(19) Europäisches Patentamt
European Patent Office
Office européen des brevets

(11) EP 0 775 706 B1

(12) **EUROPÄISCHE PATENTSCHRIFT**

(45) Veröffentlichungstag und Bekanntmachung des Hinweises auf die Patenterteilung:
**05.06.2002 Patentblatt 2002/23**

(51) Int Cl.[7]: **C07F 5/02**, C08F 2/50, G03F 7/029, C07F 7/08, C07F 17/02

(21) Anmeldenummer: **96810802.7**

(22) Anmeldetag: **15.11.1996**

# (54) Borat Photoinitiatoren aus Polyboranen

Borates photoinitiators from polyboranes

Borates photoinitiateurs à partir de polyboranes

(84) Benannte Vertragsstaaten:
**AT BE CH DE ES FR GB IT LI NL**

(30) Priorität: **24.11.1995 CH 334195**

(43) Veröffentlichungstag der Anmeldung:
**28.05.1997 Patentblatt 1997/22**

(60) Teilanmeldung:
**01126561.8 / 1 203 999**

(73) Patentinhaber: **Ciba Specialty Chemicals Holding Inc.**
**4057 Basel (CH)**

(72) Erfinder:
- **Cunningham, Allan Francis**
  **1723 Marly (CH)**
- **Kunz, Martin**
  **79588 Efringen-Kirchen (DE)**
- **Kura, Hisatoshi**
  **Takarazuka, Hyogo 665 (JP)**

(56) Entgegenhaltungen:
**EP-A- 0 223 587** **EP-A- 0 368 629**
**US-A- 3 311 662** **US-A- 5 055 372**

- **Z. CHEM. (ZECEAL);66; VOL.6 (11); PP.435-6, KARL-MARX-UNIV.;LEIPZIG; GER., XP000645842 HOLZAPFEL H ET AL: "Quaternäre bororganische Verbindungen; VI. Verbindungen des Typs Me2(R3BR'BR3)"**
- **ACTA CHIM. (BUDAPEST) (ACASA2);69; VOL.61 (4); PP.421-7, KARL MARX UNIV.;LEIPZIG; GER., XP000645841 NENNING P ET AL: "Quaternäre bororganische Verbindungen"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 775 706 B1

Printed by Jouve, 75001 PARIS (FR)

## Beschreibung

Die Erfindung betrifft Mono- und Polyborat-Verbindungen, hergeleitet aus Polyboranen, deren Verwendung als Photoinitiatoren allein und in Kombination mit Coinitiatoren bzw. Elektronenakzeptoren, sowie photopolymerisierbare Zusammensetzungen enthaltend die erfindungsgemässen Photoinitiatoren.

Monoborat-Verbindungen in Verbindung mit ionischen Farbstoffen, sind im Stand der Technik als Photoinitiatoren beschrieben. So offenbaren beispielsweise die US Patente 4,772,530, 4,772,541 und 5,151,520 einkernige Triarylalkylborat-anionen mit kationischen Farbstoffen, wie z.B. Cyaninen, Rhodaminen usw., als Gegenionen. Diese Verbindungen werden als Photoinitiatoren eingesetzt. Im US Patent 4,954,414 werden kationische Übergangsmetallkomplexe zusammen mit Triarylalkylborat-anionen in photopolymerisier-baren Zusammensetzungen verwendet. Bekannt ist auch aus dem US Patent 5,055,372 die Verwendung von quarternären Ammoniumverbindungen, wie z.B. Tetramethylammonium. Pyridinium, Cetylpyridinium usw., als kationische Gegenionen zum Triarylalkylborat. In dieser Publikation werden die Borate in Verbindung mit aromatischen Keton-initiatorver-bindungen in photohärtbaren Materialen eingesetzt. H. Holzapfel, P. Nenning und O. Wildner beschreiben in Z. Chem. 6 (1966), 34 die Herstellung des Natrium-Phenylborates von 1,4-Bis(diphenylboryl)-benzol. In Z. Chem. 6 (1966), 435 veröffentlichten H. Holzapfel, P. Nenning und H. Stirn die Herstellung der entsprechenden Bisphenyl-borate und die entsprechenden naphthyl-substiutierten Verbindungen. Im US Patent 3,311,662 sind Polyborate beschrieben, die als Fungizide und Bakterizide eingesetzt werden. Polyboratverbindungen als Photoinitiatoren sind in keiner dieser Schriften offenbart.

In der Technik besteht für den umfangreichen Anwendungsbereich von Photointiatoren ein Bedarf an reaktiven Verbindungen. Bei den bisher aus dem Stand der Technik bekannten Photohärtungsverfahren mit Borat-Verbindungen ist die Zugabe von Farbstoffen oder Coinitiatoren zwingend erforderlich. Besonders interessant sind jedoch Verbindungen, die als solche Initiatoren sind, sodass der Zusatz von Coinitiatoren nicht zwingend erforderlich ist.

Es wurde nun überraschenderweise gefunden, dass
Verbindungen der Formel I

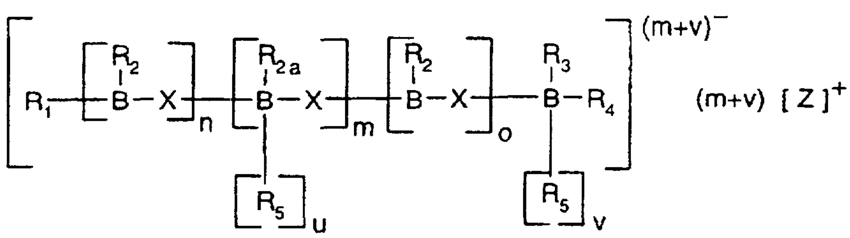

(I)

worin n und o für eine Zahl von 0 bis 50 stehen,

m eine Zahl von 1-50 ist,

u und v 0 oder 1 sind, wobei mindestens einer der Indices u oder v 1 bedeutet,

$R_1$, $R_2$, $R_{2a}$, $R_3$ und $R_4$ unabhängig voneinander für Phenyl oder einen anderen aromatischen Kohlenwasserstoff stehen, wobei diese Reste unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,

p 0, 1 oder 2 ist;

q 0 oder 1 ist;

$R_5$ $C_1$-$C_{12}$-Alkyl, $C_3$-$C_{12}$-Cycloalkyl, $C_2$-$C_8$-Alkenyl, Phenyl-$C_1$-$C_6$-Alkyl oder Naphthyl-$C_1$-$C_3$-Alkyl bedeutet; wobei die Reste $C_1$-$C_{12}$-Alkyl, $C_3$-$C_{12}$-Cycloalkyl, $C_2$-$C_8$-Alkenyl, Phenyl-$C_1$-$C_6$-Alkyl oder Naphthyl-$C_1$-$C_3$-Alkyl unsubstituiert oder mit $OR_6$, $S(O)_pR_7$, $OS(O)_2R_7$, $NR_8R_9$, $C(O)OR_6$, $C(O)NR_8R_9$, $C(O)R_{10}$,

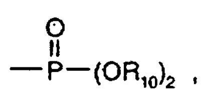

$SiR_{11}R_{12}R_{13}$, $BR_{14}R_{15}$ oder Halogen substituiert sind, oder $R_5$ für Phenyl oder einen anderen aromatischen Kohlenwasserstoff steht, wobei diese Reste unsubstituiert oder mit $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind,

wobei mindestens einer der Reste $R_1$, $R_2$, $R_{2a}$, $R_3$, $R_4$ oder $R_5$ einen in ortho-Stellung zu der Bindung zum Boratom

substituierten Phenylrest oder anderen in ortho Stellung zum Boratom sterisch gehinderten aromatischen Kohlenwasserstoffrest darstellt,

$R_6$ und $R_7$ unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,

$R_{7a}$ für $C_1$-$C_{12}$-Alkyl steht;

$R_8$, $R_9$, $R_{10}$, $R_{11}$, $R_{12}$, $R_{13}$, $R_{14}$ und $R_{15}$ unabhängig voneinander eine der Bedeutungen von $R_6$ haben oder $C_3$-$C_{12}$-Cycloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;

X $C_1$-$C_{20}$-Alkylen, welches unsubstituiert oder mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, Halogen oder $P(O)_qR_{16}R_{17}$ substituiert ist bedeutet,

oder X $C_1$-$C_{20}$-Alkylen, welches durch eine oder mehrere Gruppen -O-, -$S(O)_p$- oder -$NR_{18}$unterbrochen ist, bedeutet,

oder X $C_3$-$C_{12}$-Cycloalkylen oder $C_2$-$C_8$-Alkenylen ist, wobei diese Reste unsubstituiert oder mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind, oder wobei diese Reste durch eine oder mehrere Gruppen -O-, -$S(O)_p$- oder -$NR_{18}$- unterbrochen sind,

oder X für einen zweiwertigen aromatischen Kohlenwasserstoffrest steht, wobei dieser Rest unsubstituiert oder mit $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert ist;

oder X für einen Rest der Formeln II oder III

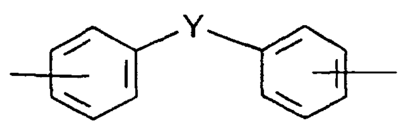

(II)

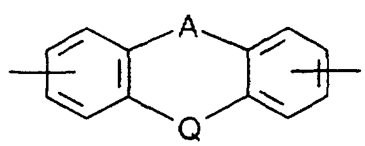

(III)

steht;

$R_{16}$ und $R_{17}$ unabhängig voneinander eine der Bedeutungen von $R_6$ haben oder $C_3$-$C_{12}$-Cycloalkyl sind;

$R_{18}$ eine der Bedeutungen von $R_6$ hat oder Wasserstoff ist;

Y -$(CH_2)_r$-, -C(O)-, -$NR_{18}$-, -O-, -$S(O)_p$-, -$CR_{19}R_{20}$-,

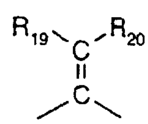

oder

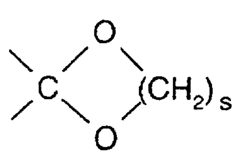

ist

r für 1, 2 oder 3 steht;
s für 2 oder 3 steht;
$R_{19}$ und $R_{20}$ $C_1$-$C_6$-Alkyl oder Phenyl sind oder $R_{19}$ und $R_{20}$ zusammen mit dem C-Atom, an welches sie gebunden sind, einen 5- oder 6-gliedrigen Ring bilden; A und Q unabhängig voneinander eine Einfachbindung, $-(CH_2)_r-$, -CH=CH-, -C(O)-, $-NR_{18}-$, $S(O)_p-$,

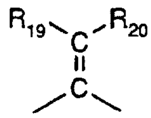 oder 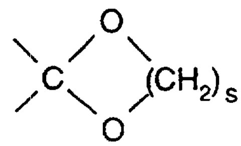

bedeuten;
oder die Reste $R_1$, $R_2$, $R_3$, $R_4$ oder X Brücken bilden, wobei Reste der Formeln (IV) oder (V)

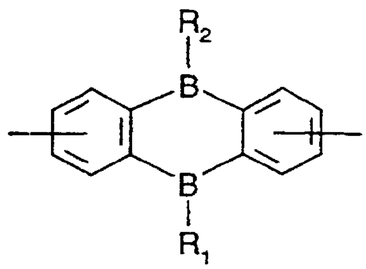 (IV)

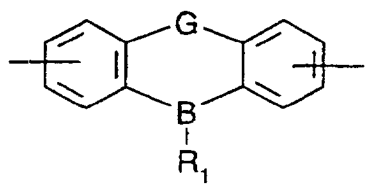 (V)

entstehen, worin
G für $-(CH_2)_t-$, -CHCH-, -C(O)-, $-NR_{18}-$, -O- oder $-S(O)_p-$ steht und
t 0, 1 oder 2 ist,
wobei die Reste der Formeln (II), (III), (IV) und (V) unsubstituiert sind oder an den aromatischen Ringen mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind und wobei an die Phenylringe der Formeln (II), (III), (IV) und (V) weitere Phenylringe anneliert sein können; mit der Massgabe, dass $R_1$, $R_{2a}$, $R_3$ und $R_4$ nicht alle gleichzeitig 1-Naphthyl bedeuten, wenn X für Phenylen oder 4,4'-Biphenylen steht; und
Z für einen Rest steht, welcher positive Ionen bilden kann, insbesondere Alkalimetalle, Ammonium, Tetraalkylammonium, Sulfomium oder Phosphoniumverbindungen,
sich als Photoinitiatoren zur Photopolymerisation von ethylenisch ungesättigte Doppelbindungen enthaltendenVerbindungen eignen. Die Verbindungen der Formel I als solche sind überraschenderweise wirksam als Photoinitiatoren, auch ohne zusätzliche Coinitiatoren.

Die Boratverbindungen der Formel I sind dadurch gekennzeichnet, dass mindestens einer der Reste $R_1$-$R_5$ einen in ortho Stellung zu der Bindung zum Boratom substituierten Phenyiring oder einen anderen in ortho Stellung zum Boratom sterisch gehinderten aromatischen Kohlenwasserstoffrest darstellt. Unter Substitution in ortho Stellung wird hier allgemein eine Bindung in o-Position des Arylrings zum Borzentralatom, also z.B. auch ein annelierter Ring, verstanden. Gemäss dieser Definition sind damit auch einige mehrcyclische aromatische Kohlenwasserstoffe, wie z. B. Naphthyl, in o-Position zur Bindung zum Borzentralatom substituierte Ringe.

Aromatische Kohlenwasserstoffe, wie sie in den erfindungsgemässen Verbindungen enthalten sein können, können z.B. ein oder mehrere, insbesondere 1 oder 2, Heteroatome enthalten. Als Heteroatome kommen z.B. N, P, O oder S, bevorzugt N oder O, in Frage. Beispiele für aromatische Kohlenwasserstoffreste sind: Phenyl, α- und β-Naphthyl, Stilbenyl, Biphenyl, o-, m-, p-Terphenyl, Triphenylphenyl, Binaphthyl, Anthracyl, Phenanthryl, Pyrenyl, Furan-2-yl oder Furan-3-yl, Thiophen-2-yl oder Thiophen-3-yl, Pyridin-2-yl, oder Pyridin-3-yl, Chinolyl oder Isochinolyl.
Ebenfalls geeignet sind aromatische Kohlenwasserstoffreste der Formel

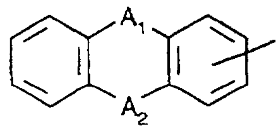

worin $A_1$ und $A_2$ unabhängig voneinander eine Einfachbindung, $-(CH_2)_t-$, -CH=CH-, -C(O)-, $-NR_{18}-$, $S(O)_p$,

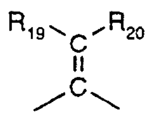
oder
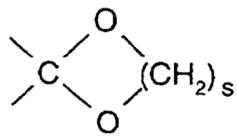

bedeuten; $R_{19}$, $R_{20}$, r, s und p haben die oben angegebenen Bedeutungen. Beispiele dafür sind z.B. Anthracyl, Fluorenyl, Thianthryl, Xanthyl, Acridinyl, Phenazinyl, Phenothiazinyl, Phenoxathiinyl, Phenoxazinyl.
Stilbenyl ist

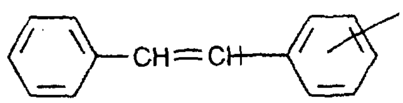

Biphenyl bedeutet

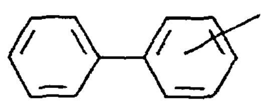

o-, m- oder p-Terphenyl sind

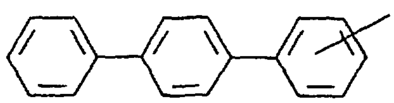

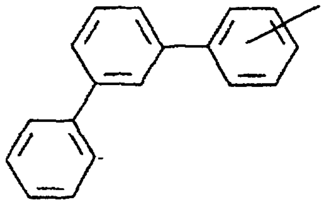

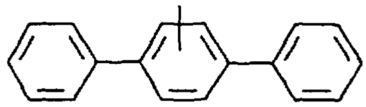

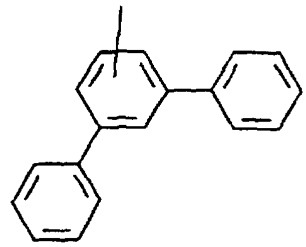

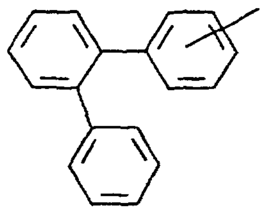

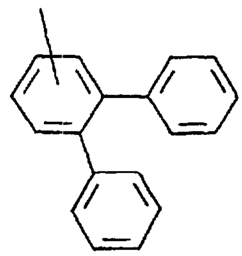

Triphenylphenyl bedeutet

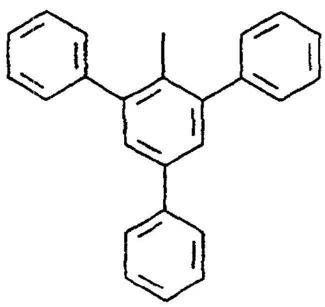

oder

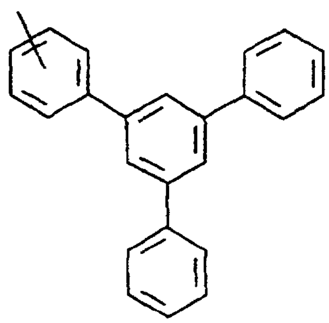

Binaphthyl ist

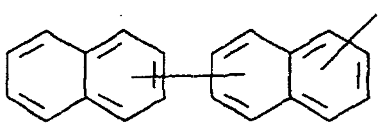

Anthracyl bedeutet

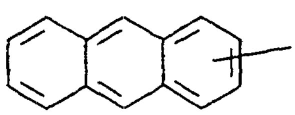

oder

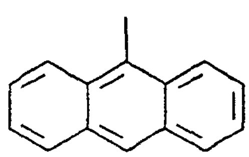

Phenanthryl steht für

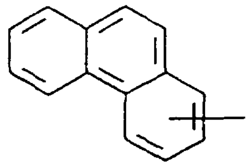 oder 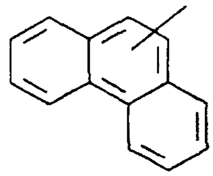

Pyrenyl bedeutet

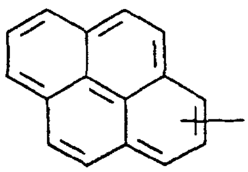 oder 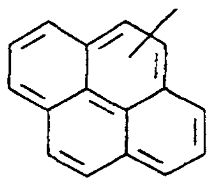

Furanyl ist Furan-2-yl oder Furan-3-yl. Thiophenyl bedeutet Thiophen-2-yl oder Thiophen-3-yl. Pyridinyl steht für Pyridin-2-yl, Pyridin-3-yl oder Pyridin-4-yl. Chinolinyl bedeutet

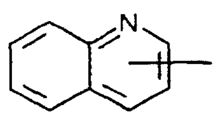 oder 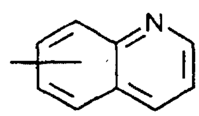

Isochinolinyl bedeutet

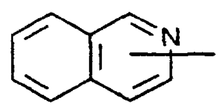

oder

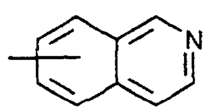

Sind die Reste Phenyl, Stilbenyl, Biphenyl, o-, m- oder p-Terphenyl, Triphenylphenyl, Naphthyl, Binaphthyl, Anthracyl, Phenanthryl, Pyrenyl, Ferrocenyl, Furanyl, Thiophenyl, Pyridinyl, Chinolinyl oder Isochinolinyl substituiert, so sind sie ein- bis vierfach, z.B. ein-, zwei- oder dreifach, insbesondere zwei- oder dreifach substituiert. Substituenten am Phenylring befinden sich vorzugsweise in 2- oder in 2,6- oder 2,4,6-Stellung des Phenylrings.

$C_1$-$C_{12}$-Alkyl ist linear oder verzweigt und ist beispielsweise $C_1$-$C_8$-, $C_1$-$C_6$- oder $C_1$-$C_4$-Alkyl. Beispiele sind Methyl, Ethyl, Propyl, Isopropyl, n-Butyl, sec-Butyl, iso-Butyl, tert-Butyl, Pentyl, Hexyl, Heptyl, 2,4,4-Trimethyl-pentyl, 2-Ethylhexyl, Octyl, Nonyl, Decyl oder Dodecyl. Beispielsweise sind $R_5$-$R_{15}$ $C_1$-$C_8$-Alkyl, insbesondere $C_1$-$C_6$-Alkyl, vorzugsweise $C_1$-$C_4$-Alkyl.

$C_3$-$C_{12}$-Cycloalkyl bedeutet z.B. Cyclopropyl, Cyclopentyl, Cyclohexyl, Cyclooctyl, Cyclododecyl, insbesondere Cyclopentyl und Cyclohexyl, vorzugsweise Cyclohexyl.

$C_2$-$C_8$-Alkenyl-Reste können ein- oder mehrfach ungesättigt sein und sind beispielsweise Allyl, Methallyl, 1,1-Dimethylallyl, 1-Butenyl, 3-Butenyl, 2-Butenyl, 1,3-Pentadienyl, 5-Hexenyl oder 7-Octenyl, insbesondere Allyl.

Phenyl-$C_1$-$C_6$-alkyl bedeutet z.B. Benzyl, Phenylethyl, α-Methylbenzyl, Phenylpentyl, Phenylhexyl oder α, α-Dimethylbenzyl, insbesondere Benzyl. Substituiertes Phenyl-$C_1$-$C_5$alkyl ist ein- bis vierfach, z.B. ein-, zwei- oder dreifach, insbesondere zwei- oder dreifach am Phenylring substituiert.

Naphthyl-$C_1$-$C_3$-alkyl ist beispielsweise Naphthylmethyl, Naphthylethyl, Naphthylpropyl oder Naphthyl-1-methylethyl, insbesondere Naphthylmethyl. Dabei kann sich die Alkyleinheit sowohl in 1- als auch in 2-Stellung des Naphthylringes befinden. Substituiertes Naphthyl-$C_1$-$C_3$-alkyl ist ein- bis vierfach, z.B. ein-, zwei- oder dreifach, insbesondere zwei- oder dreifach an den aromatischen Ringen substituiert.

$C_1$-$C_{12}$-Alkoxy sind lineare oder verzweigte Reste und bedeuten z.B. Methoxy, Ethoxy, Propoxy, Isopropoxy, n-Butyloxy, sec-Butyloxy, iso-Butyloxy, tert-Butyloxy, Pentyloxy, Hexyloxy, Heptyloxy, 2,4,4-Trimethylpentyloxy, 2-Ethylhexyloxy, Octyloxy, Nonyloxy, Decyloxy oder Dodecyloxy, insbesondere Methoxy, Ethoxy, Propoxy, Isopropoxy, n-Butyloxy, sec-Butyloxy, iso-Butyloxy, tert-Butyloxy, vorzugsweise Methoxy.

Halogen bedeutet Fluor, Chlor, Brom und lod, insbesondere Fluor, Chlor und Brom, vorzugsweise Chlor und Fluor.

Ist $C_1$-$C_{12}$-Alkyl ein oder mehrmals mit Halogen substituiert, so sind z.B. 1 bis 3 oder 1 oder 2 Halogensubstituenten am Alkylrest.

X als $C_1$-$C_{20}$-Alkylen ist lineares oder verweigtes Alkylen wie z.B. Methylen, Ethylen, Propylen, 1-Methylethylen, 1,1-Dimethylethylen, Butylen, 1-Methylpropylen, 2-Methylpropylen, Pentylen, Hexylen, Heptylen, Octylen, Nonylen, Decylen, Dodecylen, Tetradecylen, Hexadecylen oder Octadecylen. Insbesondere ist X $C_1$-$C_{12}$-Alkylen, z.B. Ethylen, Decylen,

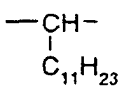 , 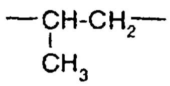 , 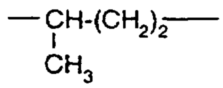 , 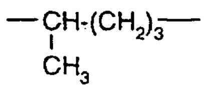 ,

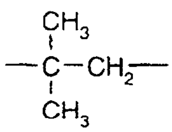 oder 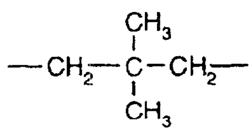 .

X als $C_2$-$C_{20}$-Alkylen, das ein oder mehrmals durch -O-, -$S(O)_p$- oder -$NR_{18}$- unterbrochen ist, ist beispielsweise 1-9, z.B. 1-7 oder 1 oder 2 mal durch -O-, -$S(O)_p$- oder -$NR_{18}$- unterbrochen. Es ergeben sich z.B. Struktureinheiten wie -$CH_2$-O-$CH_2$-, -$CH_2$-S-$CH_2$-, -$CH_2$-N($CH_3$)-$CH_2$-, -$CH_2CH_2$-O-$CH_2CH_2$-,-[$CH_2CH_2O$]$_y$-, -[$CH_2CH_2O$]$_y$-$CH_2$-, mit y = 1-9, -($CH_2CH_2O$)$_7$$CH_2CH_2$-, -$CH_2$-CH($CH_3$)-O-$CH_2$-CH($CH_3$)- oder -$CH_2$-CH($CH_3$)-O-$CH_2$-$CH_2CH_2$-Mit -$OR_6$ substituiertes $C_1$-$C_{20}$-Alkylen ist z.B.

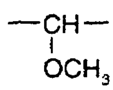

$C_3$-$C_{12}$-Cycloalkylen bedeutet z.B. Cyclopropylen, Cyclopentylen, Cyclohexylen, Cyclooctylen,Cyclododecylen, insbesondere Cyclopentylen und Cyclohexylen, vorzugsweise Cyclohexylen. $C_3$-$C_{12}$-Cycloalkylen steht aber auch z.B. für Struktureinheiten wie z.B.

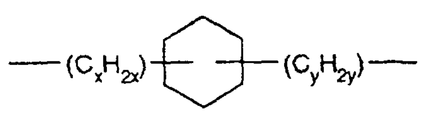 ,

wobei x und y unabhängig voneinander 0-6 sind und die Summe von x+y ≤ 6 ist oder

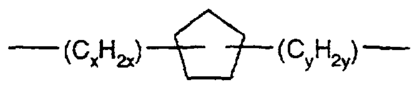 ,

wobei x und y unabhängig voneinander 0-7 bedeuten und die Summe von x+y ≤ 7 ist.

$C_2$-$C_8$-Alkenylen kann ein oder mehrfach ungesättigt sein und ist z.B. Ethenylen, 1- Propenylen, 1-Butenylen, 3-Butenylen, 2-Butenylen, 1,3-Pentadienylen, 5-Hexenylen oder 7-Octenylen.

Zweiwertige aromatische Kohlenwasserstoffreste sind z.B. Phenylen, Stilbenylen, Biphenylen, o-, m- oder p-Terphenylen, Triphenylphenylen Naphthylen, Binaphthylen, Anthracenylen, Phenanthrylen, Pyrenylen, Ferrocenylen, Furanylen, Thiophenylen, Pyridinylen, Chinolinylen oder Isochinolinylen.

Naphthylen steht für

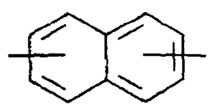 oder 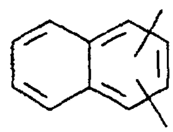 ,

insbesondere für

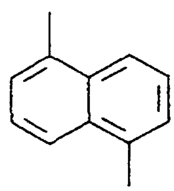 oder 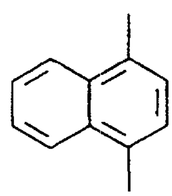 .

Stilbenylen ist

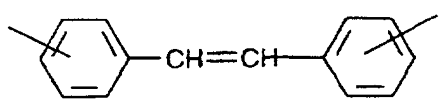

oder

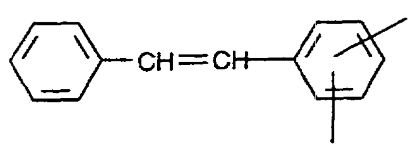 .

Biphenylen bedeutet

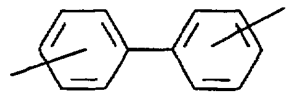

o-, m- oder p-Terphenylen sind

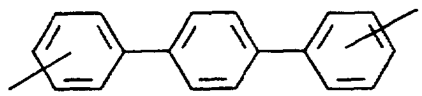

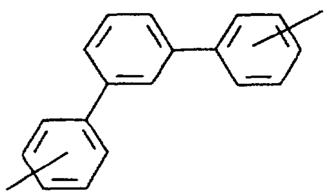

oder

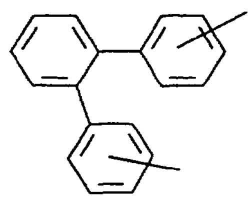

Triphenylphenylen bedeutet

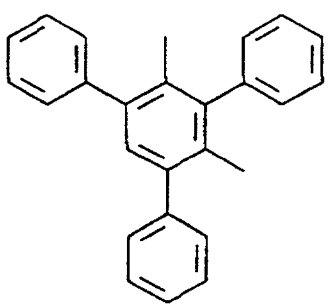

oder

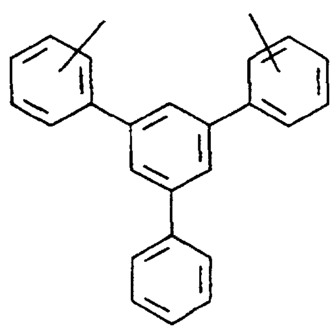

.

Binaphthylen ist

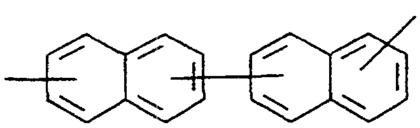

,

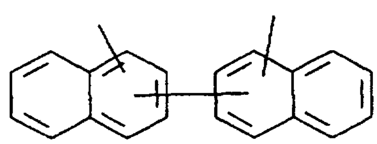

,

insbesondere

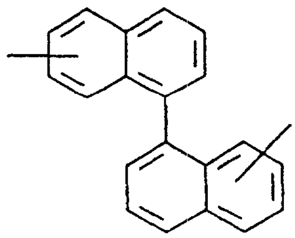 und 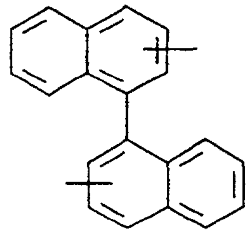 .

Anthracylen bedeutet

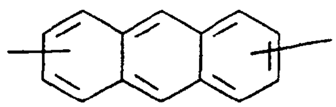 , 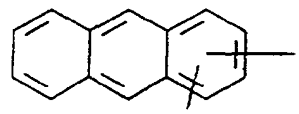

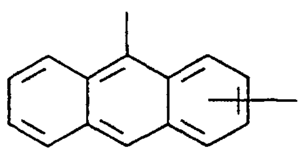 oder 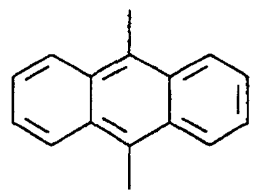 .

Phenanthrylen steht für

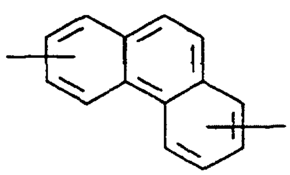 , 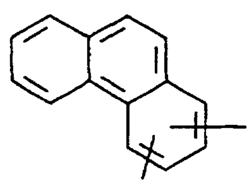 , 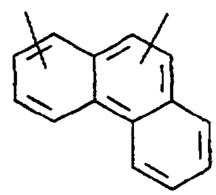

oder

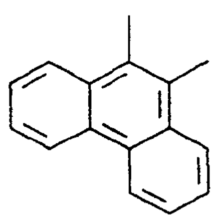 .

Pyrenylen bedeutet

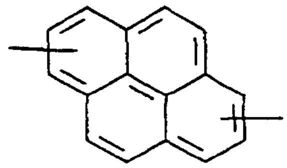 ,

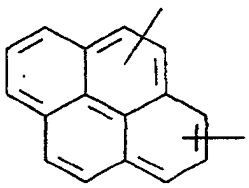 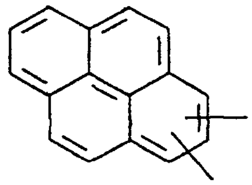 oder 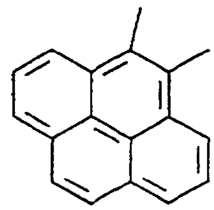 .

Furanylen ist

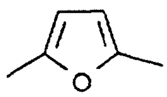 , 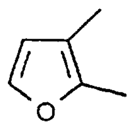 oder 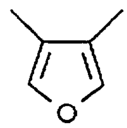 .

Thiophenylen bedeutet

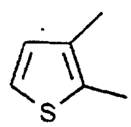 ,

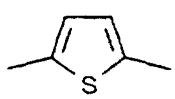 oder 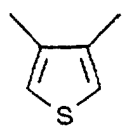 .

Pyridinylen steht für

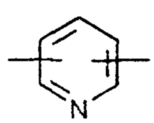 .

Chinolinylen bedeutet

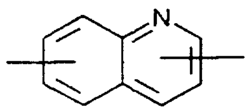 , 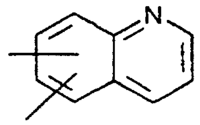 oder 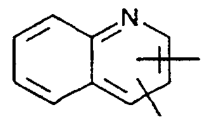 .

Isochinolinylen bedeutet

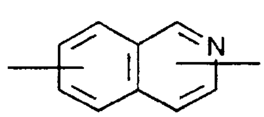 , 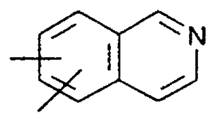 oder 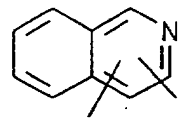 .

1,4-Duryl ist

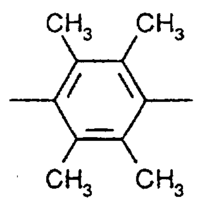 .

Sind die Reste Phenylen, Stilbenylen, Biphenylen, o-, m- oder p-Terphenylen, Triphenylphenylen, Naphthylen, Binaphthylen, Anthracylen, Phenanthrylen, Pyrenylen, Ferrocenylen, Furanylen, Thiophenylen, Pyridinylen, Chinolinylen oder Isochinolinylen substituiert, so sind sie ein- bis vierfach, z.B. ein-, zwei- oder dreifach, insbesondere ein- oder zweifach substituiert. Substituenten am 1,4-Phenylenring befinden sich in 2-, 3-, 5- oder 6-Stellung, ins-besondere in 2- oder 3-Stellung des Phenylrings. Substituenten am 1,3-Phenylenring befinden sich in 2-, 4-, 5- oder 6-Stellung, insbesondere in 4- oder 5-Stellung des Phenylrings.

Als Gegenion $Z^+$ zum negativen Borat in der Formel I sind Reste geeignet, welche positive Ionen bilden können.

Dies sind beispielsweise Alkalimetalle, insbesondere Lithium oder Natrium, quarternäre Ammoniumverbindungen, Farbstoffkationen oder kationische Übergangsmetallkoordinationskomplex-Verbindungen, insbesondere Ammonium oder Tetraalkylammonium. Beispiele für Tetraalkylammonium sind insbesondere Tetramethylammonium oder Tetrabutylammonium, geeignet sind aber auch Trisalkylammoniumionen, z.B. Trimethylammonium. Geeignet sind Phosphonium- und Ammonium-gegenionen der Formeln $^+PR_wR_xR_yR_z$ und $^+NR_wR_xR_yR_z$, wobei $R_w$, $R_x$, $R_y$, $R_z$ unabhängig voneinander Wasserstoff, unsubstituiertes oder substituiertes Alkyl, Cycloalkyl, Alkenyl, Phenyl oder Arylalkyl bedeuten. Substituenten für diese Alkyl-, Cycloalkyl-, Alkenyl-, Phenyl- oder Arylalkyl-Reste sind z.B. Halogenid, Hydroxy, Heterocycloalkyl (z.B Epoxy, Aziridyl, Oxetanyl, Furanyl, Pyrrolidinyl, Pyrrolyl, Thiophenyl,Tetrahydrofuranyl, usw.), Dialkylamino, Amino, Carboxy, Alkyl- und Arylcarbonyl und Aryloxy- und Alkoxycarbonyl.

Der tetravalente Stickstoff kann auch Mitglied eines 5- oder 6-gliedrigen Ringes sein, wobei dieser Ring wiederum an andere Ringsysteme anneliert werden kann. Diese Systeme können auch zusätzliche Heteroatome enthalten, wie z. B. S, N, O.

Der tetravalente Stickstoff kann auch Mitglied eines polycyclischen Ringsystemes sein, z.B. Azoniapropellan. Diese Systeme können auch weitere Heteroatome enthalten, wie z.B. S, N, O.

Ebenfalls geeignet sind Polyammonium- und Polyphosphoniumsalze, im besonderen die Bissalze, wobei die gleichen Substituenten wie oben für die "mono"-Verbindungen beschrieben sind, vorhanden sein werden können.

Die Ammonium- und Phosphoniumsalze können auch mit neutralen Farbstoffen (z.B. Thioxanthenen, Thioxanthonen, Coumarinen, Ketocoumarinen, usw.) substituiert werden. Solche Salze werden von der Reaktion von den mit reaktiven Gruppen (z.B. Epoxy, Amino, Hydroxy, usw.) substituierten Ammonium- und Phosphoniumsalze mit

geeigneten Derivaten von neutralen Farbstoffen erhalten. Entsprechende Beispiele sind in der EP-A 224967 beschrieben (Quantacure QTX).

Ebenso können Ammonium- und Phosphoniumsalze auch mit farblosen Elektronenakzeptoren (z.B. Benzophenonen) substituiert werden: Beispiele dafür sind Quantacure ABQ

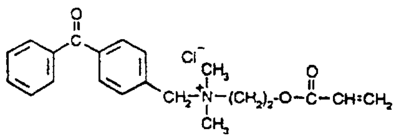 ,

Quantacure BPQ

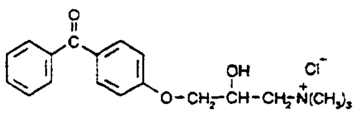

und Quantacure BTC

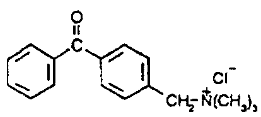

der Firma International Bio-Synthetics.

Weitere interessante quarternäre Ammoniumverbindungen sind z.B. Trimethylcetylammonium oder Cetylpyridinium.
Als positive Gegenionen Z in der Verbindung der Formel I sind z.B. auch folgende Ionen einzusetzen:

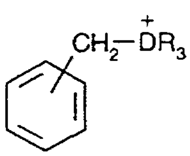 , 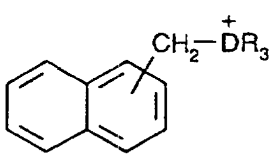 , 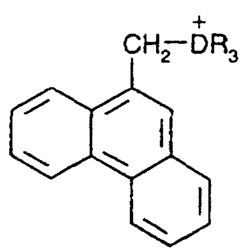 , 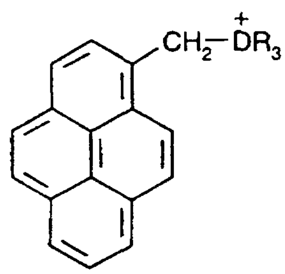 ,

worin D für P, N oder S steht und R einen Alkyl- oder Arylrest bedeutet. Ebenfalls geeignet sind Verbindungen wie z.B.

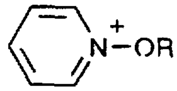 oder 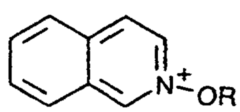

(beschrieben von Yagci et al. in J. Polym. Sci. Part A: Polymer Chem. 1992, 30, 1987 und Polymer 1993, 34(6), 1130).
oder Verbindungen wie z.B.

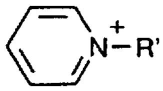 oder 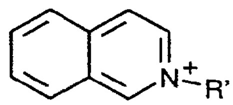

mit R' = unsubstituiertes oder substituiertes Benzyl oder Phenacyl (beschrieben in JP-A Hei 7 70221). Bei diesen Verbindungen können die aromatischen Ringe im Pyridinium auch substituiert sein.

Als positive Gegenionen $Z^+$ zum Borat sind auch weitere Oniumionen, wie z.B. Iodoniumoder Sulfoniumionen einsetzbar.

Beispiele für solche Gegenionen zum Borat sind Reste der Formel

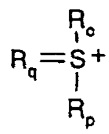

wie sie z.B. in der EP-A 555058 und der EP-A 690074 beschrieben sind. Ausserdem interessant als Gegenionen sind

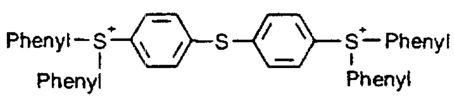 , 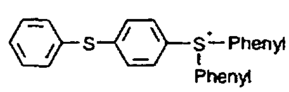 ,

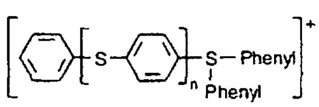 , 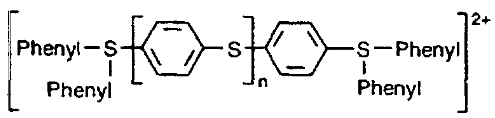 .

Weiterhin geeignete Gegenionen für die erfindungsgemässen Borate sind Kationen der Formel

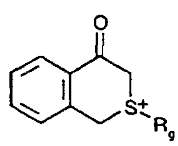 ,

worin $R_g$ für einen Alkylrest, insbesondere Ethyl, oder Benzyl steht und der aromatische Ring weitere Substituenten tragen kann.

Weitere geeignete Gegenionen sind Haloniumiumionen, insbesondere Diaryliodoniumionen, wie z.B. in der EP-A 334056 und der EP-A 562897 beschrieben.

Geeignet sind aber auch Kationen von Ferroceniumsalzen, wie z.B. in der EP-A 94915 und der EP-A 109851 beschrieben, beispielsweise

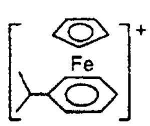 .

Weitere geeignete "Onium"-Kationen, wie Ammonium, Phosphonium, Sulfonium, Iodonium, Selonium, Arsonium, Tellonium, Bismuthonium sind z.B. in der japanischen Patentanmeldung Hei 6 266102 beschrieben.

Beispiele für kationische Übergangsmetallkomplex-Verbindungen, welche als Gegenion geeignet sind, sind

im US Patent 4,954,414 beschrieben. Besonders interessant sind Bis(2,2'-bipyridin)(4,4'-dimethyl-2,2'-bipyridin)-ruthenium, Tris(4,4'-dimethyl-2,2'-bipyridin)-ruthenium, Tris(4,4'-dimethyl-2,2'-bipyridin)-eisen, Tris(2,2',2''-terpyridin)-ruthenium,Tris(2,2'bipyridin)-ruthenium und Bis(2,2'-bipyridin)(5-chloro-1,10-phenanthrolin)-ruthenium. Geeignete Farbstoffe sind beispielsweise Kationen von Triaryl-methanen, z.B. Malachit Grün, Indolinen, Thiazinen, z.B. Methylen Blau, Xanthonen, Thio-xanthonen, Oxazinen, Acridinen, Cyaninen, Rhodaminen, Phenazinen, z.B. Safranin, bevorzugt Cyaninen und Thioxanthonen.

Einige der erfindungsgemässen Verbindungen weisen gute Säurestabilität auf und sind daher auch in sauren Formulierungen, z.B. auch in Kombination mit säuregruppenhaltigen Farbstoffen einsetzbar.

Die erfindungsgemässen Verbindungen der Formel I werden z.B. hergestellt durch Addition von einem bis m+v Äquivalenten eines organometallischen Reagens an ein entsprechendes Boran (Ib).

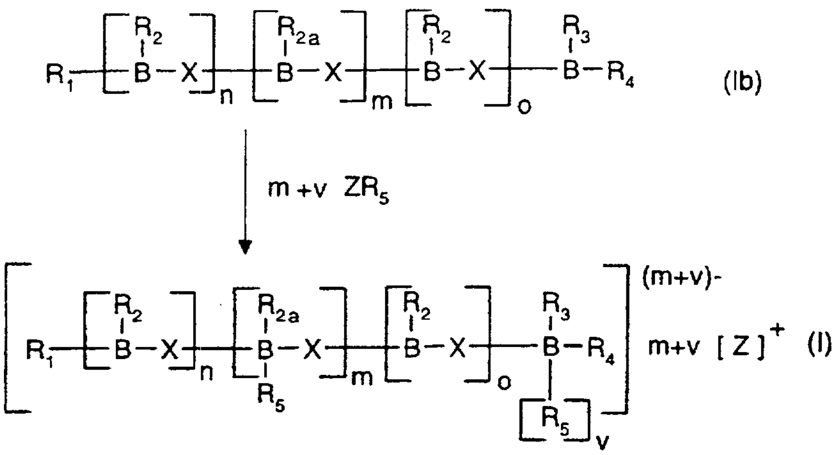


oder (wenn u in Formel I, wie oben definiert, 0 ist und v 1 ist)

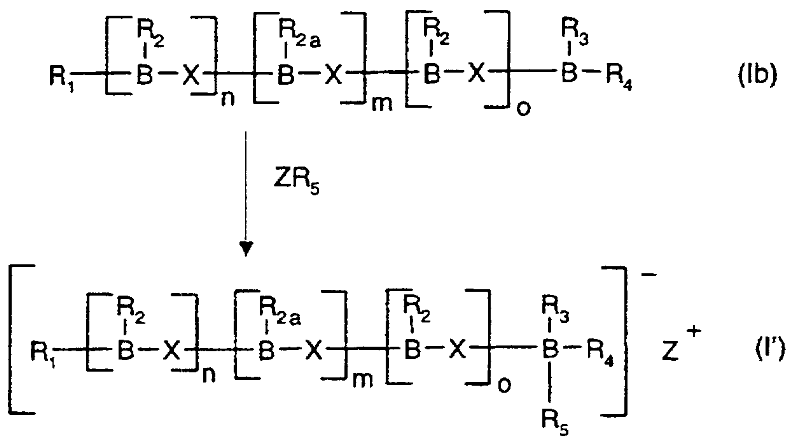


Die Bedeutungen der Reste sind die gleichen wie oben angegeben.

Es ist auch möglich das Polyboran zunächst mit einem metallorganischen Reagens $MR_5$, worin M für ein Metallatom, wie z.B. Li, Mg usw. steht, umzusetzen und in einem zweiten Reaktionsschritt das Metallkation in der Formel Ib durch ein anderes Kation $Z^+$ (z.B. Tetraalkylammonium) zu ersetzen.

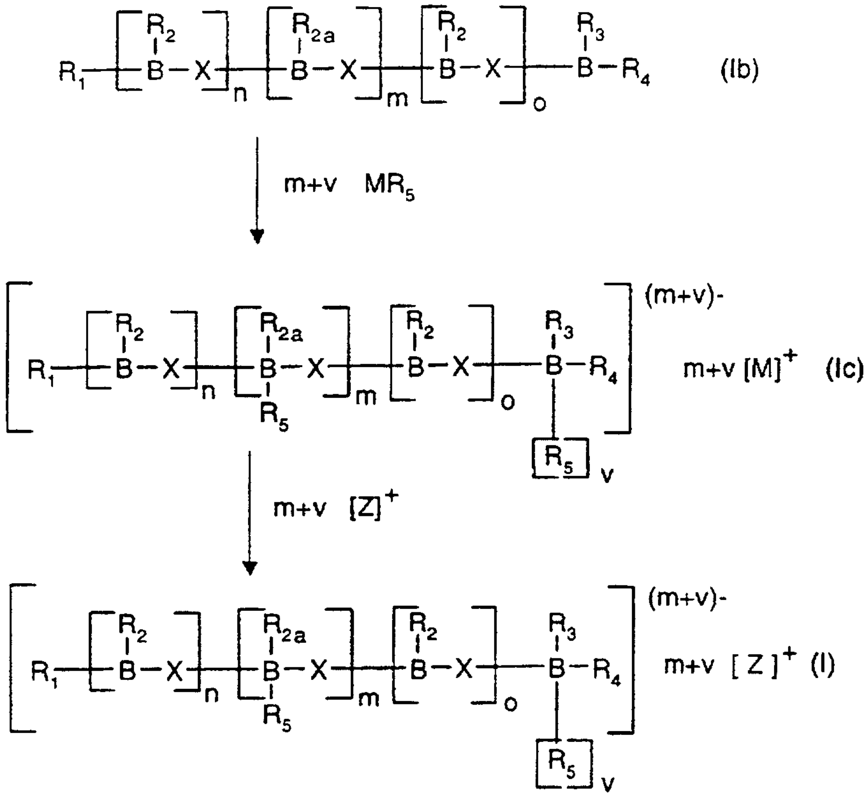


(Ib) (Ic) (I)

Die Reaktionsbedingungen beim Arbeiten mit metallorganischen Reagentien sind dem Fachmann im allgemeinen geläufig. So erfolgt die Umsetzung zweckmässigerweise in einem inerten organischen Lösungsmittel, beispielsweise einem Ether oder aliphatischen Kohlenwasserstoff, z.B. Diethylether, Tetrahydrofuran oder Hexan.
Als metallorganische Reagentien zur Herstellung der erfindungsgemässen Polyborate kommen beispielsweise die Lithiumverbindungen der entsprechenden aliphatischen und aromatischen Kohlenwasserstoffreste in Frage. Ebenso können z.B. Grignard Reagenzien, Zink oder Natrium verwendet werden.
Die Reaktion mit dem metallorganischen Reagenz wird zweckmässigerweise unter Luftausschlüss in einer Inertgasatmosphäre, z.B. unter Stickstoff, durchgeführt. Die Reaktion wird in der Regel unter Kühlung auf 0°C oder darunter und anschliessendem Erwärmen bis auf Raumtemperatur ausgeführt.
Es ist zweckmässig die Reaktionsmischung zu rühren. Die Isolierung und Reinigung der Produkte erfolgt ebenfalls nach dem Fachmann allgemein bekannten Methoden, wie z.B. Chromatigraphie, Umkristallisation usw.. So werden z. B. zweckmässigerweise Verunreinigungen durch Waschen des Produktes mit einem siedendem Lösungsmittel und anschliessender Filtration entfernt.
Die Polyborate können auch direkt aus der Lösung bei der Herstellung der Polyboran-Edukte ohne deren vorherige Isolierung erhalten werden.

Enthalten die erfindungsgemässen Verbindungen der Formel I als Kation einen Farbstoff-Rest, so werden diese Verbindungen durch Kationenaustausch-Reaktion eines entsprechenden Borat-Salzes mit einem Farbstoff hergestellt. Die zum Austausch geeigneten Boratsalze sind z.B. die Natrium-,Lithium-, Magnesium-, Ammonium- oder Tetraalkylammoniumsalze.
Die Polyborane werden z.B. durch Addition eines Boranreagenzes der Formel $ArBL_2$ oder $Ar_2BL$, worin Ar für einen Arylrest und L für eine Abgangsgruppe stehen, an eine polymetallierte Verbindung erhalten.Diese wird in der Regel durch Halogen↔Metallaustausch einer polyhalogenierten aromatischen Verbindung mit einem organometallischen Reagenz, z.B. Butyllithium, oder einem Metall, z.B. Magnesium, hergestellt. Die Polyborierung kann auch schrittweise erfolgen, z.B. durch wiederholte Sequenzen Monometallierung/Monoborylierung.
Ausserdem können Polyborane z.B. durch Reaktion von metallierten Arylverbindungen, in der Regel Aryllithium oder Aryl-Magnesiumderivaten, zu poly-dihaloborylierten oder polydialkoxyborylierten oder polydiaryloxyborylierten aromatischen Verbindungen umgesetzt werden.
Die Reaktionsbedingungen für solche Reaktionen sind dem Fachmann allgemein geläufig und wie oben beschrieben. In der Regel werden die Polyborierungsreaktionen jedoch bei niedrigeren Temperaturen, z.B. -78°C, durchgeführt.

Dimesitylfluoroboran kann z.B. nach der Methode von Pelter et al.; Tetrahedron 1993, 49, 2965 hergestellt werden. Es ist auch im Handel erhältlich. Bis(chloromesityl)fluoroboran und Bis(dichloromesityl)fluorboran können in analoger Weise aus Bromchlormesitylen erhalten werden. Diphenylisopropoxy-boran und Di-o-tolylisopropoxyboran können z.B. durch Addition von zwei Äquivalenten eines entsprechenden Grignard-Reagenzes an Triisopropoxyboran synthetisiert werden (vgl. Cole et al., Organometallics, 1992, 11, 652). Die entsprechenden Diarylbromoborane können beispielsweise nach der Methode von Haubold et al., J. Organomet. Chem. 1986, 315, 1, hergestellt werden. Phenyldifluoroboran wird z.B. erhalten durch Reaktion von Phenyldibromoboran mit Titaniumtetrafluorid (vgl. Nahm et al., J. Organomet. Chem. 1972, 35, 9). 1,4-Bis(difluoroboryl)- und 1,4-Bis(dibromoboryl)benzol können auch nach der von Nielsen et al. in J. Amer. Chem. Soc. 1957, 79, 3081 beschriebenen Methode hergestellt werden.
Die erforderlichen Arylhalogenide sind entweder im Handel erhältlich oder können nach dem Fachmann bekannten, in der Technik allgemein üblichen Verfahren hergestellt werden.

Borane mit chlorierten aromatischen Resten können z.B. auch durch Chlorierung des Borans erhalten werden: z.B.

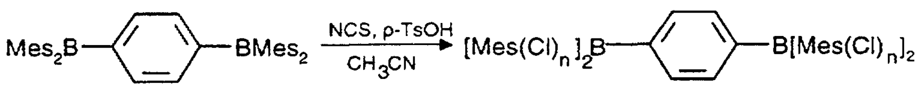


Mes steht für Mesityl; NCS steht für N-Chlorsuccinimid; p-TsOH bedeutet p-Toluolsulfonsäure und n ist 1 oder 2. Es können z.B. auch andere Chlorierungsmittel, wie z.B. Chlorgas eingesetzt werden.

Bevorzugt sind Verbindungen der Formel I, worin n und o gleich 0 sind.

Weitere interessante Verbindungen der Formel I sind solche, worin m 1 ist.

Hervorzuheben sind Verbindungen der Formel I, worin $R_1$, $R_{2a}$, $R_3$ und $R_4$ gleich sind.

Insbesondere sind solche Verbindungen der Formel I bevorzugt, worin $R_1$, $R_2$, $R_{2a}$, $R_3$, $R_4$, $R_{14}$ und $R_{15}$ unabhängig voneinander in 2-, 2,6- oder 2,4,6-Position substituiertes Phenyl oder Naphthyl oder Anthracyl bedeuten.

Interessante Verbindungen der Formel I sind solche, worin $R_1$, $R_2$, $R_{2a}$, $R_3$, $R_4$, $R_{14}$ und $R_{15}$ mit $C_1$-$C_6$-Alkyl, Halogen, $OR_6$ oder Trifluormethyl substituiertes Phenyl, 1-Naphthyl, 1- oder 9-Anthracyl bedeuten.

Interessant sind auch Verbindungen der Formel I, worin $R_1$ 1-Naphthyl, 2-($C_1$-$C_6$-Alkyl)naphth-1-yl, 1-Anthracyl, 9-Anthracyl oder Ferrocenyl bedeutet.

Ausserdem bevorzugt sind die Verbindungen der Formel I, worin X $C_1$-$C_{18}$-Alkylen, welches unsubstituiert oder mit $OR_6$, $NR_8R_9$, $SiR_{11}R_{12}R_{13}$, $BR_{14}R_{15}$ oder Halogen substituiert ist bedeutet, oder X $C_1$-$C_{20}$-Alkylen, welches durch eine oder mehrere Gruppen -Ounterbrochen ist, bedeutet, oder X Phenylen, Biphenylen, o-, m- oder p-Terphenylen, Naphthylen, Phenanthrylen oder Ferrocenylen bedeuten, wobei die Reste Phenylen, Biphenylen, o-, m- oder p-Terphenylen, Naphthylen, Phenanthrylen oder Ferrocenylen unsubstituiert oder mit $C_1$-$C_6$-Alkyl, $OR_6$, $NR_8R_9$, C(O)$OR_6$, C(O)$NR_8R_9$, C(O)$R_{10}$, $SiR_{11}R_{12}R_{13}$, $BR_{14}R_{15}$ oder Halogen substituiert sind, oder X für einen Rest der Formel II steht, worin
Y $-(CH_2)_r-$, -C(O)-, -N-, -O-, $-S(O)_p-$, $-CR_{19}R_{20}-$,

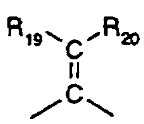

oder

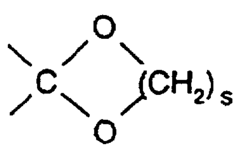

ist. Weitere bevorzugte Verbindungen der Formel I sind die, worin
n und o gleich 0 sind,
m für die Zahl 1 steht,
$R_1$, $R_2$, $R_{2a}$, $R_3$ und $R_4$ mit $C_1$-$C_6$-Alkyl und/oder Halogen, insbesondere Chlor, substituiertes Phenyl bedeuten,
$R_5$ $C_1$-$C_{12}$-Alkyl, ($C_1$-$C_4$-Alkyl)$_3$Si-$CH_2$- oder Phenyl ist,
X unsubstituiertes Phenylen, mit Halogen, insbesondere Fluor, substituiertes Phenylen, Biphenylen, o- oder p-Terphenylen, Naphthylen, Phenanthrylen, Ferrocenylen oder einen Rest der Formel II darstellt, worin
Y -C(O)- oder

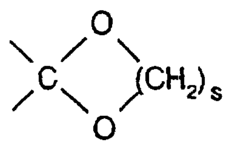

bedeutet,
s gleich 2 ist und
Z für Tetraalkylammonium, ein Cyaninfarbstoffkation oder Thioxanthonkation steht.

Als Coinitiatoren werden gemäss der vorliegenden Erfindung Elektronenakzeptorverbindungen (in Kombination mit erfindungsgemässen Boraten der Formel I) eingesetzt. Der Begriff Coinitiator steht in diesem Zusammenhang also z.B. für Sensibilisatoren, wie z.B. Thioxanthone, Reaktionsbeschleuniger, wie z.B. Amine, Thiole usw., oder Farbstoffe.

Wie bereits erwähnt, sind die erfindungsgemässen Polyborat-Verbindungen der Formel I als solche als Photoinitiatoren einsetzbar. Es ist jedoch auch möglich, sie in Kombination mit weiteren Coinitiatoren bzw. Elektronenakzeptorverbindungen als Photoinitiatoren zu verwenden.
Gegenstand der Erfindung ist daher auch ein Photoinitiator enthaltend mindestens eine Verbindung der Formel I nach Anspruch 1 und mindestens eine Elektronenakzeptor-Verbindung.

Geeignete Coinitiatoren bzw. Elektronenakzeptorverbindungen sind z.B. Übergangsmetallkomplexverbin-dungen oder Farbstoffe. Geeignete Übergangsmetallkomplexverbindungen sind beispiels-weise im US Patent 4,954,414 beschrieben, z.B. Bis(2,2'-bipyridin)(4,4'-dimethyl-2,2'-bipyri-din)-ruthenium, Tris (4,4'dimethyl-2,2'-bipyridin)-ruthenium, Tris(4,4'-dimethyl-2,2'-bipyridin)-eisen, Tris(2,2',2"terpyridin)-ruthenium,Tris (2,2'-bipyridin)-ruthenium und Bis(2,2'-bipyridin)-(5-chloro-1,10-phenanthrolin)-ruthenium.
Geeignete Farbstoffe, welche als Coinitiatoren (Elektronenaklzeptorverbindungen) zugesetzt werden können, sind z. B. im US Patent 5,151,520 beschrieben. Es sind beispielsweise Triarylmethane, z.B. Malachit Grün, Indoline, Thiazine, z.B. Methylen Blau, Xanthone, Thioxanthone, Oxazine, Acridine oder Phenazine, z.B. Safranin.
Besonders geeignete Farbstoffe sind Malachit Grün, Methylen Blau, Safranin O, Rhodamine der Formel

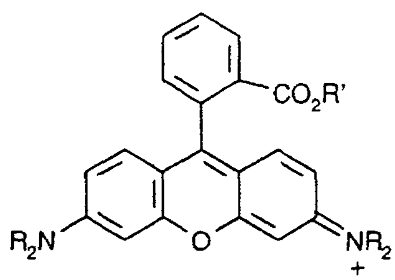

worin R für Alkyl- oder Arylreste steht und R' Wasserstoff, einen Alkyl- oder Arylrest darstellt, z.B. Rhodamin B, Rhodamin 6G oder Violamin R, ausserdem Sulforhodamin B oder Sulforhodamin G.

Andere geeignete Farbstoffe sind Fluorone, wie sie z.B. von Neckers et al. in J. Polym. Sci., Part A, Poly. Chem, 1995, 33, 1691-1703 beschrieben sind. Besonders interessant ist

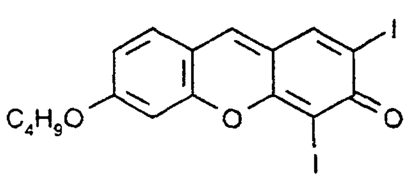

Beispiele für weitere geeignete Farbstoffe sind Cyanine der Formel

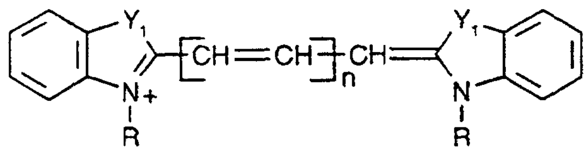,

worin R = Alkyl; n = 0,1,2,3 oder 4 und $Y_1$ = CH=CH, N-$CH_3$, $C(CH_3)_2$, O, S, Se. Bevorzugt sind Cyanine, worin $Y_1$ in der obigen Formel $C(CH_3)_2$ oder S ist.

Ausserdem sind folgende Farbstoffverbindungen als Coinitiatoren geeignet:

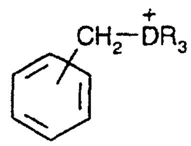

, 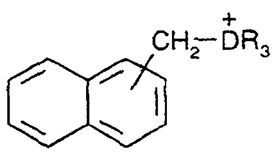 , 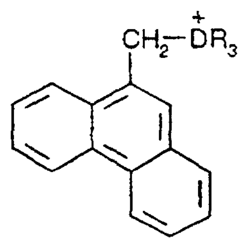 , 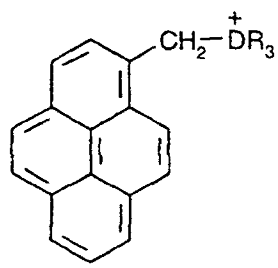 ,

worin D für P, N oder S steht und R einen Alkyl- oder Arylrest bedeutet. Bevorzugt sind Verbindungen der obigen Formel, worin $DR_3$ für $N(CH_3)_3$, $N(C_2H_5)_3$ oder $P(C_6H_5)_3$ steht.

Ebenfalls geeignet sind Verbindungen wie z.B.

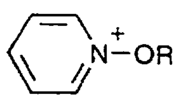 oder 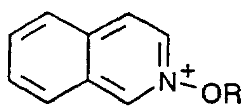

wie sie z.B. von Yagci et al. in J. Polym. Sci. Part A: Polymer Chem. 1992, 30, 1987 und Polymer 1993, 34(6), 1130 beschrieben sind oder wie z.B.

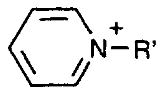

oder

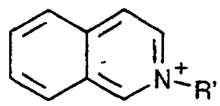

mit R' = unsubstituiertes oder substituiertes Benzyl oder Phenacyl, beschrieben in JP-A Hei 7 70221. Die oben genannten Pyridiniumverbindungen können im aromatischen Pyridiniumring auch substituiert sein.

Andere geeignete Farbstoffe sind beispielsweise dem US Patent 4,902,604 zu entnehmen.
Es handelt sich um Azulen-Farstoffe. Insbesondere interessant als Coinitiatoren für die erfindungsgemässen Verbindungen sind die in den Spalten 10 und 11 dieses Patentes in der Tabelle angegebenen Verbindungen 1-18.
Weitere geeignete Farbstoffe sind z.B. Merocyanin-Farbstoffe, wie sie im US Patent 4,950,581 von Spalte 6, Zeile 20 bis Spalte 9, Zeile 57 beschrieben sind.

Als Coinitiatoren für die erfindungsgemässen Verbindungen bzw. Photoinitiatoren können auch Coumarin-Verbindungen verwendet werden. Beispiele dafür sind im US Patent 4,950,581 auf den Spalte 11, Zeile 20 bis Spalte 12, Zeile 42 angegeben.

Andere geeignete Coinitiatoren sind Xanthone oder Thioxanthone wie sie z.B. im US Patent 4,950,581, Spalte 12, Zeile 44 bis Spalte 13, Zeile 15 beschrieben sind.

Es können als Coinitiatoren bzw. Elektronenakzeptorverbindungen auch anionische Farbstoff-Verbindungen eingesetzt werden. So sind z.B. auch Rose Bengal, Eosin oder Fluorescein als geeignet. Weitere geeignete Farbstoffe, wie z.B. aus der Triaryl-methan- oder Azo-Klasse, sind z.B. dem US Patent 5,143,818 zu entnehmen. Beispiele sind Ethyl Orange (Chem. Abstr. Reg. No. 62758-12-7), Brilliant Blue G (Chem. Abstr. Reg. No. 6104-58-1), Brilliant Blue R (Chem. Abstr. Reg. No.6104-59-2), Lissamine Green B (Chem. Abstr. Reg. No. 3087-16-9) oder Patent Blue VF (Chem. Abstr. Reg. No.129-17-9).

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden. Diese Verwendung kann auch in Kombination mit einem anderen Photoinitiator und/oder anderen Additiven erfolgen.

Die Erfindung betrifft daher auch photopolymerisierbare Zusammensetzungen, enthaltend

(a) mindestens eine ethylenisch ungesättigte photopolymerisierbare Verbindung und
(b) mindestens eine Verbindung der Formel I,

wobei die Zusammensetzung neben der Komponenten (a) und (b) noch andere Photoinitiatoren und/oder andere Additive enthalten kann.

Erfindungsgemäss ist auch eine Zusammensetzung, enthaltend zusätzlich zu den Komponenten (a) und (b) mindestens eine Verbindung der Formel XI

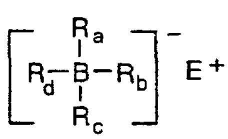
(XI)

worin $R_a$, $R_b$, $R_c$ und $R_d$ unabhängig voneinander für $C_1$-$C_{12}$-Alkyl, Trimethylsilylmethyl, Phenyl, einen anderen aromatischen Kohlenwasserstoff, $C_1$-$C_6$-Alkylphenyl, Allyl, Phenyl-$C_1$-$C_6$-alkyl, $C_2$-$C_8$-Alkenyl, $C_2$-$C_8$-Alkinyl, $C_3$-$C_{12}$-Cycloalkyl oder gesättigte oder ungesättigte heterozyclische Reste stehen, wobei die Reste Phenyl, anderer aromatischer Kohlenwasserstoff, Phenyl-$C_1$-$C_6$-alkyl, gesättigter oder ungesättigter heterozyclischer Rest unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,
p 0, 1 oder 2 ist;
q 0 oder 1 ist;
$R_6$ und $R_7$ unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,
$R_{7a}$ für $C_1$-$C_{12}$-Alkyl steht;
$R_8$, $R_9$, $R_{10}$, $R_{11}$, $R_{12}$, $R_{13}$, $R_{14}$ und $R_{15}$ unabhängig voneinander eine der Bedeutungen von $R_6$ haben oder $C_3$-$C_{12}$-Cy-

cloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;
$R_{16}$ und $R_{17}$ unabhängig voneinander eine der Bedeutungen von $R_6$ haben oder $C_3$-$C_{12}$-Cycloalkyl sind; und E für einen Rest steht, welcher positive Ionen bilden kann, insbesondere Alkalimetalle, Ammonium, Tetraalkylammonium, Farbstoffkationen, Sulfonium- oder Phosphoniumkationen.

Wie schon erwähnt, ist die Kombination der erfindungsgemässen Boratverbindungen mit Coinitiatoren, z.B. auch solchen, welche Sensibilisatoren (d.h. Energieüberträger) sind, vorteilhaft. Dabei sind auch insbesondere Kombinationen mit mehreren verschiedenen Sensibilisatoren, wie z.B. Mischungen der erfindungsgemässen Boratverbindungen mit "Onium"-Salzen und Thioxanthonen oder Coumarinen oder Farbstoffen, sehr effektiv. Bevorzugte "Onium"-Salze in diesen Mischungen sind Diphenyliodonium-hexafluorophosphat, (p-Octyloxyphenyl)(phenyl)iodonium-hexafluorophosphat, oder entsprechende andere Anionen dieser Verbindungen, wie z.B. die Halogenide; aber auch Sulfoniumsalze, wie z.B. Triarylsulfoniumsalze (Cyracure®UVI 6990, Cyracure® UVI-6974 von Union Carbide; Degacure® KI 85 von Degussa oder SP-150 und SP-170 von Asahi Denka). Bevorzugt ist beispielsweise eine Mischung der erfindungsgemässen Boratver-bindungen mit Diphenyliodonium-hexafluorophosphat und Isopropylthioxanthon, eine Mischung der erfindungsgemässen Boratverbindungen mit (p-Octyloxyphenyl)(phenyl)iodo-niumhexafluorophosphat und Isopropylthioxanthon, sowie eine Mischung der erfindungsgemässen Boratverbindungen mit

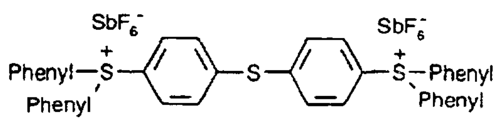

+

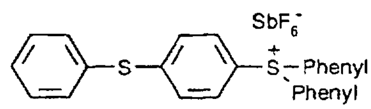

(=Cyracure® UVI-6974) und Isopropylthioxanthon.

Besonders vorteilhaft ist es jedoch auch den oben erwähnten Mischungen noch einen weiteren Photoinitiator von $\alpha$-Aminoketon-Typ zuzusetzen. So sind beispielsweise Mischungen aus den erfindungsgemässen Boraten mit "Onium"-Salzen und Thioxanthonen oder Farbstoffen und $\alpha$-Aminoketonen sehr effektiv. Ein bevorzugtes Beispiel ist die Mischung der erfindungsgemässen Boratverbindungen mit Diphenyliodonium-hexafluorophosphat oder (p-Octyloxyphenyl)(phenyl)iodonium-hexafluorophosphat, Isopropylthioxanthon und (4-Methylthiobenzoyl)-methyl-1-morpholino-ethan.

Erfindungsgemäss ist daher auch eine Zusammensetzung, enthaltend zusätzlich zu den Komponenten (a) und (b) mindestens einen neutralen, anionischen oder kationischen Farbstoff oder eine Thioxanthonverbindung und eine Oniumverbindung. Bevorzugt sind die oben erwähnten Oniumverbindungen.
Weiterhin erfindungsgemäss ist eine Zusammensetzung, enthaltend zusätzlich zu den Komponenten (a) und (b) mindestens einen neutralen, anionischen oder kationischen Farbstoff und eine Oniumverbindung und einen radikalischen Photoinitiator, insbesondere eine $\alpha$-Aminoketonverbindung.

Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkylacrylate oder -methacrylate, wie z.B. Methyl-, Ethyl-, Butyl-, 2-Ethylhexyl- oder 2-Hydroxyethyla-crylat, Isobornylacrylat, Methyl- oder Ethylmethacrylat. Interessant sind auch Silicon-acrylate. Weitere Beispiele sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4'-Bis(2-acryloyloxyethoxy)-diphenylpropan, Trimethylolpropan-triacrylat, Pentaerythrittriacrylat oder -tetraacrylat, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte oder Vinylether- oder Epoxy-Gruppen enthaltende Polyester, Polyurethane und Polyether. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Daneben können auch

Vinylether-Monomere und -Oligomere, sowie maleat-terminierte Oligomere mit Polyester-, Polyurethan-, Polyether-, Polyvinylether- und Epoxidhauptketten eingesetzt werden. Insbesondere Kombinationen von Vinylethergruppen tragenden Oligomeren und Polymeren, wie sie in der WO 90/01512 beschrieben sind, sind gut geeignet. Aber auch Copolymere aus Vinylether und Maleinsäure funktionalisierten Monomeren kommen in Frage. Solche ungesättigten Oligomere kann man auch als Prepolymere bezeichnen.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Alkydharze, Polybutadien und Butadien-Copolymere, Polyisopren und Iso-pren-Copolymere, Polymere und Coplymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Triethylenglykol, Polyethyfenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl) amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:

Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3-oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di(β-aminoethoxy)- oder Di(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen. Beispiele für solche ungesättigten Amide sind: Methylen-bis-acrylamid, 1,6-Hexamethylenbis-acrylamid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)(Meth) -Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Vinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 40-90 Gew.-% betragen, bezogen auf den Gesamtfestkörper. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2000000, bevorzugt 10000-1000000. Beispiele sind: Homo- und Copolymere Acrylate und Methacrylate, z.B. Copolymere aus Methylmethacrylat/Ethylacrylat/Methacrylsäure, Poly-(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösemitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.
Erfindungsgemäss sind auch Zusammensetzungen, worin zusätzlich zu den Komponenten (a) und (b) mindestens ein Elektronenakzeptor (c), wie z.B. ein Farbstoff oder ein UV-Absorber, enthalten ist.
Geeignete Farbstoffe (c) sind oben beschrieben. Ausserdem geeignet sind z.B. Benzoxanthen-, Benzothioxanthen-, Pyronin- oder Porphyrin-Farbstoffe.
Als Elektronenakzeptor (c) geeignete UV-Absorber sind z.B. Thioxanthonderivate, Coumarine, Benzophenon, Benzophenonderivate oder Hexaarylbisimidazolderivate (HABI). Geeignete Hexaarylbisimidazolderivate sind z.B. in den US Patenten 3,784,557, 4,252,887, 4,311,783, 4,459,349, 4,410,621 und 4,622,286 beschrieben. Insbesondere interessant sind 2-o-chlorophenyl-substituierte Derivate wie z.B. 2,2'-bis(o-chlorophenyl)-4,4',5,5'tetraphenyl-1,1'-bisimidazol. Andere in diesem Zusammenhang geeignete UV-Absorber sind z.B. polycyclische aromatische Kohlenwasserstoffe, wie z.B. Anthracen oder Pyren, sowie die in der EP-A-137 452, der DE-A-27 18 254 und der DE-A-22 43 621 beschriebenen Triazine. Weitere geeignete Triazine sind dem US Patent 4,950,581, Spalte 14, Zeile 60 bis Spalte 18, Zeile 44 zu entnehmen. Insbesondere interessant sind Trihalogenmethyltriazine, wie z.B. 2,4-Bis(trichloromethyl)-6-(4-styryl-phenyl)-s-triazin. Weitere geeignete Elektronenakzeptoren (c) sind Benzopteridinedione (beschrieben in JP Hei 02 113002), substituierte Benzophenone (z.B Michler's Keton, Quantacure ABQ, Quantacure BPQ und Quantacure BTC der Firma International Biosynthetics), Trichlormethyltriazine (beschrieben in JP Hei 01 033548), Metallkomplexe (beschrieben in JP Hei 04 261405), Porphyrine (beschrieben in JP Hei 06 202548 und JP Hei 06 195014), Coumarine und Ketocoumarine (beschrieben in US 4,950,581 und JP Hei 06 175557), p-Aminophenyl-Verbindungen (beschrieben in EP-A 475153), Xanthene (beschrieben in JP Hei 06 175566) oder Pyrilium-, Thiopyrilium- und Selenopyrilium Farbstoffe (beschrieben in JP Hei 06 175563).

Es ist, wie oben bereits erwähnt, auch möglich die erfindungsgemässen Polyborate der Formel I mit Farbstoffkationen oder Sulfonium- oder Iodoniumkationen auszustatten und so als Photoinitiator einzusetzen. Gegenstand der Erfindung ist daher auch eine Zusammensetzung enthaltend

(a) mindestens eine ethylenisch ungesättigte photopolymerisierbare Verbindung und
(b) mindestens ein Polyborat-Anion der Formel Ia

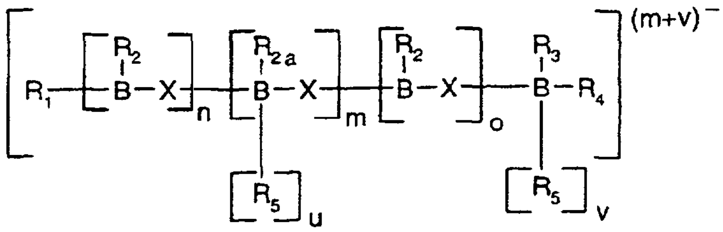

(Ia)

worin die Reste $R_1$, $R_2$, $R_{2a}$, $R_3$, $R_4$, $R_5$ und X, sowie n, m, o, u und v wie in Anspruch 1 definiert sind, und (c) ein Farbstoff-, Sulfoium oder lodonium-Kation.

Erfindungsgemäss ist auch eine wie oben beschriebene Zusammensetzung, enthaltend zusätzlich mindestens eine weitere Boratverbindung der Formel XI

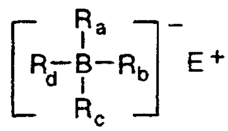

(XI)

worin $R_a$, $R_b$, $R_c$ und $R_d$ unabhängig voneinander für $C_1$-$C_{12}$-Alkyl, Trimethylsilylmethyl, Phenyl, einen anderen aromatischen Kohlenwasserstoff, $C_1$-$C_6$-Alkylphenyl, Allyl, Phenyl-$C_1$-$C_6$-alkyl, $C_2$-$C_8$-Alkenyl, $C_2$-$C_8$-Alkinyl, $C_3$-$C_{12}$-Cycloalkyl oder gesättigte oder ungesättigte heterozyclische Reste stehen, wobei die Reste Phenyl, anderer aromatischer Kohlenwasserstoff, Phenyl-$C_1$-$C_6$-alkyl, gesättigter oder ungesättigter heterozyclischer Rest unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,

p 0, 1 oder 2 ist;

q 0 oder 1 ist;

$R_6$ und $R_7$ unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,

$R_{7a}$ für $C_1$-$C_{12}$-Alkyl steht;

$R_8$, $R_9$, $R_{10}$, $R_{11}$, $R_{12}$, $R_{13}$, $R_{14}$ und $R_{15}$ unabhängig voneinander eine der Bedeutungen von $R_6$ haben oder $C_3$-$C_{12}$-Cycloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;

$R_{16}$ und $R_{17}$ unabhängig voneinander eine der Bedeutungen von $R_6$ haben oder $C_3$-$C_{12}$-Cycloalkyl sind; und

E für einen Rest steht, welcher positive Ionen bilden kann, insbesondere Alkalimetalle, Ammonium, Tetraalkylammonium, Farbstoffkationen, Sulfonium- oder Phosphoniumkationen.

Erfindungsgemäss ist auch eine Zusammensetzung, enthaltend mindestens ein Borat der Formel I und mindestens einen Farbstoff, der während oder nach der Bestrahlung seine Farbe verändert oder verliert, wobei dieser Farbstoff auch als Kation Bestandteil der Verbindung der Formel I sein kann.

Beispiele solcher Farbstoffe sind z.B. Cyanin- und Pyriliumfarbstoffe.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon, Hydrochinonderivate, p-Methoxyphenol, β-Naphthol oder sterisch gehinderte Phenole wie z.B. 2,6-Di(tert-butyl)-p-kresol. Zur Erhöhung der Dunkellagerstabilität können z.B. Kupferverbindungen, wie Kupfernaphthenat, -stearat oder -octat, Phosphorverbindungen, wie z.B. Triphenylphosphin, Tributylphosphin, Triethylphosphit, Triphenylphosphit oder Tribenzylphosphit, quartäre Ammoniumverbindungen, wie z.B. Tetramethylammoniumchlorid oder Trimethylbenzylammoniumchlorid, oder Hydroxylaminderivate, wie z.B. N-Diethyl-hydroxylamin verwendet werden. Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den Zutritt von Luft verhindert. Ebenso kann eine sauerstoffundurchlässige Schicht aufgetragen werden. Als Lichtschutzmittel können in geringer Menge UV-Absorber, wie z.B. solche vom Hydroxyphenyl-benztriazol-, Hydroxyphenyl-benzophenon-, Oxalsäureamid- oder Hydroxyphenyl-s-triazin-Typ,

zugesetzt werden. Es können einzelne oder Mischungen dieser Verbindungen mit oder ohne Einsatz von sterisch gehinderten Aminen (HALS) verwendet werden.

Beispiele für solche UV-Absorber und Lichtschutzmittel sind

1.2-(2'-Hydroxyphenyl)-benzotriazole, wie z.B. 2-(2'-Hydroxy-5'-methylphenyl)-benzotriazol, 2-(3',5'-Di-tert-butyl-2'-hydroxyphenyl)-benzotriazol, 2-(5'-tert-Butyl-2'-hydroxyphenyl)-benzotriazol, 2-(2'-Hydroxy-5'-(1,1,3,3-tetramethylbutyl)phenyl)-benzotriazol, 2-(3',5'-Di-tert-butyl-2'-hydroxyphenyl)-5-chlor-benzotriazol, 2-(3'-tert-Butyl-2'-hydroxy-5'-methylphenyl)-5-chlor-benzotriazol, 2-(3'-sec-Butyl-5'-tert-butyl-2'-hydroxyphenyl)-benzotrizol, 2-(2'-Hydroxy-4'-octoxyphenyl)-benzotriazol, 2-(3',5'-Di-tert-amyl-2'-hydroxyphenyl)-benzotriazol, 2-(3',5'-Bis-(a,a-dimethylbenzyl)-2'-hydroxyphenyl)-benzotriazol, Mischung aus 2-(3'-tert-Butyl-2'-hydroxy-5'-(2-octyloxycarbonylethyl) phenyl)-5-chlor-benzotriazol, 2-(3'-tert-Butyl-5'-[2-(2-ethylhexyloxy)-carbonylethyl]-2'-hydroxyphenyl)-5-chlorbenzotriazol, 2-(3'-tert-Butyl-2'-hydroxy-5'-(2-methoxycarbonylethyl)phenyl)-5-chlor-benzotriazol, 2-(3'-tert-Butyl-2'-hydroxy-5'-(2-methoxycarbonylethyl)phenyl)-benzotriazol, 2-(3'-tert-Butyl-2'-hydroxy-5'-(2-octyloxycarbonylethyl)phenyl)-benzotriazol, 2-(3'-tert-Butyl-5'-[2-(2-ethylhexyloxy)carbonylethyl]-2'-hydroxyphenyl)-benzotriazol, 2-(3'-Dodecyl-2'-hydroxy-5'-methylphenyl)-benzotriazol, und 2-(3'-tert-Butyl-2'-hydroxy- 5'-(2-isooctyloxycarbonylethyl)phenyl-benzotriazol, 2,2'-Methylenbis[4-(1,1,3,3-tetramethylbutyl)-6-benzotriazol-2-yl-phenol]; Umesterungsprodukt von 2-[3'-tert-Butyl-5'-(2-methoxycarbonylethyl)-2'-hydroxy-phenyl]-benzotriazol mit Polyethylenglycol 300; $[R-CH_2CH_2-COO(CH_2)_3]_2$- mit R = 3'-tert-Butyl-4'-hydroxy-5'-2H-benzotriazol-2-ylphenyl.

2. 2-Hydroxybenzophenone, wie z.B. das 4-Hydroxy-, 4-Methoxy-, 4-Octoxy-, 4-Decyloxy-, 4-Dodecyloxy-, 4-Benzyloxy-, 4,2',4'-Trihydroxy-, 2'-Hydroxy-4,4'-dimethoxy-Derivat.

3. Ester von gegebenenfalls substituierten Benzoesäuren, wie z.B. 4-tert-Butyl-phenylsalicylat, Phenylsalicylat, Octylphenyl-salicylat, Dibenzoylresorcin, Bis-(4-tert-butylbenzoyl)-resorcin, Benzoylresorcin, 3,5-Di-tert-butyl-4-hydroxybenzoesäure-2,4-di-tert-butylphenylester, 3,5-Di-tert-butyl-4-hydroxybenzoesäurehexadecylester, 3,5-Di-tert- butyl-4-hydroxybenzoesäure-octadecylester, 3,5-Di-tert-butyl-4-hydroxybenzoesäure-2-methyl-4,6-di-tert-butylphenylester.

4. Acrylate, wie z.B. α-Cyan-β,β-diphenylacrylsäure-ethylester bzw. -isooctylester, α-Carbomethoxy-zimtsäure-methylester, α-Cyano-β-methyl-p-methoxy-zimtsäuremethylester bzw. -butylester, α-Carbomethoxy-p-methoxy-zimtsäure-methylester, N-(β-Carbomethoxy-β-cyanovinyl)-2-methyl-indolin.

5. Sterisch gehinderte Amine, wie z.B. Bis-(2,2,6,6-tetramethyl-piperidyl)-sebacat, Bis-(2,2,6,6-tetramethyl-piperidyl)-succinat, Bis-(1,2,2,6,6-pentamethylpiperidyl)-sebacat, n-Butyl-3,5-di-tert-butyl-4-hydroxybenzyl-malonsäure-bis(1,2, 2,6,6-pentamethylpiperidyl)-ester, Kondensationsprodukt aus 1-Hydroxyethyl-2,2,6,6-tetramethyl-4-hydroxypiperidin und Bernsteinsäure, Kondensationsprodukt aus N,N'-Bis-(2,2,6,6-Tetramethyl-4-piperidyl)-hexamethylendiamin und 4-tert-Octylamino-2,6-dichlor-1,3,5-s-triazin, Tris-(2,2,6,6-tetramethyl-4-piperidyl)-nitrilotriacetat, Tetrakis-(2,2,6,6-tetramethyl-4-piperidyl)-1,2,3,4-butantetraoat, 1,1'-(1,2-Ethandiyl)-bis-(3,3,5,5-tetramethyl-piperazinon), 4-Benzoyl-2,2,6,6-tetramethylpiperidin, 4-Stearyloxy-2,2,6,6-tetramethylpiperidin, Bis-(1,2,2,6,6-pentamethylpiperidyl)-2-n-butyl-2-(2-hydroxy-3,5-di-tert-butylbenzyl)-malonat, 3-n-Octyl-7,7,9,9-tetramethyl-1,3,8-triazaspiro-[4.5]decan-2,4-dion, Bis-(1-octyloxy-2,2,6,6-tetramethylpiperidyl)-sebacat, Bis-(1-octyloxy-2,2,6,6-tetramethylpiperidyl)-succinat, Kondensationsprodukt aus N,N'-Bis-(2,2,6,6-tetramethyl-4-piperidyl)-hexamethylendiamin und 4-Morpholino-2,6-dichlor-1,3,5-triazin, Kondensationsprodukt aus 2-Chlor-4,6-di-(4-n-butylamino-2,2,6,6-tetramethylpiperidyl)-1,3,5-triazin und 1,2-Bis-(3-aminopropylamino)äthan, Kondensationsprodukt aus 2-Chlor-4,6-di-(4-nbutylamino-1,2,2,6,6-pentamethylpiperidyl)-1,3,5-triazin und 1,2-Bis-(3-aminopropylamino)-äthan, 8-Acetyl-3-dodecyl-7,7,9,9-tetramethyl-1,3,8-triazaspiro[4.5]decan-2,4-dion, 3-Dodecyl-1-(2,2,6,6-tetramethyl-4-piperidyl)pyrrolidin-2,5-dion, 3-Dodecyl-1-(1,2,2,6,6-pentamethyl-4-piperidyl)-pyrrolidin-2,5-dion.

6. Oxalsäurediamide, wie z.B. 4,4'-Di-octyloxy-oxanilid, 2,2'-Diethoxy-oxanilid, 2,2'-Di-octyloxy-5,5'-di-tert-butyl-oxanilid, 2,2'-Di-dodecyloxy-5,5'di-tert-butyl-oxanilid, 2-Ethoxy-2'-ethyloxanilid, N,N'-Bis-(3-dimethylaminopropyl)-oxalamid, 2-Ethoxy-5-tert-butyl-2'-ethyloxanilid und dessen Gemisch mit 2-Ethoxy-2'-ethyl-5,4'-di-tert-butyl-oxanilid, Gemische von o- und p-Methoxy- sowie von o- und p-Ethoxy-di-substituierten Oxaniliden.

7.2-(2-Hydroxyphenyl)-1,3,5-triazine, wie z.B. 2,4,6-Tris(2-hydroxy-4-octyloxyphenyl)-1,3,5-triazin, 2-(2-Hydroxy-4-octyloxyphenyl)-4,6-bis-(2,4-dimethylphenyl)-1,3,5-triazin, 2-(2,4-Dihydroxyphenyl)-4,6-bis(2,4-dimethylphenyl)-1,3,5-triazin, 2,4-Bis(2-hydroxy-4-propyloxyphenyl)-6-(2,4-dimethylphenyl)-1,3,5-triazin, 2-(2-Hydroxy-4-octyloxyphenyl)-4,6-bis(4-methylphenyl)-1,3,5-triazin, 2-(2-Hydroxy-4-dodecyloxyphenyl)-4,6-bis(2,4-dimethylphenyl)-1,3,5-triazin, 2-[2-hydroxy-4-(2-hydroxy-3-butyloxy-propyloxy) phenyl]-4,6-bis(2,4-dimethylphenyl)-1,3,5-triazin, 2-[2-hydroxy-4-(2-hydroxy-3-octyloxy-propyloxy)phenyl]-4,6-bis(2,4-dimethylphenyl)-1,3,5-triazin, 2-[4-dodecyl/tridecyl-oxy-(2-hydroxypropyl)oxy-2-hydroxyphenyl]-4,6-bis(2,4-dimethylphenyl)-1 ,3,5-triazin.

8. Phosphite und Phosphonite, wie z.B. Triphenylphosphit, Diphenylalkylphosphite, Phenyldialkylphosphite, Tris-(nonylphenyl)-phosphit, Trilaurylphosphit, Trioctadecylphosphit, Distearyl-pentaerythritdiphosphit, Tris-(2,4-di-tert-butylphenyl)-phosphit, Diisodecylpentaerythrit-diphosphit, Bis-(2,4-di-tert-butylphenyl)-pentaerythritdiphosphit, Bis-(2,6-di-tert-butyl-4-methylphenyl)-pentaerythritdiphosphit, Bis-isodecyloxy-pentaerythritdiphosphit, Bis-(2,4-di-tert-butyl-6-methylphenyl)-pentaerythritdiphosphit, Bis-(2,4,6-tri-tert-butylphenyl)-pentaerythritdiphosphit, Tristearyl-sorbit-triphosphit, Tetrakis-(2,4-di-tert-butylphenyl)-4,4'-biphenylen-diphosphonit, 6-Isooctyloxy-2,4,8,10-tetra-tert-butyl-12H-dibenz[d,g]-1,3,2-dioxaphosphocin, 6-Fluor-2,4,8,10-tetra-tert-butyl-12-methyl-dibenz[d,g]-1,3,2-dioxaphosphocin, Bis-(2,4-di-tert-butyl-6-methylphenyl)-methylphosphit, Bis-(2,4-di-tert-butyl-6-methylphenyl)-ethylphosphit.

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons. Als Sauerstofffänger brauchbare Amine sind beispielsweise substituierte N,N-dialkylaniline, wie sie in der EP-A-339 841 beschrieben sind. Weitere Beschleuniger, Coinitiatoren und Autoxidizer sind z.B. Thiole, Thioether, Disulfide und Phosphine, wie beispielsweise in der EP-A-438 123 und GB-A-2 180 358 beschrieben.

Unterstützt werden kann der Härtungsvorgang insbesondere von (z.B. mit Titandioxid) pigmentierten Zusammensetzungen, auch durch Zugabe einer unter thermischen Bedingungen radikalbildenden Komponente wie z.B. einer Azoverbindung wie etwa 2,2'-Azobis(4-methoxy-2,4-dimethylvaleronitril), eines Triazenes, Diazosulfids, Pentazadiens oder einer Peroxyverbindung wie etwa Hydroperoxid oder Peroxycarbonat, z.B. t-Butylhydroperoxid, wie z.B. in der EP-A-245 639 beschrieben.

Weitere übliche Zusätze sind - je nach Verwendungszweck - optische Aufheller, Füllstoffe, Pigmente, Farbstoffe, Netzmittel oder Verlaufhilfsmittel. Zur Härtung dicker und pigmentierter Beschichtungen eignet sich der Zusatz von MikroGlaskugeln oder pulverisierter Glasfasern, wie z.B. im US-A-5,013,768 beschrieben.

Gegenstand der Erfindung sind auch Zusammensetzungen enthaltend als Komponente (a) mindestens eine in Wasser gelöste oder emulgierte ethylenisch ungesättigte photopolymerisierbare Verbindung.

Solche strahlungshärtbaren wässrigen Prepolymerdispersionen sind in vielen Variationen im Handel erhältlich. Man versteht darunter eine Dispersion aus Wasser und mindestens einem darin dispergierten Prepolymeren. Die Konzentration des Wassers in diesen Systemen liegt z.B. bei 5 bis 80, insbesondere 30 bis 60 Gew.-%. Das strahlungshärtbare Prepolymere bzw. Prepolymerengemisch ist beispielsweise in Konzentrationen von 95 bis 20, insbesondere 70 bis 40 Gew.-% enthalten. In diesen Zusammensetzungen ist die Summe der für Wasser und Prepolymere genannten Prozentzahlen jeweils 100, die Hilfsund Zusatzstoffe kommen, je nach Verwendungszweck in unterschiedlichen Mengen hinzu.

Bei den strahlungshärtbaren, in Wasser dispergierten, oft auch gelösten filmbildenden Prepolymeren handelt es sich um für wässrige Prepolymerdispersionen an sich bekannte, durch freie Radikale initiierbare mono- oder polyfunktionelle ethylenisch ungesättigte Prepolymere, die beispielsweise einen Gehalt von 0,01 bis 1,0 Mol pro 100 g Prepolymer an polymerisierbaren Doppelbindungen, sowie ein mittleres Molekulargewicht von z.B. mindestens 400, insbesondere von 500 bis 10000 aufweisen. Je nach Anwendungszweck kommen jedoch auch Prepolymere mit höheren Molekulargewichten in Frage. Es werden beispielsweise polymerisierbare C-C-Doppelbindungen enthaltende Polyester mit einer Säurezahl von höchstens 10, polymerisierbare C-C-Doppelbindungen enthaltende Polyether, hydroxylgruppenhaltige Umsetzungsprodukte aus einem mindestens zwei Epoxidgruppen pro Molekül enthaltenden Polyepoxid mit mindestens einer α,β-ethylenisch ungesättigten Carbonsäure, Polyurethan(meth-)acrylate sowie α,β-ethylenisch ungesättigte Acrylreste enthaltende Acrylcopolymere verwendet, wie sie in der EP-A-12 339 beschrieben sind. Gemische dieser Prepolymeren können ebenfalls verwendet werden. In Frage kommen ausserdem die in der EP-A-33 896 beschriebenen polymerisierbaren Prepolymere, bei denen es sich um Thioetheraddukte von polymerisierbaren Prepolymeren mit einem mittleren Molekulargewicht von mindestens 600, einem Carboxylgruppengehalt von 0,2 bis 15 % und einem Gehalt von 0,01 bis 0,8 Mol polyrnerisierbarer C-C-Doppelbindungen pro 100 g Prepolymer handelt. Andere geeignete wässrige Dispersionen auf Basis von speziellen (Meth-)Acrylsäurealkylester-Polymerisaten sind in der EP-A-41 125 beschrieben, geeignete in Wasser dispergierbare, strahlungshärtbare Prepolymere aus Urethanacrylaten sind der DE-A-29 36 039 zu entnehmen.

Als weitere Zusätze können diese strahlungshärtbaren wässrigen Prepolymerdispersionen Dispergierhilfsmittel, Emulgatoren, Antioxidantien, Lichtstabilisatoren, Farbstoffe, Pigmente, Füllstoffe, z.B. Talkum, Gips, Kieselsäure, Rutil, Russ, Zinkoxid, Eisenoxide, Reaktionsbeschieuniger, Verlaufsmittel, Gleitmittel, Netzmittel, Verdickungsmittel, Mattierungsmittel, Entschäumer und andere in der Lacktechnologie übliche Hilfsstoffe enthalten. Als Dispergierhilfsmittel kommen wasserlösliche hochmolekulare organische Verbindungen mit polaren Gruppen, wie z.B. Polyvinylalkohole, Polyvinylpyrrolidon oder Celluloseether in Frage. Als Emulgatoren können nicht-ionische, gegebenenfalls auch ionische Emulgatoren verwendet werden.

Die photopolymerisierbaren Zusammensetzungen enthalten den Photoinitiator (b) zweckmässig in einer Menge von 0,05 bis 15 Gew.-%, vorzugsweise 0,1 bis 5 Gew.-%, bezogen auf die Zusammensetzung.

In bestimmten Fällen kann es von Vorteil sein, Gemische von zwei oder mehr der erfindungsgemässen Photoinitiatoren zu verwenden. Wie oben bereits erwähnt, können selbstverständlich auch Gemische mit anderen bekannten Photoinitiatoren verwendet werden, z.B. Gemische mit Benzophenon, Benzophenonderivaten, Acetophenon, Acetophenonderivaten, wie beispielsweise α-Hydroxycycloalkylphenyl-ketonen, Dialkoxyacetophenonen, α-Hydroxy- oder α-Aminoacetophenonen, 4-Aroyl-1,3-Dioxolanen, Benzoinalkylethem und Benzilketalen, Monoacylphosphinoxiden, Bisacylphosphinoxiden, Titanocenen oder Ferrocenen.

Beispiele für besonderes geeignete zusätzliche Photoinitiatoren sind: 1-(4-Dodecylbenzoyl)-1-hydroxy-1-methyl-ethan, 1-(4-Isopropylbenzoyl)-1-hydroxy-1-methyl-ethan, 1-benzoyl-1-hydroxy-1-methyl-ethan, 1-[4(2-Hydroxyethoxy)-benzoyl]-1-hydroxy-1-methyl-ethan, 1-[4(Acryloyloxyethoxy)benzoyl]-1-hydroxy-1-methyl-ethan, Diphenylketon, Phenyl-1 -hydroxycyclohexylketon, (4-Morpholinobenzoyl)-1-benzyl-1-dimethylamino-propan, 1-(3,4-Dimethoxyphenyl)-2-benzyl-2-dimethylamino-butanon-1, (4-Methylthiobenzoyl)-1-methyl-1-morpholino-ethan, Benzildimethylketal, Bis(cyclopentadienyl)-bis(2,6-difluoro-3-pyrrylphenyl)-titan, Cyclopentadienyl-aren-eisen(II)-Komplexsalze,z.B. ($\eta^6$-Iso-propylbenzol)($\eta^5$cyclopentadien-yl)-eisen-II-hexafluorophosphat, Trimethylbenzoyldiphenylphosphinoxid, Bis (2,6-dimethoxy-benzoyl)-(2,4,4-trimethyl-pentyl)-phosphinoxid, Bis(2,4,6-trimethylbenzoyl)-2,4-dipentoxyphenylphosphin-oxid oder Bis(2,4,6-trimethylbenzoyl)-phenyl-phosphinoxid. Weitere geeignete zusätzliche Photoinitiatoren sind dem US Patent 4,950,581 Spalte 20, Zeile 35 bis Spalte 21, Zeile 35 zu entnehmen.

Geeignet sind weiterhin Triazin-verbindungen, wie z.B. die in der EP-A-137 452, der DE-A-27 18 254 und der DE-A-22 43 621 beschriebenen Triazine. Weitere geeignete Triazine sind dem US Patent 4,950,581, Spalte 14, Zeile 60 bis Spalte 18, Zeile 44 zu entnehmen. Insbesondere interessant sind Trihalogenmethyltriazine, wie z.B. 2,4-Bis(trichloromethyl)-6-(4-styryl-phenyl)-s-triazin.

Im Falle des Einsatzes der erfindungsgemäßen Photoinitiatoren in Hybridsystemen werden zusätzlich zu den erfindungsgemäßen radikalischen Härtern kationische Photoinitiatoren wie z.B. Peroxidverbindungen, z.B. Benzoylperoxid (weitere geegnete Peroxide sind im US Patent 4,950,581 Spalte 19, Zeilen 17-25 beschrieben), aromatische Sulfonium-, Phosphonium- oder lodonium-Salze (wie z.B. im US Patent 4,950,581 Spalte 18, Zeile 60 bis Spalte 19, Zeile 10 beschrieben) oder Cyclopentadienyl-aren-eisen(II)-Komplexsalze,z.B. ($\eta^6$-Isopropylbenzol)($\eta^5$-cyclopentadien-yl)-eisen-II-hexafluorophosphat, verwendet.

Gegenstand der Erfindung sind daher auch Zusammensetzungen, die neben dem Photoninitiator (b) noch mindestens einen weiteren Photoinitator (d) und/oder andere Additive enthalten.

Insbesondere interessant sind Zusammenseztungen enthaltend als zusätzlichen Photoinitiator (d) ein Titanocen, ein Ferrocen, ein Benzophenon, einen Benzoinalkylether, ein Benzilketal, ein 4-Aroyl-1,3-dioxolan, ein Dialkoxyacetophenon, ein α-Hydroxy- oder α-Aminoacetophenon, ein α-Hydroxycycloalkyl-phenylketon, ein Xanthon, ein Thioxanthon, ein Anthrachinon oder ein Mono- oder Bisacylphosphinoxid oder Mischungen davon als zusätzlichen Photoinitiator.

Interessant sind auch Zusammensetzungen, worin als weiteres Additiv eine leicht reduzierbare Verbindung, insbesondere ein halogenierter Kohlenwasserstoff, eingesetzt wird.

Als leicht reduzierbare Verbindungen kommen z.B. halogenierte Kohlenwasserstoffe in Frage. Beispiele dafür sind insbesondere

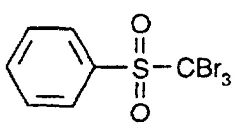 , 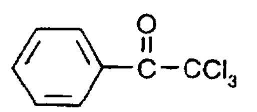 ,

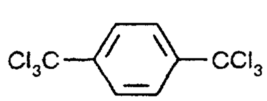 , 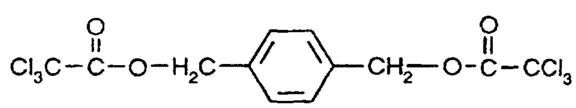 .

Unter leicht reduzierbarer Verbindung sind in diesem Zusammenhang auch Verbindungen wie sie im US Patent 4,950, 581 beschrieben sind zu verstehen, beispielsweise auch lodoniumsalze, Sulfoniumsalze, organische Peroxide, Verbindungen mit Kohlenstoff-Halogenid Bindungen (Trichlormethyltriazine), heterocyclische Schwefelverbindungen und andere Photoinitiatoren (α-Aminoketone). Andere Additive sind z.B Heterocylen wie sie in den Patenten und Patentanmeldungen US 5,168,032, JP 02 244050, JP 02 054268, JP 01 017048 und DE 383308 beschrieben sind. Weitere Additive sind z.B. aromatische Imine, beschrieben in US 5,079,126 und aromatische Diazoverbindungen beschrieben in US 5,200,292 (z.B. Iminochinondiazide), Thiole, beschrieben in US 4,937,159 und Thiole und N,N-Dialkylaniline, beschrieben in US 4,874,685. Es können auch mehrere der aufgeführten Coinitiatoren bzw. Elektronenakzeptoren und Additive kombiniert eingesetzt werden.

Die photopolymerisierbaren Zusammensetzungen können für verschiedene Zwecke verwendet werden, beispielsweise als Druckfarbe, als Klarlack, als Weisslack, z.B. für Holz oder Metall, als Anstrichstoff, u.a. für Papier, Holz, Metall oder Kunststoff, als Pulverlack, als tageslichthärtbarer Anstrich für Bauten- und Straßenmarkierung, für photographische Reproduktionsverfahren, für holographische Aufzeichnungsmaterialien, für Bildaufzeichnungsverfahren oder zur Herstellung von Druckplatten, die mit organischen Lösemitteln oder wässrig-alkalisch entwickelbar sind, zur Herstellung von Masken für den Siebdruck, als Zahnfüllmassen, als Klebstoffe, als drucksensitive Klebstoffe, als Laminierharze, als Aetzoder Permanentresists und als Lötstoppmasken für elektronische Schaltungen, zur Herstellung von dreidimensionalen Gegenständen durch Massenhärtung (UV-Härtung in transparenten Formen) oder nach dem StereolithographieVerfahren, wie es z.B. im US-Patent Nr. 4,575,330 beschrieben ist, zur Herstellung von Verbundwerkstoffen (z.B. styrolischen Polyestern, die gegebenenfalls Glasfasern und/oder andere Fasern und andere Hilfsstoffe, enthalten können) und anderen dickschichtigen Massen, zur Beschichtung oder Versiegelung von elektronischen Teilen oder als Ueberzüge für optische Fasern.

Die erfindungsgemäßen Verbindungen können weiterhin als Initatoren für Emulsions-, Perl- oder Suspensionspolymerisationen, als Initiatoren einer Polymerisation für die Fixierung von Ordnungszuständen von flüssigkristallinen Mono- und Oligomeren oder als Initiatoren für die Fixierung von Farbstoffen auf organischen Materialien eingesetzt werden.

In Lacken verwendet man häufig Gemische eines Prepolymeren mit mehrfach ungesättigten Monomeren, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vemetzer, das den Lackfilm unlöslich macht. Das einfach ungesättigte Monomere fungiert als reaktiver Verdünner, mit dessen Hilfe die Viskosität herabgesetzt wird, ohne dass ein Lösungsmittel verwendet werden muss.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-A-23 08 830 beschrieben sind.

Die erfindungsgemässen Verbindungen und Mischungen davon können weiterhin als radikalische Photoinitiatoren oder photoinitiierende Systeme für strahlenhärtbare Pulverlacke verwendet werden. Die Pulverlacke können auf festen Harzen und Monomeren enthaltend reaktive Doppelbindungen basieren, wie z.B. Maleaten, Vinylethern, Acrylaten, Acrylamiden und Mischungen davon. Ein radikalisch UV-härtbarer Pulverlack kann durch Mischen von ungesättigten Polyesterharzen mit festen Acrylamiden (z.B. Methylacrylamidoglycolatmethylester) und einem erfindungsgemässen radikalischen Photoinitiator, wie beispielsweise im Vortrag "Radiation Curing of Powder Coating", Conference Proceedings, Radtech Europe 1993 von M. Wittig und Th. Gohmann beschrieben, formuliert werden. Ebenso können radikalisch UV-härtbare Pulverlacke durch Mischen von ungesättigten Polyesterharzen mit festen Acrylaten, Methacrylaten oder Vinylethern und einem erfindungsgemässen Photoinitiator (bzw. Photoinitiatorgemisch) formuliert werden. Die Pulverlacke können auch Bindemittel enthalten, wie sie z.B. in der DE-A-42 28 514 und der EP-A-636 669 beschrieben sind. Die UV-härtbaren Pulverlacke können auch weisse oder farbige Pigmente enthalten. So kann z.B. vorzugsweise Rutil-Titaniumdioxid bis zu Konzentrationen von 50 Gew.-% eingesetzt werden, um einen gehärteten Pulverlack mit gutem Abdeckungsvermögen zu erhalten. Das Verfahren beinhaltet normalerweise elektrostatisches oder tribostatisches Aufsprühen des Pulvers auf das Substrat, wie z.B. Metall oder Holz, Aufschmelzen des Pulvers durch Erwärmen und, nachdem ein glatter Film entstanden ist, Strahlenhärten des Überzugs mit ultraviolettem und/oder sichtbaren Licht, z.B. mit Quecksilbermitteldrucklampen, Metallhalogenidlampen oder Xenonlampen. Ein besonderer Vorteil der strahlenhärtbaren Pulverlacke im Vergleich zu den entsprechenden thermisch härtbaren liegt darin, dass die Fliesszeit nach dem Aufschmelzen der Pulverpartikel wahlweise hinausgezögert werden kann, um die Bildung eines glatten hochglänzenden Überzugs zu gewährleisten. Im Gegensatz zu thermisch härtbaren Systemen können strahlenhärtbare Pulverlacke ohne den unerwünschten Effekt der Lebensdauerverkürzung so formuliert werden, dass sie bei niedrigeren Temperaturen schmelzen. Aus diesem Grund sind sie auch geeignet als Überzüge für wärmeempfindliche Substrate, wie z.B. Holz oder Kunststoffe.

Die Pulverlackformulierungen können neben den erfindungsgemässen Photoinitiatoren auch UV-Absorber enthalten. Entsprechende Beispiele sind vorstehend unter den Punkten 1.-8. aufgeführt.

Die erfindungsgemässen photohärtbaren Zusammensetzungen eignen sich z.B. als Beschichtungsstoffe für Substrate aller Art, z.B. Holz, Textilien, Papier, Keramik, Glas, Kunststoffe wie Polyester, Polyethylenterephthalat, Polyolefine oder Celluloseacetat, insbesondere in Form von Filmen, sowie Metalle wie Al, Cu, Ni, Fe, Zn, Mg oder Co und GaAs, Si oder $SiO_2$, auf denen eine Schutzschicht oder durch bildmässiges Belichten eine Abbildung aufgebracht werden soll.

Die Beschichtung der Substrate kann erfolgen, indem man eine flüssige Zusammensetzung, eine Lösung oder Suspension auf das Substrat aufbringt. Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder entfernt werden können. Geeignete Lösungsmittel sind z.B. Ketone, Ether und Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester und 3-Ethoxy-propionsäureethylester. Die Lösung wird mittels bekannter Beschichtungsverfahren gleichförmig auf ein Substrat aufgebrächt, z.B. durch Schleudern, Tauchen, Rakelbeschichtung, Vorhanggiessverfahren, Aufpinseln, Sprühen, speziell durch elektrostatisches Sprühen und Reverse-Roll-Beschichtung, sowie durch elektrophoretische Abscheidung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Der Schichtdickenbereich umfasst im allgemeinen Werte von ca 0,1 µm bis mehr als 100 µm.

Die erfindungsgemässen strahlungsempfindlichen Zusammensetzungen finden Anwendung als Negativresists, die eine sehr hohe Lichtempfindlichkeit aufweisen und schwellungsfrei in wässrig-alkalischem Medium entwickelt werden können. Sie eignen sich als Photoresists für die Elektronik (Galvanoresist, Aetzresist, Lötstopresist), die Herstellung von Druckplatten, wie Offsetdruckplatten, Flexo- und Hochdruckplatten oder Siebdruckformen, die Herstellung von Stempeln, den Einsatz beim Formteilätzen oder den Einsatz als Mikroresist bei der Herstellung integrierter Schaltkreise. Dementsprechend unterschiedlich sind die möglichen Schichtträger und die Verarbeitungsbedingungen der beschichteten Substrate.

Die erfindungsgemässen Verbindungen und Zusammensetzungen finden auch Verwendung zur Herstellung ein- oder mehrschichtiger Materialien zur Bildaufzeichnung oder Bildvervielfachung (Kopien, Reprographie), die ein- oder mehrfarbig sein können. Weiterhin sind diese Materialien auch in Farbprüfsystemen einsetzbar. Bei dieser Technologie können auch Formulierungen angewendet werden, welche Mikrokapseln enthalten, und zur Bilderzeugung kann dem Belichtungsschritt ein thermischer Schritt nachgeschaltet werden. Derartige Systeme und Technologien und ihre Anwendung sind z.B. in US 5,376,459 beschrieben.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 µm bis 10 µm, für gedruckte Schaltungen 1 µm bis ca. 100 µm.

Nach dem Beschichten der Substrate wird das Lösungsmittel in der Regel durch Trocknen entfernt, und es resultiert eine Schicht des Photoresists auf dem Träger.

Der Begriff "bildmässige" Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteteten Substrates bewegt wird und auf diese Weise ein Bild erzeugt, sowie die Bestrahlung mit computergesteuerten Elektronenstrahlen.

Nach der bildmässigen Belichtung des Materials und vor der Entwicklung kann es vorteilhaft sein, für kürzere Zeit ein thermische Behandlung durchzuführen. Dabei werden nur die belichteten Teile thermisch gehärtet. Die angewandten Temperaturen liegen im allgemeinen bei 50-150 °C, bevorzugt bei 80-130 °C; die Zeit für die thermische Behandlung liegt in der Regel zwischen 0,25 und 10 Minuten.

Die photohärtbare Zusammensetzung kann weiterhin in einem Verfahren zur Herstellung von Druckformen oder Photoresists wie es z.B. in der DE-A-40 13 358 beschrieben wird verwendet werden. Darin wird die Zusammensetzung vor, zugleich mit oder nach der bildmäßigen Bestrahlung kurzzeitig mit sichtbarem Licht einer Wellenlänge von mindestens 400 nm ohne Maske belichtet.

Nach der Belichtung und gegebenenfalls thermischen Behandlung werden die unbelichteten Stellen des Photolacks in an sich bekannter Weise mit einem Entwickler entfernt.

Die erfindungsgemässen Zusammensetzungen sind -wie schon erwähnt- wässrig-alkalisch entwickelbar. Geeignete wässrig-alkalische Entwicklerlösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwicklerflüssigkeiten in kleinen Mengen zugesetzt werden können, sind beispielsweise Cyclohexanon, 2-Ethoxyethanol, Toluol, Aceton sowie Mischungen solcher Lösungsmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Farben von Bedeutung.

Gut geeignet sind die erfindungsgemässen Gemische -wie oben bereits erwähnt- auch zur Herstellung von Druckplatten. Hierbei werden z. B. Gemische von löslichen linearen Polyamiden oder Styrol/Butadien bzw. Styrol/Isopren Kautschuk, Polyacrylaten oder Polymethylmethacrylaten mit Carboxyl-Gruppen, Polyvinylalkoholen oder Urethanacrylaten mit photopolymerisierbaren Monomeren, beispielsweise Acryl- bzw. Methacrylamiden oder Acryl- bzw. Methacrylestern, und einem Photoinitiator verwendet. Filme und Platten aus diesen Systemen (nass oder trocken) werden über das Negativ (oder Positiv) der Druckvorlage belichtet und die ungehärteten Teile anschliessend mit einem geeigneten Lösemittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung auf Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplattenhüllen oder Buchumschlägen.

Ebenfalls interessant ist die Verwendung der erfindungsgemässen Verbindungen zur Härtung von Formteilen aus Verbundmassen. Die Verbundmasse besteht aus einem selbsttragenden Matrixmaterial, z.B. einem Glasfasergewebe, oder auch beispielsweise Pflanzenfasern [vgl. K.-P. Mieck, T. Reussmann in Kunststoffe 85 (1995), 366-370], das mit der lichthärtenden Formulierung durchtränkt wird. Mit den erfindungsgemässen Verbindungen hergestellte Formteile aus Verbundmassen erreichen eine hohe mechanische Stabilität und Wider-standsfähigkeit. Die erfindungsgemässen Verbindungen sind auch als Photohärter in Form-, Tränk- und Überzugsmassen, wie sie beispielsweise in der EP-A-7086 beschrieben sind, einsetzbar. Solche Massen sind beispielsweise Feinschichtharze, an die hohe Anforderungen bezüglich der Härtungsaktivität und Vergilbungsresistenz gestellt werden, faserverstärkte Formstoffe, wie z.B. plane, längs - oder quergewellte Lichtplatten. Verfahren zur Herstellung von solchen Formstoffen, wie z.B. Handauflegeverfahren, Faserspritz-, Schleuder- oder Wickelverfahren, sind z.B. von P.H. Selden in "Glasfaserverstärkte Kunststoffe", Seite 610, Springer Verlag Berlin-Heidelberg-New York 1967, beschrieben. Gebrauchsgegenstände, die beispielsweise nach diesen Verfahren hergestellt werden können sind Boote, beidseitig mit glasfaserverstärktem Kunststoff beschichtete Span- oder Tischlerplatten, Rohre, Behälter usw. Weitere Beispiele für Form-, Tränk- und Überzugs-massen sind UP-Harz-Feinschichten für glasfaserhaltige Formstoffe (GFK), z.B. Wellplatten und Papierlaminate. Papierlaminate können auf Harnstoff- oder Melaminharzen basieren. Die Feinschicht wird vor der Laminatherstellung auf einem Träger (z.B. einer Folie) erzeugt. Die erfindungsgemässen photohärtbaren Zusammensetzungen können auch für Giessharze oder zur Einbettung von Gegenständen, z.B. von Elektronikteilen usw., verwendet werden. Darüberhinaus können sie auch zur Auskleidung von Hohlräumen und Rohren eingesetzt werden. Zur Härtung werden Quecksilbermitteldrucklampen verwendet, wie sie in der UV-Härtung üblich sind. Von besonderem Interesse sind aber auch weniger intensive Lampen, z.B. vom Typ TL 40W/03 oder TL40W/05. Die Intensität dieser Lampen entspricht etwa dem Sonnenlicht. Es kann auch direktes Sonnenlicht zur Härtung eingesetzt werden. Ein weiterer Vorteil ist, dass die Verbundmasse in einem angehärteten, plastischen Zustand von der Lichtquelle entfernt und verformt werden kann. Danach erfolgt die vollständige Aushärtung.

Die erfindungsgemässen Verbindungen und Zusammensetzungen können auch zur Herstellung von Lichtwellenleitern und optischen Schaltern eingesetzt werden, wobei die Erzeugung eines Unterschiedes im Brechungsindex zwischen belichteten und unbelichteten Bereichen ausgenutzt wird.

Wichtig ist auch die Verwendung von photohärtbaren Zusammensetzungen für Abbildungsverfahren und zur optischen Herstellung von Informationsträgern. Hierbei wird -wie oben bereits beschrieben- die auf dem Träger aufgebrachte Schicht (nass oder trocken) durch eine Photomaske mit UV oder sichtbarem Licht bestrahlt und die unbelichteten Stellen der Schicht durch Behandlung mit einem Lösemittel (= Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte elektronische Schaltungen und Photoresists herstellen.

Die Lichtempfindlichkeit der erfindungsgemässen Zusammensetzungen reicht in der Regel von ca. 200 nm über das UV-Gebiet bis in den Infrarotbereich (ca. 20000 nm, insbesondere 1200 nm) und umspannt somit einen sehr breiten Bereich. Geeignete Strahlung enthält z.B. Sonnenlicht oder Licht, aus künstlichen Lichtquellen. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilber-mitteldruck-, -hochdruck- und -niederdruckstrahler, gegebenenfalls mit Metall-Halogeniden dotiert (Metall-Halogenlampen), mikrowellenangeregte Metalldampflampen, Excimer Lampen, superaktinische Leuchtstoffröhren, Fluoreszenzlampen, Argonglühlampen, Elektronenblitzlampen, photographische Flutlichtlampen, Elektronenstrahlen und Röntgenstrahlen, erzeugt mittels Synchrotronen oder Laser-Plasma. Der Abstand zwischen Lampe und erfindungsgemässem zu belichtendem Substrat kann je nach Anwendungszweck und Lampentyp bzw. -stärke variieren, z.B. zwischen 2 cm bis 150 cm. Speziell geeignet sind Laserlichtquellen, z.B. Excimer-Laser. Auch Laser im sichtbaren Bereich oder im IR-Bereich können eingesetzt werden. Hier ist die hohe Empfindlichkeit der erfindungsgemässen Materialien und die Möglichkeit der Anpassung des Farbstoffes an die Laserlinie sehr vorteilhaft. Nach dieser

Methode können gedruckte Schaltungen in der Elektronikindustrie, lithographische Offsetdruckplatten oder Reliefdruck-platten sowie photo-graphische Bildaufzeichnungsmaterialien hergestellt werden.

Erfindungsgegenstand ist auch die Verwendung der oben beschriebenen Zusammensetzung zur Herstellung von pigmentierten und nichtpigmentierten Lacken, Druckfarben, Pulverlacken, Druckplatten, Klebern, Dentalmassen, Lichtwellenlietern, optischen Schaltern, Farbprüfsystemen, Verbundmassen, Glasfaserkabelbe-schichtungen, Siebdruckschablonen, Resistmaterialien, die Verwendung zur Verkapselung elektrischer und elektronischer Bauteile, zur Herstellung von magnetischen Aufzeichnungs-materialien, zu Herstellung von dreidimensionalen Objekten mittels Stereolithographie, für photographische Reproduktionen, sowie die Verwendung als Bildaufzeichnungsmaterial, insbesondere für holographische Aufzeichnungen.

Ebenfalls Gegenstand der Erfindung ist ein beschichtetes Substrat, das auf mindestens einer Oberfläche mit einer wie oben beschriebenen Zusammensetzung beschichtet ist, sowie ein Verfahren zur photographischen Herstellung von Reliefabbildungen, in welchem ein beschichtetes Substrat bildmässig belichtet wird und danach die unbelichteten Anteile mit einem Lösemittel entfernt werden. Insebsondere interessant ist dabei die -oben schon erwähnte-Belichtung mittels eines Laserstrahls.

Gegenstand der Erfindung ist auch ein Verfahren zur Photopolymerisation von nichtflüchtigen monomeren, oligomeren oder polymeren Verbindungen mit mindestens einer ethylenisch ungesättigten Doppelbindung, dadurch gekennzeichnet, dass man zu den oben genannten Verbindungen mindestens eine Verbindung der Formel I zugibt und mit

Licht der Wellenlänge von 200 nm bis einschliesslich in den Infrarotbereich bestrahlt. Die erfindungsgemässen Boratverbindungen sind nicht nur als Initiatoren für Photopolymerisationsreaktionen einsetzbar, sondern sind ebenfalls als thermische Polymerisationsinitiatoren zu verwenden.

Gegenstand der Erfindung ist daher auch die Verwendung der Verbindungen der Formel I als Initiator für die thermische Polymerisation von Verbindungen mit ethylenisch ungesättigten Doppelbindungen, sowie ein Verfahren zur thermischen Polymerisation von Verbindungen mit ethylenisch ungesättigten Doppelbindungen, dadurch gekennzeichnet, dass als Polymerisationsinitiator mindestens eine Verbindung der Formel I eingesetzt wird.

**I. Herstellung der Borane**

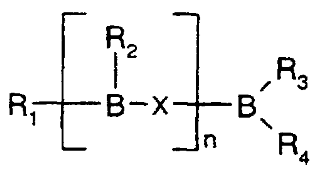

<u>Beispiel 1:</u> 1,4-Bis(dimesitylboryl)benzol

$R_1$-$R_4$ = Mesityl, n = 1; X = 1,4-Phenylen

*Methode A:*

Zu einer Lösung von 2,36 g (0,01 mol) 1,4-Dibrombenzol in 10 ml Diethylether wird bei -78°C ein Äquivalent Butyllithium (0,01 mol) in Hexan während 15 Minuten gegeben. Während einer Stunde wird die Temperatur langsam auf -50°C steigen lassen und danach wieder auf -78°C abgekühlt. Dann werden 2,68 g (0.01 mol) festes Dimesitylfluoroboran zugegeben, die Reaktionsmischung auf Raumtemperatur erwärmen lassen, und es wird während einer Stunde gerührt. Die Mischung wird in 50 ml Wasser gegossen und filtriert. Es werden 3,1 g eines beigefarbenen Feststoffes erhalten. Das Produkt wird durch Waschen mit siedendem Acetonitril gereinigt. Es werden 2,1 g (52 % d. Theorie) 1-Brom-4-dimesitylborylbenzol erhalten. Eine Lösung dieses Borans in 20 ml Tetrahydrofuran (THF) wird auf -78°C abgekühlt und mit 1 Äquivalent (0,05 mol) Butyllithium in Hexan behandelt. Die rote Lösung wird während 30 Minuten auf -50°C erwärmen lassen und danach wieder auf -78°C abgekühlt. Danach werden 1,34 g (0,005 mol) festes Dimesitylfluoroboran zugegeben, die Reaktionsmischung wird auf Raumtemperatur erwärmen lassen und während einer Stunde gerührt.

Die Mischung wird in 50 ml Wasser gegossen und filtriert. Es wird ein weisser Feststoff erhalten. Das Produkt wird durch Waschen mit siedendem Acetonitril gereinigt. Es werden 2,23 g (78 % d. Theorie) des reinen Bisborans erhalten.

Physikalische Daten sind der Tabelle 1 zu entnehmen.

*Methode B:*

Zu einer Lösung von 2,36 g (0,01 mol) 1,4-Dibrombenzol in 20 ml THF wird während 15 Minuten bei -78°C ein Äquivalent (0,01 mol) Butyllithium in Hexan gegeben. Die Suspension wird während 30 Minuten langsam auf -50°C erwärmen lassen, danach wieder auf -78°C abgekühlt und mit 2,68 g (0,01 mol) festem Dimesitylfluoroboran behandelt. Die Reaktionsmischung wird auf Raumtemperatur erwärmen lassen und eine halbe Stunde gerührt. Die Mischung wird auf -78°C abgekühlt und wie oben bei Methode A beschrieben nacheinander mit Butyllithium und Dimesitylfluorboran behandelt. Nach dem Erwärmen auf Raumtemperatur wird die Mischung in 100 ml Wasser gegossen, filtriert und mit siedendem Acetonitril gewaschen. Es werden 4,88 g (85% d. Theorie) des Produktes erhalten.

*Methode C:*

Zu einer Lösung von 11,8 g (0,05 mol) 1,4-Dibrombenzol in 200 ml Hexan werden bei Raumtemperatur 2 Äquivalente Butyllithium (0,1 mol) in Hexan gegeben. Die Mischung wird 3 Stunden am Rückfluss erhitzt. Die entstehende Suspension wird auf -78°C abgekühlt und mit 26,8 g (0,1 mol) festem Dimesitylfluoroboran behandelt. Nach dem Erwärmen auf Raumtemperatur wird die Reaktionsmischung in 200 ml Wasser gegossen und zweimal mit 50 ml Hexan extrahiert. Die vereinigten organischen Phasen werden mit Magnesiumsulfat getrocknet, filtriert und eingeengt. Es resultiert ein gelber Feststoff. Nach dem Umkristallisieren aus Hexan werden 17,0 g (d.h. 59% d. Theorie) 1,4-Bis (dimesitylboryl)benzol erhalten.

*Methode D:*

Zu einer Lösung von 8 g (0,04 mol) Brommesitylen in 100 ml Hexan werden bei 0°C 2 Äquivalente (0,08 mol) t-Butyllithium in Pentan während einer Stunde gegeben. Die Mischung wird 3 Stunden am Rückfluss erhitzt. Nach dem Abkühlen auf 0°C wird eine Lösung von 4,17 g (0,01 mol) 1,4-Bis(dibromoboryl)benzol in 80 ml Hexan zur Mischung gegeben und über Nacht am Rückfluss erhitzt. Die entstehende dicke Suspension wird in 200 ml Wasser gegossen und zweimal mit 50 ml Hexan extrahiert. Die vereinigten organischen Phasen werden über Magnesiumsulfat getrocknet, filtriert und eingeengt. Es bildet sich ein gelber Feststoff, der in Hexan umkristallisiert wird. Es resultieren 3,0 g (52% d. Theorie) 1,4-Bis(dimesitylboryl)benzol.

*Methode E:*

1,4-Bis(dimesitylboryl)benzol kann auch nach der von A. Schultz und W. Kaim in Chem. Ber. 1989, 122, 1863-1868, beschriebenen Methode durch Reaktion von einem Äquivalent 1,4-Bis(bromomagnesio)benzol mit 2 Äquivalenten Dimesitylfluorboran unter Rückfluss in THF in einer Ausbeute von 6% d. Theorie erhalten werden.

<u>Beispiel 2:</u> 1-Dimesitylboryl-4-diphenylborylbenzol

$R_1$,$R_2$ = Mesityl; $R_3$,$R_4$ = Phenyl; n = 1; X = 1,4-Phenylen

Die Verbindung wird nach der oben beschriebenen Methode B hergestellt, indem 1 Äquivalent Dimesitylfluorboran und 1 Äquivalent Diphenylisopropoxyboran eingesetzt werden. Das Rohprodukt wird erhalten, indem die Reaktionsmischung im Hochvakuum eingeengt wird und der feste Rückstand unter Argon mit Hexan behandelt wird. Filtration, Einengen des Filtrats und Umkristallisation aus Acetonitril liefert 3,0 g (61% d. Theorie) des luftempfindlichen, schwach gelben Titelproduktes. Physikalische Daten sind der Tabelle 1 zu entnehmen.

<u>Beispiel 3:</u> 1-Bis(chloromesityl)boryl-4-dimesitylborylbenzol

$R_1$,$R_2$ = Mesityl; $R_3$,$R_4$ = Chlormesityl; n = 1; X = 1,4-Phenylen

Die Verbindung wird nach der oben beschriebenen Methode B hergestellt, indem 1 Äquivalent Bis(chloromesityl)fluoroboran und 1 Äquivalent Dimesitylfluoroboran eingesetzt werden. Physikalische Daten sind der Tabelle 1 zu entnehmen.

Beispiel 4: 1,4-Bis[bis(chloromesityl)boryl]benzol

$R_1$-$R_4$ = Chloromesityl; n = 1; X = 1,4-Phenylen

Die Verbindung wird nach der oben beschriebenen Methode B hergestellt, indem 2 Äquivalente Bis(chloromesityl)fluoroboran eingesetzt werden. Physikalische Daten sind der Tabelle 1 zu entnehmen.

Beispiel 5: 1,3-Bis(dimesitylboryl)benzol

$R_1$-$R_4$ = Mesityl; n = 1; X = 1,3-Phenylen

Die Verbindung wird nach der oben beschriebenen Methode B hergestellt und in 83% Ausbeute erhalten. Physikalische Daten sind der Tabelle 1 zu entnehmen.

Beispiel 6: 1-Fluoro-3,5-bis(dimesitylboryl)benzol

$R_1$-$R_4$ = Mesityl; n = 1; X = 5-Fluoro-1,3-phenylen

Die Verbindung wird nach der oben beschriebenen Methode C in Diethylether bei -50°C hergestellt und in einer Ausbeute von 61% erhalten. Physikalische Daten sind der Tabelle 1 zu entnehmen.

Beispiel 7: 1 -Bis(chloromesityl)boryl-3-dimesitylborylbenzol

$R_1$,$R_2$ = Mesityl; $R_3$,$R_4$ = Chloromesityl; n = 1; X = 1,3-Phenylen

Die Verbindung wird nach der oben beschriebenen Methode B in einer Ausbeute von 86% hergestellt, indem 1 Äquivalent Bis(chloromesityl)fluoroboran und 1 Äquivalent Dimesitylfluoroboran eingesetzt werden. Physikalische Daten sind der Tabelle 1 zu entnehmen.

Beispiel 8: 4,4'-Bis(dimesitylboryl)biphenyl

$R_1$-$R_4$= Mesityl; n = 1; X = 4,4'-Biphenylen

Die Verbindung wird nach der oben beschriebenen Methode C in Diethylether bei 0°C in einer Ausbeute von 70% erhalten. Physikalische Daten sind der Tabelle 1 zu entnehmen.

Beispiel 9: 4-Bis(chloromesityl)boryl-4'-dimesitylborylbiphenyl

$R_1$, $R_2$ = Mesityl; $R_3$,$R_4$ = Chloromesityl; n= 1; X = 4,4'-Biphenylen

Die Verbindung wird nach der oben beschriebenen Methode B in einer Ausbeute von 71% erhalten, indem 1Äquivalent Bis(chloromesityl)fluoroboran und 1 Äquivalent Dimesitylfluoroboran eingesetzt werden. Physikalische Daten sind der Tabelle 1 zu entnehmen.

Beispiel 10: 4,4'-Bis(dimesitylboryl)benzophenon-ethylen-ketal

$R_1$-$R_4$ = Mesityl; n = 1; X =

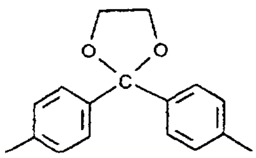

Die Verbindung wird nach der oben beschriebenen Methode C in Diethylether bei 0°C hergestellt. Physikalische Daten sind der Tabelle 1 zu entnehmen.

Beispiel 11: 4,4'-Bis(dimesitylboryl)benzophenon

$R_1$-$R_4$ = Mesityl; n = 1; X =

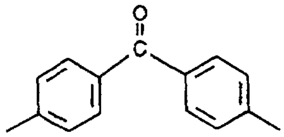

Die Verbindung wird durch Hydrolyse der Verbindung aus Beispiel 10 in einer Mischung von Ethanol, Wasser und konzentrierter Salzsäure in einer Ausbeute von 64% erhalten. Physikalische Daten sind der Tabelle 1 zu entnehmen.

Beispiel 12: 4,4"-Bis(dimesitylboryl)-p-terphenyl

$R_1$-$R_4$ = Mesityl; n = 1; X = 4,4"-p-Terphenylen

Die Verbindung wird nach der oben beschriebenen Methode B unter Verwendung der entprechenden Edukte in einer Ausbeute von 73% erhalten. Physikalische Daten sind der Tabelle 1 zu entnehmen.

Beispiel 13: 4,4"-Bis[bis(chloromesityl)boryl]-p-terphenyl

$R_1$-$R_4$ = Chloromesityl, N = 1; X = 4,4"-p-Terphenylen

Die Verbindung wird nach der oben beschriebenen Methode B in einer Ausbeute von 51% erhalten, indem 2 Äquivalente Bis(chloromesityl)fluoroboran eingesetzt werden. Physikalische Daten sind der Tabelle 1 zu entnehmen.

Beispiel 14: 4,4"-Bis(dimesitylboryl)-o-terphenyl

$R_1$-$R_4$ = Mesityl; n = 1; X = 4,4"-o-Terphenylen

Die Verbindung wird nach der oben beschriebenen Methode B unter Verwendung der entprechenden Edukte in einer Ausbeute von 43% erhalten. Physikalische Daten sind der Tabelle 1 zu entnehmen.

Beispiel 15: 1,5-Bis(dimesitylboryl)naphthalen

$R_1$-$R_4$ = Mesityl; n = 1; X = 1,5-Naphthylen

Die Verbindung wird nach der oben beschriebenen Methode C in Diethylether bei -78°C unter Verwendung der entprechenden Edukte in einer Ausbeute von 86% erhalten. Physikalische Daten sind der Tabelle 1 zu entnehmen.

Beispiel 16: 1,5-Bis[bis(chloromesityl)boryl]naphthalen

$R_1$-$R_4$ = Chloromesityl; n = 1; X = 1,5-Naphthylen

Die Verbindung wird nach der oben beschriebenen Methode C in Diethylether bei -78°C unter Verwendung der entprechenden Edukte in einer Ausbeute von 83% erhalten. Physikalische Daten sind der Tabelle 1 zu entnehmen.

Beispiel 17: 1,7-Bis(dimesitylboryl)naphthalen

$R_1$-$R_4$ = Mesityl; n = 1; X = 1,7-Naphthylen

Die Verbindung wird nach der oben beschriebenen Methode C in Diethylether bei 0°C unter Verwendung der entprechenden Edukte in einer Ausbeute von 37% erhalten. Physikalische Daten sind der Tabelle 1 zu entnehmen.

Beispiel 18: 9-Dimesitylboryl-1 0-di(2-methylphenyl)borylanthracen

$R_1$,$R_2$ = Mesityl; $R_3$,$R_4$ = o-Tolyl; n = 1; X = 9,10-Anthracylen

Die Verbindung wird nach der oben beschriebenen Methode A über 9-Bromo-10-dimesitylborylanthracen hergestellt. Der Brom-Lithium-Austausch und anschliessende Behandlung mit Ditolylbromoboran ergibt das gewünschte Produkt in einer Ausbeute von 55%. Physikalische Daten sind der Tabelle 1 zu entnehmen.

Beispiel 19: 9,10-Bis(dimesitylboryl)anthracen

$R_1$-$R_4$ = Mesityl; n = 1; X = 9,10-Anthracylen

Die Verbindung wird nach der oben beschriebenen Methode C in Diethylether bei 0°C unter Verwendung der entprechenden Edukte in einer Ausbeute von 45% erhalten. Physikalische Daten sind der Tabelle 1 zu entnehmen.

Beispiel 20: Polymesitylphenylboran

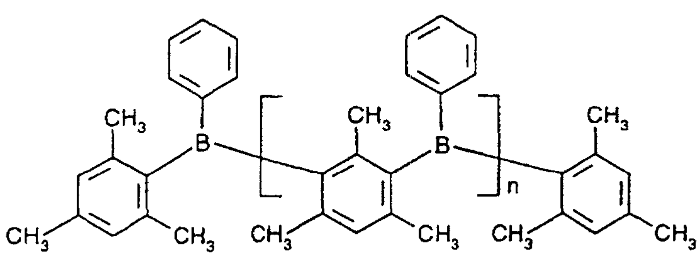

n = 2-12

Zu einer Lösung von 1,86 g (0,005 mol) Diiodomesitylen in THF werden während einer Stunde bei -78°C 4 Äquivalente tert.-Butyllithium (0,020 mol) in Pentan gegeben.Die Suspension wird bei -78°C während 3 Stunden gerührt und dann mit 0,57 g (0,0045 mol) Phenyldifluoro-boran behandelt. Die Reaktionsmischung wird auf Raumtemperatur erwärmen lassen und während 2 Stunden gerührt. Die Mischung wird in 50 ml Wasser gegossen und zweimal mit 50 ml Ethylacetat extrahiert. Die vereinigten organischen Phasen werden über Magnesiumsulfat getrocknet, filtriert und eingeengt.Das Rohprodukt wird durch Waschen mit siedendem Acetonitril gereinigt. Es werden 0,37 g (38% d. Theorie)

eines weissen Feststoffs erhalten. GPC (Gel Permeation Chromatography) ergibt $M_n$ = 1730; $M_w$ = 1061, $M_n/M_w$ = 1,63. Weitere physikalische Daten sind der Tabelle 1 zu entnehmen.

Beispiel 21: 1,1'-Bis(dimesitylboryl)ferrocen

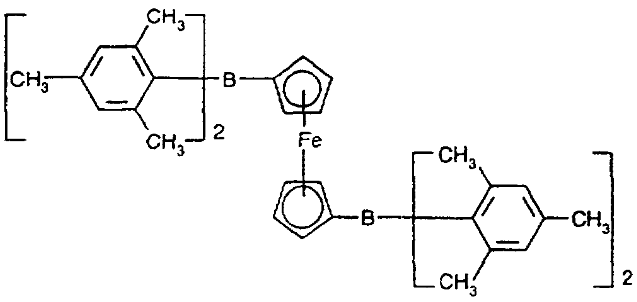

Die Verbindung wird nach der oben beschriebenen Methode D unter Verwendung der entsprechenden Edukte in einer Ausbeute von 10% erhalten.

Beispiel 22: 1,4-Bis[bis(dinitromesityl)boryl]benzol

$R_1$-$R_4$ = Dinitromesityl; n = 1; X = 1,4-Phenylen

Zu einer Mischung von 13,9 ml (25,5 g, 0,26 mol) konzentrierter Schwefelsäure und 24,9 ml (37,8 g, 0,6 mol) Salpetersäure werden bei -78°C 2,87 g (0,005 mol) 1,4-Bis(dimesitylboryl)-benzol (=Verbindung aus Beispiel 1) während 25 Minuten in Portionen zugegeben. Die Mischung wird während 30 Minuten auf -40°C erwärmen lassen, Danach wird vorsichtig solange Wasser zugegeben, bis die Reaktion nicht mehr exotherm verläuft. Der ausgefallene Feststoff wird filtriert, mit Wasser gewaschen und getrocknet. Nach dem Umkristallisieren aus Essigsäureethylester werden 0,55 g (0,0006 mol, d.h. 13 % der Theorie) eines weissen Feststoffes erhalten. Physikalische Daten sind der Tabelle 1 zu entnehmen.

Beispiel 23: 1,7-Bis[bis(chloromesityl)boryl]naphthyl

$R_1$-$R_4$ = Chloromesityl; n = 1; X = 1,7-Naphthylen

Die Verbindung wird analog zu der oben beschriebenen Methode B hergestellt und in 57 % Ausbeute erhalten. Physikalische Daten sind der Tabelle 1 zu entnehmen.

Beispiel 24: 1,4-Bis[bis(dichloromesityl)boryl]benzol

$R_1$-$R_4$ = Dichloromesityl; n = 1; X = 1,4-Phenylen

Die Verbindung wird analog zu der oben beschriebenen Methode B mit Bis(dichloromesityl)fluoroboran hergestellt und in 13 % Ausbeute erhalten. Physikalische Daten sind der Tabelle 1 zu entnehmen.

Beispiel 25: 1,6- und 1,8-Bis(dimesityl-boryl)-pyren (Gemisch aus der 1,6- und 1,8-Verbindung)

$R_1$-$R_4$ = Mesityl; n = 1; X = 1,6- und 1,8-Pyrenyl

Die Verbindung wird analog zu der oben beschriebenen Methode C in THF bei -78°C hergestellt und in 74 % Ausbeute erhalten. Physikalische Daten sind der Tabelle 1 zu entnehmen.

Beispiel 26: 1,6- und 1,8-Bis[bis(chloromesityl)boryl]pyren (Gemisch aus der 1,6- uns 1,8-Verbindung)

$R_1$-$R_4$ = Chloromesityl; n = 1; X = 1,6- und 1,8-Pyrenyl

Die Verbindung wird analog zu der oben beschriebenen Methode C in THF bei -78°C hergestellt und in 56 % Ausbeute erhalten. Physikalische Daten sind der Tabelle 1 zu entnehmen.

Beispiel 27: Poly(4-butylphenyl)durylboran

$R_1$, $R_3$ = 4-Butylphenyl; $R_2$, $R_4$ = Duryl; n = 2-22, X = 1,4-Duren

Die Verbindung wird analog zu der für Verbindung 20 beschriebenen Methode unter Verwendung von Diiododuren und Kalium-p-tert-butylphenyltrifluoroborat hergestellt und in 33% Ausbeute erhalten. Physikalische Daten sind in der Tabelle 1 angegeben.

Beispiel 28:

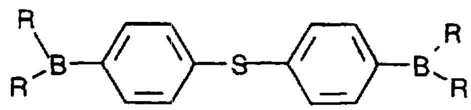

R = Mesityl

Die Verbindung wird nach der oben beschriebenen Methode C mit 4 Äquivalenten t-Butyllithium in THF bei -78°C hergestellt und in einer Ausbeute von 77% erhalten. Physikalische Daten sind in der Tabelle 1 angegeben.

Beispiel 29: 3,5-Bis(dimesitylboryl)-1-trimethylsilyl-benzol

$R_1$-$R_4$ = Mesityl; n = 1; X = 1-trimethylsilyl-phen-3-yl-5-yl

a) 1-Brom-3,5-bis(dimesitylboryl)benzol

Zu einer Suspension von 3,14 g (0,01 mol) 1,3,5-Tribrombenzol in 50 ml Diethylether werden bei -78°C 6,25 ml (0,01 mol) 1,6M Butyllithium in Hexan während 5 Minuten gegeben. Die Reaktionsmischung wird während 2 Stunden bei -78°C gerührt, wobei eine gelb-orange Suspension entsteht. 2,68 g (0,01 mol) festes Dimesitylfluoroboran werden zugegeben, und die Reaktionsmischung wird während ca. einer Stunde bis auf Raumtemperatur erwärmen lassen. Die Mischung wird dann mit 50 ml Hexan verdünnt und auf 0°C abgekühlt. Der entstehende Feststoff wird filtriert, mehrere Male mit kaltem Hexan gewaschen, danach mit Wasser und schliesslich mit Methanol solange gewaschen, bis der Feststoff farblos ist. Nach dem Trocknen werden 3,54 g (0,0073 mol; d.h. 73% d. Theorie) eines weissen Feststoffes erhalten (1,3-Dibromo-5-dimesitylboryl-benzol). Nach der Reinigung durch Chromatographie (Hexan; $SiO_2$) wird ein Schmelzpunkt von 190-191 °C erhalten.

Die Elementaranalyse für $C_{24}H_{25}BBr_2$ ergibt:

C ber.: 59,55%; gef.: 59,52%
H ber.: 5,21%; gef.: 5,12%

Zur Herstellung von 1-Brom-3,5-bis(dimesitylboryl)benzol wird 1,3-Dibromo-5-dimesitylborylbenzol erneut nach der oben beschriebenen Methode mit Butyllithium und Dimesitylfluoroboran umgesetzt. Die Ausbeute an 1-Brom-3,5-bis(dimesitylboryl)benzol beträgt 76% d. Theorie. (Physikalische Daten vgl. Beispiel 32)

b) 3,5-Bis(dimesitylboryl)-1-trimethylsilyl-benzol

Zu einer Lösung von 6,53 g (0,01 mol) 1-Brom-3,5-bis(dimesitylboryl)benzol in 50 ml THF werden bei -78°C 6,25 ml (0,01 mol) einer 1,6M Lösung von Butyllithium in Hexan gegeben. Es wird 1,5 h bei -78°C gerührt. Danach werden 2,0 ml (3,0 g; 0,015 mol) Trimethylsilyliodid während 10 Minuten zugegeben. Nach erneutem einstündigem

Rühren bei -78°C wird die Mischung auf Raumtemperatur erwärmen lassen und ca. 12 Stunden gerührt. Die Mischung wird dann mit Wasser verdünnt und zweimal mit je 50 ml Essigsäureethylester extrahiert. Trocknen mit Magnesiumsulfat und Einengen ergibt 7,15 g eines viskosen Öls. Nach der Reinigung mittels Chromatographie (Hexan, $SiO_2$) werden 3,7 g (0,0058 mol, d.h. 58% d. Theorie) der Titelverbindung als weisser Feststoff erhalten. Physikalische Daten sind der Tabelle 1 zu entnehmen.

Beispiel 30: 3,5-Bis(dimesitylboryl)-1-diisopropylaminocarbonyl-benzol

$R_1$-$R_4$ = Mesityl; n = 1; X = 1-diisopropylaminocarbonyl-phen-3-yl-5-yl

Die Verbindung wird analog zu der in Beispiel 29 beschriebenen Methode b) hergestellt, wobei Cl(CO)N $(i\text{-}C_3H_7)_2$ als Elektrophil eingesetzt wird. Durch Umkristallisieren aus Hexan wird das Produkt in 46% Ausbeute erhalten. Physikalische Daten sind der Tabelle 1 zu entnehmen.

Beispiel 31:

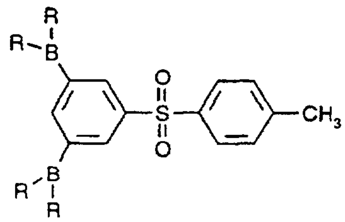

R = Mesityl

Die Verbindung wird analog zu der in Beispiel 29 beschriebenen Methode b) hergestellt, wobei

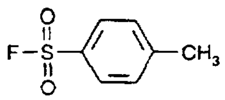

als Elektrophil eingesetzt wird. Reinigung durch Waschen in siedendem Hexan ergibt 62% Ausbeute. Physikalische Daten sind in der Tabelle 1 angegeben.

Beispiel 32: 1-Brom-3,5-bis(dimesitylboryl)benzol

$R_1$-$R_4$ = Mesityl; n = 1; X = 1-Brom-phen-3-yl-5-yl

Die Herstellung dieses Borans ist in Beispiel 29 Stufe a) beschrieben. Physikalische Daten sind in der Tabelle 1 enthalten.

Beispiel 33: 1-Brom-3,5-bis(bis(chloromesityl)boryl]benzol

$R_1$-$R_4$ = Chloromesityl; n = 1; X = 1-Brom-phen-3-yl-5-yl

Diese Verbindung wird analog zu der in Beispiel 32 beschriebenen Verbindung unter Verwendung von Bis (chloromesityl)fluoroboran als Elektrophil hergestellt.Physikalische Daten sind der Tabelle 1 zu entnehmen.

Beispiel 34: 1,3,5-Tris[bis(chloromesityl)boryl]benzol

$R_1$-$R_4$ = Chloromesityl; n = 1; X = 1-Bis(chloromesityl)boryl-phen-3-yl-5-yl

Die Verbindung wird entsprechend der Verbindung aus Beispiel 29 hergestellt, indem (Dichloromesityl)fluoroboran als Elektrophil sowohl in der Stufe a) als auch in der Stufe b) eingesetzt wird. Physikalische Daten sind der Tabelle 1 zu entnehmen.

Beispiel 35: Bis[3(dimesitylboryl)-2,4,6(trimethyl)-phenyl]-phenyl-boran

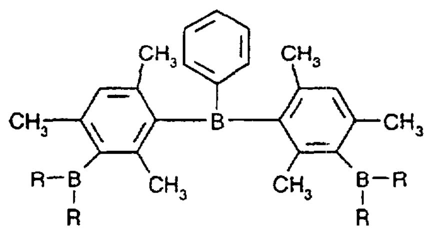

R = Mesityl

a) (1-Bromo-2,4,6-trimethylphenyl)-dimesityl-boran

Zu einer Suspension von 13,9 g (0,05 mol) Dibrommesitylen in 100 ml THF werden bei -78°C 67 ml (0,1 mol) einer 1,5M Lösung von t-Butyllithium in Pentan tropfenweise durch eine Spritze während 2,5 h gegeben.Nach weiterem 1,5 stündigem Rühren bei -78°C wird festes Dimesitylfluorboran zugegeben, die Reaktionsmischung während 2 Stunden auf Raumtemperatur erwärmen lassen und dann mit 200 ml Wasser verdünnt. Danach wird zweimal mit je 50 ml Essigsäureethylester extrahiert. Trocknen mit Magnesiumsulfat und Einengen ergibt einen beige-weissen Fest-stoff. Waschen mit siedendem Acetonitril ergibt 15,62 g (d.h. 70% d. Theorie) des gewünschten Borans. Elementaranalyse für $C_{27}H_{32}BBr$ ergibt:
C ber.: 72,51%; C gef.:72,78%; H ber.: 7,21%; H gef.: 7,30%.

b) Titelverbindung

Eine Lösung von 8,94 g (0,02 mol) der Verbindung aus Stufe a) in 50 ml THF wird bei -78°C mit 12,5 ml (0,02 mol) einer 1,6M Lösung von Butyllithium in Hexan behandelt. Nach einstündigem Rühren bei -78°C wird die rote Lösung mit 1,3 ml (1,39 g; 0,011 mol) Phenyldifluoroboran behandelt und während einer Stunde auf Raumtemperatur erwärmen lassen. Die Reaktionsmischung wird mit 100 ml Wasser verdünnt und mit Essigsäureethylester extrahiert. Trocknung über Magnesiumsulfat und Einengen ergibt einen weissen Feststoff. Nach Chromatographie (Hexan, $SiO_2$) werden 4,14 g (0,0112 mol, d.h. 56% d. Theorie) des gewünschten Produktes erhalten. Physikalische Daten sind in der Tabelle 1 wiedergegeben.

Beispiel 36: 1,4-Bis[bis(chloromesityl)boryl]naphthalin

$R_1$-$R_4$ = Chloromesityl; n = 1; X = 1,4-Naphthylen

Die Verbindung wird nach der oben beschriebenen Methode B mit Bis(chloromesityl)fluoroboran in 71% Ausbeute erhalten. Physikalische Daten sind der Tabelle 1 zu entnehmen.

Beispiel 37: 1,4-Bis(dimesitylboryl)naphthalin

$R_1$-$R_4$ = Mesityl; n = 1; X = 1,4-Naphthylen

Die Verbindung wird nach der oben beschriebenen Methode B in 71% Ausbeute erhalten. Physikalische Daten sind der Tabelle 1 zu entnehmen.

Beispiel 38: 1,4,7-Tris(dimesitylboryl)naphthalin

$R_1$-$R_4$ = Mesityl; n = 1; X = 7-Dimesitylboryl-napht-1-yl-4-yl

Die Verbindung wird entsprechend der oben beschriebenen Methode B hergestellt, jedoch mit drei aufeinanderfolgenden Zugaben von Butyllithium und Dimesitylfluoroboran. Sie wird in einer Ausbeute von 63% erhalten. Physikalische Daten sind der Tabelle 1 zu entnehmen.

Beispiel 39: 4,4'-Bis[bis(chloromesityl)boryl]-biphenyl

$R_1$-$R_4$ = Dichloromesityl; n = 1; X = 4,4'-Biphenylen

Die Verbindung wird entsprechend der oben beschriebenen Methode B mit Bis(chloromesityl)fluoroboran in einer Ausbeute von 22% erhalten. Physikalische Daten sind in der Tabelle 1 zusammengestellt.

Beispiel 40: 1,3,5-Tris(dimesitylboryl)-benzol

$R_1$-$R_4$ = Mesityl; n = 1; X = Dimesitylborylphen-3-yl-5-yl

Die Verbindung des Beispiels 40 wird analog zu der Verbindung aus Beispiel 29 hergestellt, indem dreimal mit Dimesitylfluoroboran behandelt wird. Die Ausbeute beträgt 73%. Physikalische Daten sind in der Tabelle 1 erfasst.

Tabelle 1:

| Borane | | |
|---|---|---|
| Verb. aus Bsp. | Schmelzpunkt [°C] | $^1$H-NMR in $CDCl_3$ bei 300 Hz δ [ppm] J [Hz] |
| 1 | 253-255 | 7.43 (s,4); 6.79(8); 2.28 (s,12); 1.98 (s,24) |
| 2 | * | 7.63-7.18 (m,14); 6,83 (s,4); 2.30 (s,6); 2.05 (s,12) |
| 3 | 232-233 | 7.45 (d,2,J=7.8); 7.39 (d,2,J=7.8); 6.89 (s,2); 6.80 (s,4); 2.37 (s,6); 2.29 (s, 6); 2.06 (s,6); 1.97 (s,18) |
| 4 | 248-250 | 7.40 (s,4); 6.90 (s,4); 2.37 (s,12); 2.06 (s,12); 1.97 (s,12) |
| 5 | 172-173 | 7.54 (d,2,J=7.4); 7.52 (s,1); 7.29 (t,1,J=7.4); 6.78 (s,8); 2.27 (s,12); 1.94 (s, 24) |
| 6 | 143-145 | 7.29 (s,1); 7.19 (d,2,J=9.1); 6.75 (s,8); 2.27 (s,12); 1.94 (s,24) |
| 7 | 68-70 | 7.60 (d,1,J=7.4); 7.52 (d,1,J=7.4); 7.33 (s,1); 7.31 (t,1,J=7.4); 6.83 (m,2); 6.75 (s,4); 2.35 (m,6); 2.26 (s,6); 2.05 (s,3); 2.02 (s,3); 1.96 (s,3); 1.95 (s, 12); 1.92 (s,3) |
| 8 | 254-255 | 7.64 (d,4,J=8.1); 7.58 (d,4,J=8.1); 6.83 (s,8); 2.31 (s,12); 2.03 (s,24) |
| 9 | 228-232 | 7.67-7.53 (m,8); 6.93 (s,2); 6.83 (s,4); 2.39 (s,6); 2.31 (s,6); 2.12 (s,6); 2.03 (s,12); 2.03 (s,6) |
| 10 | 234-236 | 7.46 (s,8); 6.80 (s,8); 4.07 (s,4); 2.29 (s,12); 1.96 (s,24) |
| 11 | 208-209 | 7.73 (d,4,J=7.8); 7.53 (d,4,J=7.8); 6.80(s,8); 2.30 (s,12); 2.00 (s,24) |
| 12 | >250 | 7.74 (s,4); 7.63 (d,4,J=8.2); 7.60 (d,4,J=8.2); 6.84 (s,8); 2.32 (s,12); 2.04 (s, 24) |
| 13 | 192-197 | 7.44 (s,4); 7.64 (d,4,J=8.2); 7.56 (d,4,J=8.2); 6.93 (s,4); 2.40 (s,12); 2.13 (s, 12); 2.03 (s,12) |
| 14 | 210-220 | 7.49-7.41 (m,4); 7.30 (d,4,J=11.0); 7.08 (d,4,J=11.0); 6.80 (s,8); 2.30 (s,12); 1.97 (s,24) |

* der Wert wurde nicht bestimmt

Tabelle 1: (fortgesetzt)

| Borane | | |
|---|---|---|
| Verb. aus Bsp. | Schmelzpunkt [°C] | $^{1}$H-NMR in $CDCl_3$ bei 300 Hz δ [ppm] J [Hz] |
| 15 | >250 | 7.95 (d,2,J=8.3); 7.42 (d,2,J=6.5); 7.15 (dd,2,J=8.3 und 6.5), 6,77 (br s,8) 2.29 (s,12); 1.93 (br s, 24) |
| 16 | >250 | 7.92 (br d,2,J=8.3); 7.41 (br d,2, J=6.6); 7.18 (br dd,2,J=8.3 und 6.6);6.89 (br s,2); 6.87 (br s,2); 2.37 (s,12); 2.10 (br s,12); 1.94 (br s,12) |
| 17 | 248-250 | 8.00 (s,1); 7.88 (m,1); 7.75 (d,1,J=8.2); 7.49-7.41 (m,3); 6.74 (s,4); 6.62 (br s,4); 2.31 (s,6); 2.25 (s,6); 1.80 (s,12); 1.76 (br s,12) |
| 18 | 247-250 | 8.06 (m,2); 7.67 (m,2); 7.41-7.25 (m,4); 7.18-7.10 (m,8); 6.86 (br s,2); 6.66 (br s,2); 2.27 (s,6); 2.17 (br s,6); 2.08 (s,6); 1,67 (br s,6) |
| 19 | 259-260 | 7.97 (m,4); 7.02 (m,4); 6.74 (br s,8); 2.19 (s,12); 2.08 (br s, 12); 1.63 (br s, 12) |
| 20 | 184-185 | 7.51-7.24 (m,5); 6.80 (m,1); 2.00 (br s, 6); 1.83 (br s,3) |
| 21 | >250 | 6.75 (s,8); 4.74 (br s,4); 4.42 (br s,4); 2.28 (s,36) |
| 22 | >230 | 7.66 (s,4); 2.33 (s,12); 2.08 (s,24) |
| 23 | 224-227 | 7.94 (d,1,J=8);7.90 (br s,1); 7,77 (d,1,J=8); 7.55-7.40 (m,3); 6.87 (s,4); 2.40 (s,6); 2.35 (s,6); 2.10-1.40 (br m,24) |
| 24 | * | 7.30 (s,4); 2.50 (s,12); 2.00 (s,24) |
| 25 | >230 | ** |
| 26 | >230 | ** |
| 27 | 145-150 | 7.50-7.40 (m,2); 7.30-7.10 (m,2); 2.67 (br t,2); 2.07 (br s,12);1.65 (br q,2); 1.36 (br q,2); 0.93 (t,3,J=7) |
| 28 | 210-211 | 7.44 (d,4,J=8); 7.28 (d,4,J=8); 6.81 (s,8); 2.29 (s,12); 2.00 (s,24) |
| 29 | 151-155 | 7.81 (s,2); 7.50 (s,1); 6.80 (s,8), 2.34 (s,12); 2.01 (s,24); 0.19 (s,9) |
| 30 | 210-211 | 7.47 (s,3); 6.72 (s,8); 3.79 (br s,1) 3.39 (br s, 1); 2,26 (s,12); 1.93 (s,24); 1.45 (br s,6); 0.98 (br s,6) |
| 31 | 212-213 | 8.03 (s,2); 7.64 (d,2,J=8); 7.53 (s,1); 7.25 (d,2,J=8); 6.71 (s,8); 2.44 (s,3); 2.28 (s,12); 1.82 (s,24) |
| 32 | 207-208 | 7.65 (s,2); 7.38 (s, 1); 6.74 (s,8); 2.27 (s,12); 1.93 (s,24) |
| 33 | 167-169 | 7.65 (s,2); 7.16 (s,1); 6.85 (2s,4); 2.35 (2s,12); 2.03 (s,6); 2.02 (s,6); 1.95 (s,6); 1.94 (s,6) |
| 34 | 178-184 | 7.40 (s,3); 6.79 (s,6); 2.33 (s,18); 1.98 (s,18); 1.89 (s,18) |
| 35 | 210-211 | 7.45-7.35 (m,3); 7.28 (d,2,J=7.5); 6.72 (s,8); 6.66 (s,2); 2,57 (s,6); 2,24 (s, 6); 2.05-1.87 (viele s,42) |
| 36 | >230 | 7.79 (br m,2); 7.35 (s,2); 7.24-7.20 (m,2); 6.86 (br d,4); 2.36 (s,12); 2.30-1.70 (br d,24) |
| 37 | 210-212 | 7.87-7.84 (m,2); 7.37 (s,2); 7.20-7.15 (m,2); 6.75 (s,8); 2.27 (s,12); 1.95 (br s,24) |
| 38 | 158-165 | 7.90 (d,1,J=2); 7.68 (d,1,J=9); 7.40 (d,1,J=7); 7.37 (d,1,J=7); 7.24 (dd, 1,J=9); 6.77 (2s,12); 2.28 (2s,18); 1.95 (br s,36) |
| 39 | >250 | 7.64 (d,4,J=8); 7.55 (d,4,J=8); 6.92 (s,4); 2.39 (s,12); 2.12 (s,12); 2.02 (s,12) |
| 40 | 220-225 | 7.50 (s,3); 6.65 (s,12); 2.23 (s,18); 1.89 (s,36) |

* der Wert wurde nicht bestimmt

** wurde nicht gemessen, da Verbindungen unlöslich

## II. Herstellung der Borate

Beispiel 1b: Herstellung des Tetramethylammonium-butylborates der Verbindung aus Beispiel 1.

*Methode F: Zu* einer gerührten Lösung von 8,6 g (0,015 mol) 1,4-Bis(dimesitylboryl)benzol in 80 ml THF wird während 15 Minuten bei 0°C 1 Äquivalent Butyllithium (0,015 mol) in Hexan gegeben.Die Reaktionsmischung wird auf Raumtemperatur erwärmen lassen und dann im Vakuum eingeengt. Der Rückstand wird mit 80 ml einer Mischung aus Methanol und Wasser im Verhältnis 4:1 behandelt und filtriert, um nichtabreagiertes Bisboran zu entfernen. Ein Überschuss Tetramethylammoniumchlorid wird zugegeben, worauf ein weisser Feststoff ausfällt. Filtration und Trocknung ergeben 5,0 g (47 % d. Theorie) des Titelproduktes.

*Methode G:* Das Borat kann auch ohne Isolierung der Zwischenprodukte direkt aus dem 1,4-Dibrombenzol über Methode B erhalten werden. Dabei wird nach dem zweiten Erwärmen auf Raumtemperatur die Reaktionsmischung mit zusätzlichem THF verdünnt, um eine homogene Lösung zu erhalten. Das Tetramethylammoniumborat wird dann gemäss der Methode F in einer Ausbeute von 78% d. Theorie erhalten.

Weitere Beispiele: Die der Verbindungen der Beispiele 1a-h, 2a-f, 3a-d, 4a-h, 5a-c, 6a,7a-d, 8a-l, 9a-b, 10a, 12a-d, 13a, 14a-b, 15a-f, 16a-c, 17a-b, 18a-b, 20a, 23a, 24a, 28a, 29a, 34a-b, 35a, 36a, 37a, 38a, 39a-d, 40a sind der Tabelle 2 zu entnehmen. Ebenfalls dort aufgelistet sind die jeweilige Herstellungsmethode und physikalischen Daten.

Tabelle 2: Borate

| Bsp. | Boran Verb. aus Bsp. | Art des Borats | Gegenion | Äquivalente Base | Herstellungsmethode | Schmelzbereich [°C] | Ausbeute [%] | $^{11}$B-NMR 160 Hz δ [ppm] |
|---|---|---|---|---|---|---|---|---|
| 1a | 1 | Methyl | $N(CH_3)_4^+$ | 1 $CH_3Li$ | F | # | 78 | -9.61 |
| 1b | 1 | Butyl | $N(CH_3)_4^+$ | 1 $C_4H_9Li$ | F, G | 215-219 | 47;78 | -8.35 |
| 1c | 1 | Dibutyl | 2 $N(CH_3)_4^+$ | 2 $C_4H_9Li$ | F | 229-231 | 91 | -8.71 |
| 1d | 1 | Butyl | Cyanin * | 1 $C_4H_9Li$ | F | 102-111 | 87 | -8.25 |
| 1e | 1 | Butyl | QTX ** | 1 $C_4H_9Li$ | F | 160-170 | 82 | -8.52 |
| 1f | 1 | Phenyl | $N(CH_3)_4^+$ | 1 $C_6H_4Li$ | F | >230 | 81 | -5.96 |
| 1g | 1 | Phenyl | Cyanin * | 1 $C_6H_4Li$ | F | 120-123 | 33 | # |
| 1h | 1 | Diphenyl | 2 $N(CH_3)_4^+$ | $LiC_6H_4Li$ | F | >230 | 59 | -1.96 |
| 2a | 2 | $(CH_3)_3Si-CH_2$ | $N(CH_3)_4^+$ | 1 $(CH_3)_3Si-CH_2Li$ | F | 130-170 | 80 | -9.50 |
| 2b | 2 | Butyl | $N(CH_3)_4^+$ | 1 $C_4H_9Li$ | F | 128-132 | 77 | -9.45 |
| 2c | 2 | s-Butyl | $N(CH_3)_4^+$ | 1 s-$C_4H_9Li$ | F | 136-152 | 29 | -6.57 |

| Bsp. | Boran Verb. aus Bsp. | Art des Borats | Gegenion | Äquivalente Base | Her-stel-lungs-me-thode | Schmelz bereich [°C] | Aus-beute [%] | $^{11}$B-NMR 160 Hz δ [ppm] |
|---|---|---|---|---|---|---|---|---|
| 2d | 2 | Benzyl | $N(CH_3)_4^+$ | 1 BenzylLi | F | >250 | 89 | -8.03 |
| 2e | 2 | 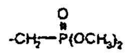 | $Li^+$ | 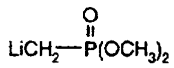 | F | 192-195 | 69 | -10.21 |
| 2f | 2 | 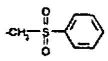 | $N(CH_3)_4^+$ | 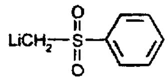 | F | 140-142 | 85 | -9.62 |
| 3a | 3 | Methyl | $N(CH_3)_4^+$ | 1 $CH_3Li$ | F | 170-172 | 100 | -8.92<br>-9.76 |
| 3b | 3 | Butyl | $N(CH_3)_4^+$ | 1 $C_4H_9Li$ | F | 172-182 | 86 | -7.38<br>-8.18 |
| 3c | 3 | Dimethyl | 2 $N(CH_3)_4^+$ | 2 $CH_3Li$ | F | 180-184 | 87 | -8.72<br>-9.77 |
| 3d | 3 | Dibutyl | 2 $N(CH_3)_4^+$ | 2 $C_4H_9Li$ | F | 224-225 | 22 | -7.59<br>-8.61 |
| 4a | 4 | Methyl | $N(CH_3)_4^+$ | 1 $CH_3Li$ | F | 180-188 | 82 | -8.60 |
| 4b | 4 | Butyl | $N(CH_3)_4^+$ | 1 $C_4H_9Li$ | F | 162-172 | 80 | -7.40 |
| 4c | 4 | Dimethyl | 2 $N(CH_3)_4^+$ | 2 $CH_3Li$ | F | 179-180 | 98 | -8.84 |
| 4d | 4 | Dibutyl | 2 $N(CH_3)_4^+$ | 2 $C_4H_9Li$ | F | 230-232 | 61 | -7.64 |
| 4e | 4 | Butyl | Cyanin * | 1 $C_4H_9Li$ | F | 110-124 | 89 | -7.64 |
| 4f | 4 | Butyl | QTX ** | 1 $C_4H_9Li$ | F | 154-161 | 84 | -7.67 |
| 4g | 4 | Phenyl | $N(CH_3)_4^+$ | 1 $C_6H_5Li$ | F | 200-205 | 75 | -5.20 |
| 4h | 4 | Phenyl | Cyanin * | 1 $C_6H_5Li$ | F | 138-140 | 72 | -5.23 |
| 5a | 5 | Methyl | $N(CH_3)_4^+$ | 1 $CH_3Li$ | F | 210-220 | 100 | -9.62 |
| 5b | 5 | Butyl | $N(CH_3)_4^+$ | 1 $C_4H_9Li$ | F | 150-160 | 36 | -8.73 |
| 5c | 5 | Dibutyl | 2 $N(CH_3)_4^+$ | 2 $C_4H_9Li$ | F | 185-187 | 52 | -8.16 |
| 6a | 6 | Methyl | $N(CH_3)_4^+$ | 1 $CH_3Li$ | F | >230 | 86 | -9.91 |
| 7a | 7 | Methyl | $N(CH_3)_4^+$ | 1 $CH_3Li$ | F | 138-140 | 25 | -8.77<br>-9.72 |
| 7b | 7 | Butyl | $N(CH_3)_4^+$ | 1 $C_4H_9Li$ | F | 138-149 | 82 | # |
| 7c | 7 | Dimethyl | 2 $N(CH_3)_4^+$ | 2 $CH_3Li$ | F | 223-233 | 69 | -8.18<br>-9.28 |
| 7d | 7 | Dibutyl | 2 $N(CH_3)_4^+$ | 2 $C_4H_9Li$ | F | 139-145 | 66 | # |
| 8a | 8 | Methyl | $N(CH_3)_4^+$ | 1 $CH_3Li$ | F | 210-215 | 100 | -9.63 |
| 8b | 8 | Butyl | $N(CH_3)_4^+$ | 1 $C_4H_9Li$ | F | 172-184 | 65 | -8.74 |

| Bsp. | Boran Verb. aus Bsp. | Art des Borats | Gegenion | Äquivalente Base | Her-stel-lungs-me-thode | Schmelz bereich [°C] | Aus-beute [%] | $^{11}$B-NMR 160 Hz δ [ppm] |
|---|---|---|---|---|---|---|---|---|
| 8c | 8 | Butyl | $N(C_4H_9)_4^+$ | 1 $C_4H_9Li$ | F | 78-80 | 53 | -8.71 |
| 8d | 8 | Dimethyl | 2 $N(CH_3)_4^+$ | 2 $CH_3Li$ | F | >270 | 71 | -9.67 |
| 8e | 8 | Dimethyl | 2 $N(C_4H_9)^+$ | 2 $CH_3Li$ | F | 159-160 | 69 | -9.68 |
| 8f | 8 | Dibutyl | 2 $N(CH_3)_4^+$ | 2 $C_4H_9Li$ | F | 265-267 | 63 | -8.46 |
| 8g | 8 | Dibutyl | 2 $N(C_4H_9)^+$ | 2 $C_4H_9Li$ | F | 225-227 | 52 | -8.82 |
| 8h | 8 | Butyl | Cyanin * | 1 $C_4H_9Li$ | F | 105-109 | 60 | -8.30 |
| 8i | 8 | Butyl | QTX ** | 1 $C_4H_9Li$ | F | 153-165 | 75 | -8.30 |
| 8j | 8 | Phenyl | $N(CH_3)_4^+$ | 1 $C_6H_5Li$ | F | >250 | 74 | -6.23 |
| 8h | 8 | Butyl | Cyanin * | 1 $C_4H_9Li$ | F | 105-109 | 60 | -8.30 |
| 8k | 8 | Phenyl | Cyanin * | 1 $C_6H_5Li$ | F | 147-157 | 63 | -6.23 |
| 8l | 8 | Diphenyl | 2 $N(CH_3)_4^+$ | $LiC_6H_5Li$ | F | >230 | 39 | -2.52 |
| 9a | 9 | Methyl | $N(CH_3)_4^+$ | 1 $CH_3Li$ | F | 150-170 | 55 | -9.06<br>-9.96 |
| 9b | 9 | Dimethyl | 2 $N(CH_3)_4^+$ | 2 $CH_3Li$ | F | # | 81 | -9.08<br>-10.01 |
| 10a | 10 | Dimethyl | 2 $N(CH_3)_4^+$ | 2 $CH_3Li$ | F | # | # | # |
| 12a | 12 | Methyl | $N(C_4H_9)_4^+$ | 1 $CH_3Li$ | F | 165-167 | 58 | -9.99 |
| 12b | 12 | Butyl | $N(CH_3)_4^+$ | 1 $C_4H_9Li$ | F | >230 | 58 | -8.41 |
| 12c | 12 | Dibutyl | 2 $N(CH_3)_4^+$ | 2 $C_4H_9Li$ | F | 205-210 | 66 | -8.77 |
| 12d | 12 | Butyl | Cyanin * | $C_4H_9Li$ | F | 103-110 | 41 | -8.35 |
| 13a | 13 | Butyl | $N(CH_3)_4^+$ | 1 $C_4H_9Li$ | F | # | 26 | # |
| 14a | 14 | Methyl | $N(CH_3)_4^+$ | $CH_3Li$ | F | 160-180 | 62 | -10.09 |
| 14b | 14 | Butyl | $N(CH_3)_4^+$ | $C_4H_9Li$ | F | 160-180 | 63 | -8.84 |
| 15a | 15 | Methyl | $N(CH_3)_4^+$ | $CH_3Li$ | F | 230-235 | 86 | -9.23 |
| 15b | 15 | Butyl | $N(CH_3)_4^+$ | $C_4H_9Li$ | F | 152-165 | 62 | -7.35 |
| 15c | 15 | Dimethyl | 2 $N(CH_3)_4^+$ | 2 $CH_3Li$ | F | >230 | 37 | -8.82 |
| 15d | 15 | Dibutyl | 2 $N(CH_3)_4^+$ | 2 $C_4H_9Li$ | F | 168-173 | 23 | -7.28 |
| 15e | 15 | Butyl | Cyanin * | 1 $C_4H_9Li$ | F | 125-157 | 48 | -7.40 |
| 15f | 15 | Butyl | QTX ** | 1 $C_4H_9Li$ | F | 146-156 | 38 | -7.42 |

| Bsp. | Boran Verb. aus Bsp. | Art des Borats | Gegenion | Äquivalente Base | Herstellungsmethode | Schmelzbereich [°C] | Ausbeute [%] | $^{11}$B-NMR 160 Hz δ [ppm] |
|---|---|---|---|---|---|---|---|---|
| 16a | 16 | Butyl | $N(CH_3)_4^+$ | 1 $C_4H_9Li$ | F | 149-157 | 80 | -6.03 |
| 16b | 16 | Butyl | Cyanin* | 1 $C_4H_9Li$ | F | 120-129 | 78 | -6.23 |
| 16c | 16 | Butyl | QTX** | 1 $C_4H_9Li$ | F | 146-152 | 81 | -6.42 |
| 17a | 17 | Methyl | $N(CH_3)_4^+$ | 1 $CH_3Li$ | F | >230 | 26 | -9.91 |
| 17b | 17 | Butyl | $N(CH_3)_4^+$ | 1 $C_4H_9Li$ | F | 230-232 | 47 | -7.35 |
| 18a | 18 | Methyl | $N(CH_3)_4^+$ | 1 $CH_3Li$ | F | 199-200 | 74 | -7.83 |
| 18b | 18 | Butyl | $N(CH_3)_4^+$ | 1 $C_4H_9Li$ | F | 115-120 | 81 | -7.18 |
| 20a*** | 20 | Butyl | $N(CH_3)_4^+$ | 0,5 $C_4H_9Li$- pro Äquiv. Bor | F | 179-180 | 40 | -8.62 |
| 23a | 23 | Butyl | $N(CH_3)_4^+$ | 1 $C_4H_9Li$ | F | >220 | 57 | # |
| 24a | 24 | Butyl | $N(CH_3)_4^+$ | 1 $C_4H_9Li$ | F | 141-142 | 15 | # |
| 28a | 28 | Butyl | $N(CH_3)_4$ | 1 $C_4H_9Li$ | F | >250 | 81 | -8.45 |
| 29a | 29 | Butyl | $N(CH_3)_4^+$ | 1 $C_4H_9Li$ | F | 125-130 | 74 | -8.38 |
| 34a | 34 | Methyl | $N(CH_3)_4^+$ | 1 $CH_3Li$ | F | 130-160 | 81 | -9.16 |
| 34b | 34 | Butyl | $N(CH_3)_4^+$ | 1 $C_4H_9Li$ | F | 150-157 | 82 | -7.69 |
| 35a | 35 | Butyl | $N(CH_3)_4^+$ | 1 $C_4H_9Li$ | F | 170-185 | 62 | -8.55 |
| 36a | 36 | Methyl | $N(CH_3)_4^+$ | 1 $CH_3Li$ | F | 186-190 | 35 | -7.91 |
| 37a | 37 | Butyl | $N(CH_3)_4^+$ | 1 $C_4H_9Li$ | F | 152-155 | 31 | # |
| 38a | 38 | Butyl | $N(CH_3)_4^+$ | 1 $C_4H_9Li$ | F | 145-150 | 43 | -7.06 |
| 39a | 39 | Methyl | $N(CH_3)_4^+$ | 1 $CH_3Li$ | F | 184-199 | 52 | -8.72 |
| 39b | 39 | Butyl | $N(CH_3)_4^+$ | 1 $C_4H_9Li$ | F | 185-195 | 53 | -7.55 |
| 39c | 39 | Phenyl | $N(CH_3)_4^+$ | 1 $C_6H_5Li$ | F | 227-230 | 64 | # |
| 39d | 39 | Phenyl | Cyanin* | 1 $C_6H_4Li$ | F | 153-167 | 52 | -5.45 |
| 40a | 40 | Butyl | $N(CH_3)_4^+$ | 1 $C_4H_9Li$ | F | 198-199 | 75 | -8.82 |

* Cyanin steht für 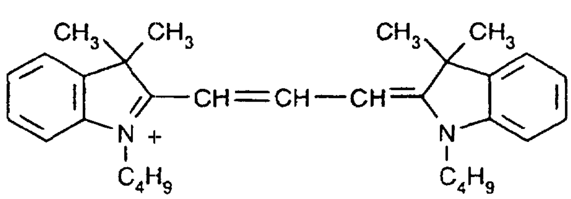

** QTX steht für 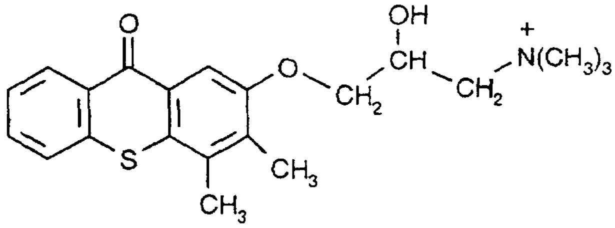

*** die genaue Stellung der Butylgruppen im Polyborat ist nicht bestimmt worden.

# die Werte wurden nicht bestimmt

**III. Anwendungsbeispiele**

Beispiel 41: Reaktivität der Polyborate in einer Resistformulierung

Durch Mischen der folgenden Komponenten wird eine photohärtbare Formulierung hergestellt:

10,0 g Dipentaerythritol-Monohydroxy-Pentaacrylat, ®SR 399, Sartomer Co., Berkshire, GB
15,0 g Tripropylenglycol-Diacrylat, Sartomer Co., Berkshire, GB
15,0 g N-Vinylpyrrolidon, Fluka
10,0 g Trimethylolpropantriacrylat, Degussa
50,0 g Urethan-Acrylat ®Actylan AJ20, Société National des Poudres et Explosifs
0,3 g Verlaufshilfsmittel ®Byk 300, Byk-Mallinckrodt

Portionen dieser Zusammensetzung werden mit 0,4 oder 1,6%, bezogen auf die Gesamtmenge der Formulierung, des erfindungsgemässen Polyborat-Photoinitiators vermischt. Alle Operationen werden unter Rotlicht durchgeführt. Die mit Polyborat versetzten Proben werden auf eine 300 µm Aluminiumfolie aufgetragen. Die Stärke der Trockenschicht ist 60 µm. Auf diesen Film wird eine 76 um dicke Polyesterfolie aufgebracht und auf diese ein standardisiertes Testnegativ mit 21 Stufen unterschiedlicher optischer Dichte (Stouffer Keil) aufgelegt. Die Probe wird mit einer zweiten UV-transparenten Folie abgedeckt und auf einer Metallplatte mittels Vakuum angepresst. Die Belichtung erfolgt in einer ersten Testreihe während 5 Sekunden, in einer zweiten während 10 und in einer dritten während 20 Sekunden im Abstand von 30 cm mittels einer 4kW Xenonlampe. Nach der Belichtung werden die Folien und die Maske entfernt und die belichtete Schicht in einem Ultraschallbad bei 23°C in Ethanol 10 Sekunden lang entwickelt. Die Trocknung erfolgt bei 40°C während 5 Minuten in einem Umluftofen. Die Empfindlichkeit des verwendeten Initiatorsystems wird durch die Angabe der letzten klebefrei abgebildeten (d.h. polymerisierten) Keilstufe charakterisiert. Je höher die Zahl der Stufen ist, desto empfindlicher ist das getestete System. Die Ergebnisse sind in der Tabelle 3 zusammengefasst.

Tabelle 3

| Verbindung aus Beispiel | Konzentration [%] | Zahl der abgebildeten Stufen nach Belichtungszeiten von | | |
|---|---|---|---|---|
| | | 5 s | 10 s | 20 s |
| 1a | 0,4 | 2 | 4 | 7 |
| 1b | 0,4 | 4 | 6 | 9 |
| 1c | 0,4 | 3 | 5 | 8 |
| 3a | 1,6 | 4 | 6 | 9 |
| 3b | 1,6 | 5 | 7 | 10 |
| 4a | 1,6 | 5 | 7 | 10 |
| 4b | 0,4 | 5 | 7 | 9 |
| 4b | 1,6 | 5 | 7 | 10 |
| 6a | 1,6 | 2 | 4 | 7 |

Tabelle 3 (fortgesetzt)

| Verbindung aus Beispiel | Konzentration [%] | Zahl der abgebildeten Stufen nach Belichtungszeiten von | | |
|---|---|---|---|---|
| | | 5 s | 10 s | 20 s |
| 8a | 1,6 | 5 | 7 | 10 |
| 8b | 1,6 | 7 | 9 | 12 |
| 8d | 1,6 | 3 | 5 | 8 |
| 8f | 1,6 | 6 | 8 | 11 |
| 8g | 1,6 | 3 | 5 | 8 |
| 9a | 1,6 | 6 | 8 | 11 |
| 9b | 1,6 | 3 | 5 | 8 |
| 12b | 1,6 | 3 | 5 | 8 |
| 12c | 1,6 | 4 | 6 | 9 |
| 14a | 1,6 | 2 | 5 | 8 |
| 14b | 1,6 | 4 | 6 | 9 |
| 15a | 1,6 | 5 | 7 | 9 |
| 15b | 1,6 | 7 | 9 | 12 |
| 16a | 1,6 | 8 | 10 | 13 |
| 17a | 1,6 | 4 | 6 | 9 |
| 17b | 1,6 | 6 | 9 | 12 |
| 18a | 1,6 | 3 | 5 | 7 |

Beispiel 42: Reaktivität der Polyborate in einer Resistformulierung

In eine wie in Beispiel 41 beschriebene Formulierung werden jeweils 1,6%, bezogen auf, die Gesamtmenge der Formulierung, des zu prüfenden Photoinitiators eingearbeitet. Die Probenbereitung, Belichtung und die Entwicklung der Probe erfolgt ebenfalls analog der in Beispiel 41 beschriebenen Methode, wobei jedoch die Belichtung jeweils 20 Sekunden lang erfolgt. Die Ergebnisse sind in der Tabelle 4 aufgelistet.

Tabelle 4

| Verbindung aus Beispiel | Konzentration [%] | Zahl der abgebildeten Stufen nach 20 s Belichtung |
|---|---|---|
| 8j | 1,6 | 7 |
| 13a | 1,6 | 10 |
| 20a | 1,6 | 8 |
| 28a | 1,6 | 11 |
| 34a | 1,6 | 8 |
| 36a | 1,6 | 15 |
| 38a | 1,6 | 15 |
| 39a | 1,6 | 12 |
| 39b | 1,6 | 12 |
| 39c | 1,6 | 7 |
| 23a | 1,6 | 13 |

Beispiel 43: Reaktivität der Polyborate in Kombination mit einem Farbstoff in einer Resistformulierung

Durch Mischen der folgenden Komponenten wird eine photohärtbare Formulierung hergestellt:

10,0 g Dipentaerythritol-Monohydroxy-Pentaacrylat, ®SR 399, Sartomer Co., Berkshire, GB
15,0 g Tripropylenglycol-Diacrylat, Sartomer Co., Berkshire, GB
15,0 g N-Vinylpyrrolidon, Fluka
10,0 g Trimethylolpropantriacrylat, Degussa
50,0 g Urethan-Acrylat ®Actylan AJ20, Société National des Poudres et Explosifs
0,3 g Verlaufshilfsmittel ®Byk 300, Byk-Mallinckrodt

Portionen dieser Zusammensetzung werden mit 0,4%, bezogen auf die Gesamtmenge der Formulierung, des erfindungsgemässen Polyborat-Photoinitiators und 0,3% des Farbstoffs mit folgender Struktur vermischt:

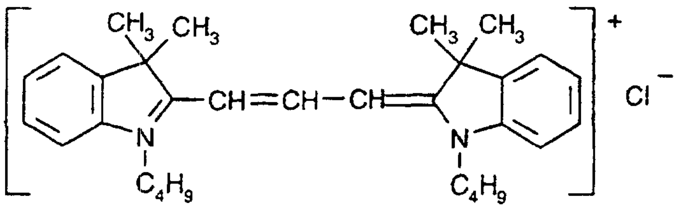

Alle Operationen werden unter Rotlicht durchgeführt. Die mit Polyborat versetzten Proben werden auf eine 300 µm Aluminiumfolie aufgetragen. Die Stärke der Trockenschicht ist 60 µm. Auf diesen Film wird eine 76 µm dicke Polyesterfolie aufgebracht und auf diese ein standardisiertes Testnegativ mit 21 Stufen unterschiedlicher optischer Dichte (Stouffer Keil) aufgelegt. Die Probe wird mit einer zweiten UV-transparenten Folie abgedeckt und auf einer Metallplatte mittels Vakuum angepresst. Die Belichtung erfolgt in einer ersten Testreihe während 5 Sekunden, in einer zweiten während 10 und in einer dritten während 20 Sekunden im Abstand von 30 cm mittels einer 4kW Xenonlampe. Nach der Belichtung werden die Folie und die Maske entfernt und die belichtete Schicht in einem Ultraschallbad bei 23°C in Ethanol 10 Sekunden lang entwickelt. Die Trocknung erfolgt bei 40°C während 5 Minuten in einem Umluftofen. Die Empfindlichkeit des verwendeten Initiatorsystems wird durch die Angabe der letzten klebefrei abgebildeten (d.h. polymerisierten) Keilstufe charakterisiert. Je höher die Zahl der Stufen ist, desto empfindlicher ist das getestete System. Die Ergebnisse sind in Tabelle 5 dargestellt.

Tabelle 5

| Verbindung aus Beispiel | Zahl der abgebildeten Stufen nach Belichtungszeiten von | | |
|---|---|---|---|
| | 5s | 10 s | 20s |
| 1a | 11 | 13 | 16 |
| 1b | 11 | 13 | 17 |
| 3a | 10 | 12 | 15 |
| 3b | 11 | 13 | 16 |
| 4a | 9 | 11 | 14 |
| 4b | 10 | 12 | 15 |
| 6a | 7 | 13 | 17 |
| 8b | 13 | 16 | 19 |
| 8f | 12 | 14 | 17 |
| 8g | 13 | 15 | 21 |
| 9a | 11 | 13 | 16 |
| 9b | 10 | 15 | 16 |
| 12b | 9 | 12 | 15 |

Tabelle 5 (fortgesetzt)

| Verbindung aus Beispiel | Zahl der abgebildeten Stufen nach Belichtungszeiten von | | |
|---|---|---|---|
| | 5s | 10 s | 20s |
| 12c | 16 | 18 | 20 |
| 14a | 9 | 14 | 17 |
| 14b | 4 | 7 | 20 |
| 15a | 14 | 17 | 20 |
| 15b | 14 | 17 | 20 |
| 17a | 11 | 16 | 18 |
| 17b | 14 | 17 | 20 |

Beispiel 44: Reaktivität der Polyborate in Kombination mit einem Farbstoff in einer Resistformulierung

In eine wie in Beispiel 43 beschriebene Formulierung werden jeweils 0,4%, bezogen auf die Gesamtmenge der Formulierung, des zu prüfenden Photoinitiators, sowie 0,3% des in Beispiel 43 beschriebenen Farbstoffs eingearbeitet. Die Probenbereitung, Belichtung und die Entwicklung der Probe erfolgt ebenfalls analog der in Beispiel 43 beschriebenen Methode, wobei jedoch die Belichtung jeweils 20 Sekunden lang erfolgt. Die Ergebnisse sind in Tabelle 6 wiedergegeben.

Tabelle 6

| Verbindung aus Beispiel | Zahl der abgebildeten Stufen nach 20 s | Bleichverhalten* |
|---|---|---|
| 2b | 13 | - |
| 2c | 14 | - |
| 2d | 14 | - |
| 13a | 17 | b |
| 20a | 17 | b |
| 28a | 17 | b |
| 29a | 17 | b |
| 34a | 12 | - |
| 34b | 12 | - |
| 35a | 15 | b |
| 36a | 17 | b |
| 38a | 18 | b |
| 39a | 17 | b |
| 39b | 17 | b |
| 40a | 16 | b |
| 23a | 18 | b |

* b = bleicht aus (visuelle Prüfung)
- = ein Ausbleichen wird nicht beobachtet, dies schliesst jedoch nocht aus, daß es nicht auftritt, sondern bedeutet nur, daß es bei der visuellen Prüfung nicht bemerkt wird

Beispiel 45:

Reaktivität von Farbstoff-Polyboratsalzen in einer Resistformulierung In eine Formulierung wie in Beipiel 41 beschrieben werden die erfindungsgemässen Farbstoff-Polyboratsalze in einer Konzentration von 0,3%, bezogen auf die Gesamtmenge der Formulierung, eingearbeitet. Der Farbstoff fungiert in diesen Verbindungen als Gegenkation

zum Polyboratanion. Die Verbindungen enthalten die Farbstoffkationen $F^+$ oder $Q^+$:

$F^+$ =

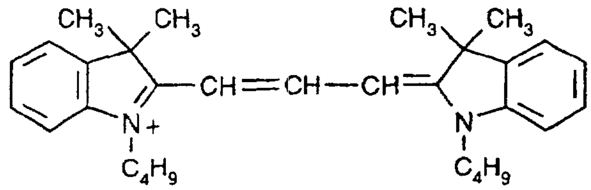

$Q^+$ =

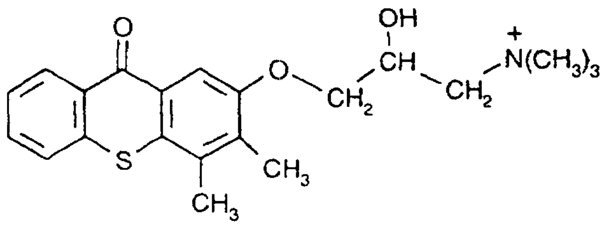

Die Probenbereitung und Härtung der Proben erfolgt ebenfalls wie in Beispiel 41 beschrieben. Die Ergebnisse sind in Tabelle 7 aufgelistet.

Tabelle 7

| Verbindung aus Beispiel | Kation | Zahl der abgebildeten Stufen nach Belichtungszeiten von | | | Bleichverhalten* |
|---|---|---|---|---|---|
| | | 5s | 10s | 20s | |
| 1d | $F^+$ | 12 | 15 | 16 | b |
| 4e | $F^+$ | 9 | 12 | 15 | - |
| 8h | $F^+$ | 12 | 14 | 17 | - |
| 12d | $F^+$ | 11 | 14 | 17 | b |
| 15e | $F^+$ | 13 | 15 | 18 | b |
| 16b | $F^+$ | 11 | 13 | 16 | - |
| 1e | $Q^+$ | 8 | 10 | 12 | - |
| 4f | $Q^+$ | 7 | 9 | 12 | - |
| 8i | $Q^+$ | 8 | 10 | 12 | - |
| 15f | $Q^+$ | 8 | 10 | 12 | - |
| 16c | $Q^+$ | 7 | 9 | 11 | - |

* b = bleicht aus (visuelle Prüfung)
\- = ein Ausbleichen wird nicht beobachtet, dies schliesst jedoch nocht aus, daß es nicht auftritt, sondern bedeutet nur, daß es bei der visuellen Prüfung nicht bemerkt wird

<u>Beispiel 46:</u> Reaktivität von Farbstoff-Polyboratsalzen in einer Resistformulierung

Es wird verfahren wie in Beispiel 45, wobei jedoch die Belichtungszeit 20 Sekunden beträgt. Die Ergebnisse sind in der Tabelle 8 wiedergegeben.

Tabelle 8

| Verbindung aus Beispiel | Anzahl der abgebildeten Stufen |
|---|---|
| 1g | 11 |
| 4h | 9 |

Tabelle 8 (fortgesetzt)

| Verbindung aus Beispiel | Anzahl der abgebildeten Stufen |
|---|---|
| 8k | 12 |
| 39d | 8 |

Beispiel 47: Reaktivität von Polyboraten in Kombination mit Elektronenakzeptoren Es wird eine Formulierung wie in Beispiel 43 beschrieben bereitet. Portionen der Zusammensetzung werden mit 0,4% des zu testenden Photoinitiators und 0,3% einer Substanz A, B, C, D oder E versetzt.

A: ®Quantacure ITX, International Bio-Synthetics Mischung aus

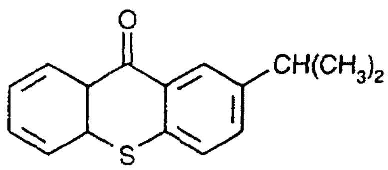

und

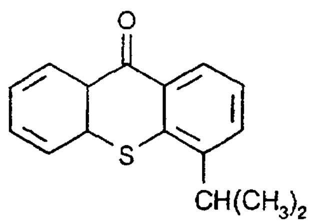

B: ®Quantacure QTX, International Bio-Synthetics

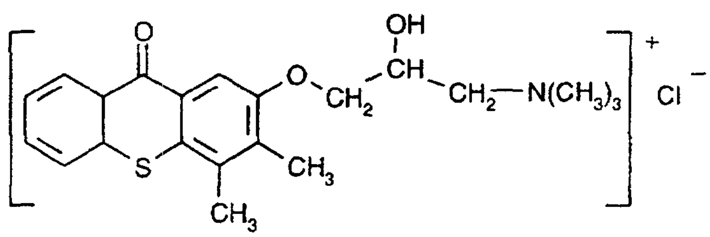

C: Benzophenon

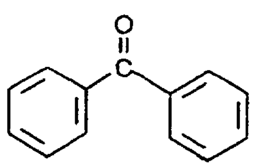

D: ®Quantacure BTC, International Bio-Synthetics

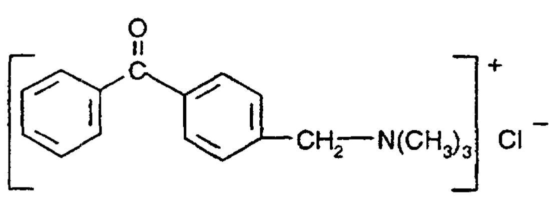

E: Thioxanthonderivat

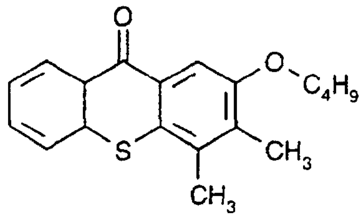

Die Bereitung der Proben und die Härtung erfolgen ebenfalls analog zu Beispiel 43. Die Ergebnisse sind in der Tabelle 9 dargestellt.

Tabelle 9

| Verbindung aus Beispiel | Elektronenakzeptor | Zahl der abgebildeten Stufen nach Belichtungszeiten von | | |
|---|---|---|---|---|
| | | 5s | 10 s | 20 s |
| 4b | A | 5 | 7 | 10 |
| 15a | A | 5 | 7 | 9 |
| 4b | B | 6 | 8 | 10 |
| 15a | B | 4 | 6 | 9 |
| 4b | C | 5 | 7 | 10 |
| 15a | C | 4 | 6 | 8 |
| 4b | D | 5 | 7 | 10 |
| 15a | D | 5 | 7 | 10 |
| 4b | E | 7 | 9 | 12 |
| 15a | E | 7 | 9 | 11 |

Beispiel 50: Kombinationen von Polyboraten mit Monoboraten

Es wird eine photohärtbare Zusammensetzung hergestellt durch Mischen der folgenden Komponenten:

| | |
|---|---|
| 37,64 g | ®Sartomer SR 444, Pentaerythritol-triacrylat, (Sartomer Company, Westchester) |
| 10,76 g | ®Cymel 301, Hexamethoxymethylmelamin (American Cyanamid, USA) |
| 47,30 g | ®Carboset 525, thermoplastisches Polyacrylat mit Carboxylgruppen (B.F.Goodrich) |
| 4,30 g | Polyvinylpyrrolidon PVP (GAF, USA) |
| 100,00 g | dieser Zusammensetzung werden mit |
| 319,00 g | Methylenchlorid und |
| 30,00 g | Methanol vermischt. |

Proben dieser Zusammensetzung werden mit jeweils 0.68% eines erfindungsgemässen Polyborates und 0.68% Tetramethylammonium N-butyltriphenylborat bezogen auf den Festkörpergehalt, durch einstündiges Rühren bei Raumtemperatur vermischt. Alle Operationen werden unter Rotlicht ausgeführt. Die mit Initiator versetzten Proben werden auf eine 300 µm Aluminiumfolie (10 x 15 cm) aufgetragen. Das Lösungsmittel wird zunächst durch 5-minütiges Trocknen bei Raumtemperatur und darauffolgende Erwärmung auf 60°C während 15 Minuten im Umluftofen entfernt, woraus eine Trockenschichtstärke von 35 µm resultiert. Auf die flüssige Schicht wird eine 76 µm dicke Polyesterfolie gelegt und auf diese ein standardisiertes Testnegativ mit 21 Stufen verschiedener optischer Dichte (Stouffer-Keil) aufgebracht. Mit einer zweiten UV-transparenten Folie wird die Probe abgedeckt und mittels Vakuum auf einer Metallplatte angepresst. Die Probe wird dann mit einer 4kW Xenon Lampe im Abstand von 30 cm 40 Sekunden lang belichtet. Nach der Belichtung werden die Folien und die Maske entfernt, die belichtete Schicht in einem Ultraschallbad 240 Sekunden mit einer 1%igen wässrigen Lösung von Natriumcarbonat entwickelt und anschliessend bei 60°C 15 Min im Umluftofen getrocknet. Die Empfindlichkeit des verwendeten Initiatorsystems wird durch die Angabe der letzten

klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 12 angegeben.

Tabelle 12:

| Verbindung aus Beispiel | Zahl der abgebildeten Stufen |
|---|---|
| 39a | 11 |
| 8b | 8 |

Beispiel 52: Farbstoff-Polyboratsalze in einer Resistformulierung und mit einem $Ar^+$ Laser als Lichtquelle

In eine Formulierung wie in Beispiel 41 beschrieben werden die erfindungsgemässen Farbstoff-Polyboratsalze in einer Konzentration von 0,3% bezogen auf die Gesamtmenge der Formulierung eingearbeitet. Der Farbstoff fungiert als Gegenion zum Polyboratanion und entspricht dem Farbstoffkation F (siehe Beispiel 45). Die Probenvorbereitung und das Entwickeln erfolgt wie im Beispiel 41 beschrieben, zur Belichtung wird jedoch ein $Ar^+$ Laser (UNIPHASE 1583, Strahldurchmesser 0,65 mm, Divergenz 0,95 mrad) mit monochromatischem Licht der Wellenlänge 488 nm und einer Leistung von 20 mW verwendet. Der Laserstrahl mit einem Durchmesser von ca. 2,5 mm wird mit einer Geschwindigkeit von 24 mm/s über einen auf der Probe fixierten Stouffer Keil mit 21 Stufen bewegt. Nach dem Entwickeln bleibt eine Linie unterschiedlicher Breite und Länge stehen. Zur Auswertung wird diejenige Stufenzahl angegeben bei der noch eine gehärtete Linie zu sehen ist. Die Ergebnisse sind in Tabelle 14 wiedergegeben.

Tabelle 14:

| Verbindung aus Beispiel | Zahl der abgebildeten Stufen | Bleichverhalten* |
|---|---|---|
| 15e | 8 | b |
| 8h | 9 | - |
| 1d | 9 | b |
| 12d | 10 | b |

* b = bleicht aus (visuelle Prüfung)
\- = ein Ausbleichen wird nicht beobachtet, dies schliesst jedoch nocht aus, daß es nicht auftritt, sondern bedeutet nur, daß es bei der visuellen Prüfung nicht bemerkt wird

Beispiel 53: Kombinationen von Farbstoffen mit Polyboraten in einer Resistformulierung und mit einem Ar+ Laser als Lichtquelle

In eine Formulierung wie in Beispiel 41 beschrieben werden 0.4 % des erfindungsgemässen Polyboratsalzes und 0.3% des Farbstoffes aus Beispiel 43 bezogen auf die Gesamtmenge der Formulierung eingearbeitet. Die Probenvorbereitung, Belichtung, Entwicklung und Auswertung erfolgt auf die im Beispiel 52 beschriebene Art und Weise. Die Ergebnisse sind in Tabelle 15 wiedergegeben.

Tabelle 15:

| Verbindung aus Beispiel | Zahl der abgebildeten Stufen | Bleichverhalten* |
|---|---|---|
| 12c | 11 | b |

* b = bleicht aus (visuelle Prüfung)

Beispiel 54: Kombinationen von Farbstoffen mit Polyboraten in einer Resistformulierung und mit einem frequenzverdoppelten Nd/YAG Laser als Lichtquelle

In eine Formulierung wie in Beispiel 41 beschrieben werden die erfindungsgemässen Farbstoff-Polyboratsalze in einer Konzentration von 0,3% bezogen auf die Gesamtmenge der Formulierung eingearbeitet. Der Farbstoff fungiert als Gegenion zum Polyboratanion und entspricht dem Farbstoffkation F (siehe Beispiel 45). Die Probenvorbereitung und das Entwickeln erfolgt wie im Beispiel 41 beschrieben, zur Belichtung wird jedoch ein frequenzverdoppelter Nd/YAG Laser (COHERENT DPSS 532-50, Strahldurchmesser 0,7 mm, Divergenz <1,3mrad) mit monochromatischem Licht der Wellenlänge 532 nm und einer Leistung von 50 mW verwendet. Der Laserstrahl mit einem Durchmesser von ca. 3,3 mm wird mit einer Geschwindigkeit von 6 mm/s über einen auf der Probe fixierten Stouffer Keil mit 21 Stufen bewegt. Nach dem Entwickeln bleibt eine Linie unterschiedlicher Breite und Länge stehen. Zur Auswertung wird diejenige Stufenzahl angegeben bei der noch eine gehärtete Linie zu sehen ist. Die Ergebnisse sind in Tabelle 16 wiedergegeben.

Tabelle 16:

| Verbindung aus Beispiel | Zahl der abgebildeten Stufen | Bleichverhalten |
|---|---|---|
| 15e | 13 | b |
| 8h | 13 | - |
| 1d | 12 | b |
| 12d | 12 | b |

* b = bleicht aus (visuelle Prüfung)

- = ein Ausbleichen wird nicht beobachtet, dies schliesst jedoch nocht aus, daß es nicht auftritt, sondern bedeutet nur, daß es bei der visuellen Prüfung nicht bemerkt wird

Beispiel 55: Kombinationen von Farbstoffen mit Polyboraten in einer Resistformulierung und mit einem frequenzverdoppelten Nd/YAG Laser als Lichtquelle

In eine Formulierung wie in Beispiel 41 beschrieben werden das erfindungsgemässe Polyboratsalz aus Beispiel 12c in einer Konzentration von 0.4% und 0.3% des Farbstoffes aus Beispiel 43, bezogen auf die Gesamtmenge der Formulierung, eingearbeitet. Die Probenvorbereitung, Belichtung, Entwicklung und Auswertung erfolgt auf die im Beispiel 53 beschriebene Art und Weise. Die Ergebnisse sind in der Tabelle 17 dargestellt.

Tabelle 17:

| Verbindung aus Beispiel | Zahl der abgebildeten Stufen |
|---|---|
| 12c | 12 |

Beispiel 56: Polyborate als thermische Initiatoren

Zu der in Beispiel 41 beschriebenen Formulierung wurden 0,3% der erfindungsgemässen Polyborate zugegeben und ca 15 mg davon in DSC-Pfännchen eingewogen (unter Rotlicht). Danach wurde mit Hilfe eines Mettler DSC 30 die Exothermie der Härtungsreaktion bei einer Aufheizrate von 10 Grad pro Minute bestimmt. Die Anfangstemperatur ($T_A$) und Peaktemperatur ($T_P$) der Exothermen wurden bestimmt. Diejenigen Initiatoren, bei denen die Anfangs- oder Peaktemperatur unter den Werten für die reine Formulierung liegen sind thermische Initiatoren. Die Ergebnisse sind in Tabelle 18 zusammengefasst.

Tabelle 18:

| Verbindung | $T_A$ [°C] | $T_P$ [°C] |
|---|---|---|
| Formulierung | 135 | 145 |
| 38a | 110 | 120 |

Beispiel 57: Polyborate in Kombination mit Elektronenakzeptoren als thermische Initiatoren

Zu der in Beispiel 41 beschriebenen Formulierung wurden 0,3% der erfindungsgemässen Polyborate und 0.4% des Elektronenakzeptors A aus Beispiel 47 zugegeben und ca 10 mg davon in DSC-Pfännchen eingewogen (unter Rotlicht). Danach wurde mit Hilfe eines Mettler DSC 30 die Exothermie der Härtungsreaktion bei einer Aufheizrate von 10 Grad pro Minute bestimmt. Die Anfangstemperatur ($T_A$) und Peaktemperatur ($T_P$) der Exothermen wurden bestimmt. Diejenigen Initiatoren, bei denen Die Anfangs- oder Peaktemperatur unter den Werten für die reine Formulierung liegen sind thermische Initiatoren. Die Ergebnisse sind in Tabelle 19 zusammengefasst.

Tabelle 19:

| Verbindung | Elektronenakzeptoren | $T_A$[°C] | $T_P$[°C] |
|---|---|---|---|
| Formulierung | - | 135 | 145 |
| 38a | A | 113 | 127 |
| 36a | A | 110 | - |

## Patentansprüche

**1.** Verbindungen der Formel I

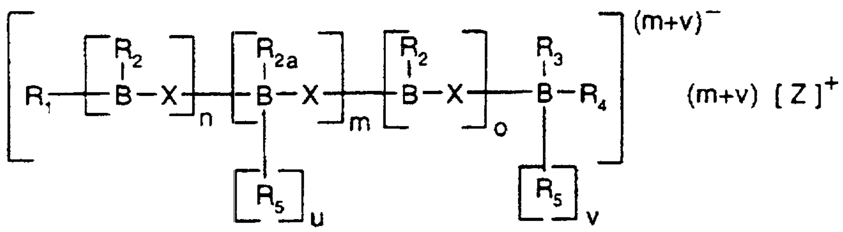 (I)

worin n und o für eine Zahl von 0 bis 50 stehen,
**m** eine Zahl von 1-50 ist,
**u** und **v** 0 oder 1 sind, wobei mindestens einer der Indices u oder v 1 bedeutet,
**$R_1$**, **$R_2$**, **$R_{2a}$**, **$R_3$** und **$R_4$** unabhängig voneinander für Phenyl oder einen anderen aromatischen Kohlenwasserstoff stehen, wobei diese Reste unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,
**p** 0, 1 oder 2 ist;
**q** 0 oder 1 ist;
**$R_5$**, $C_1$-$C_{12}$-Alkyl, $C_3$-$C_{12}$-Cycloalkyl, $C_2$-$C_8$-Alkenyl, Phenyl-$C_1$-$C_6$-Alkyl oder Naphthyl-$C_1$-$C_3$-Alkyl bedeutet; wobei die Reste $C_1$-$C_{12}$-Alkyl, $C_3$-$C_{12}$-Cycloalkyl, $C_2$-$C_8$-Alkenyl, Phenyl-$C_1$-$C_6$-Alkyl oder Naphthyl-$C_1$-$C_3$-Alkyl unsubstituiert oder mit $OR_6$, $S(O)_pR_7$, $OS(O)_2R_7$, $NR_8R_9$, $C(O)OR_6$, $C(O)NR_8R_9$, $C(O)R_{10}$,

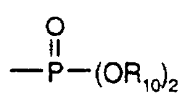 ,

$SiR_{11}R_{12}R_{13}$, $BR_{14}R_{15}$ oder Halogen substituiert sind, oder $R_5$ für Phenyl oder einen anderen aromatischen Kohlenwasserstoff steht, wobei diese Reste unsubstituiert oder mit $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind, wobei mindestens einer der Reste $R_1$, $R_2$, $R_{2a}$, $R_3$, $R_4$ oder $R_5$ einen in ortho-Stellung zu der Bindung zum Boratom substituierten Phenylrest oder anderen in ortho Stellung zum Boratom sterisch gehinderten aromatischen Kohlenwasserstoffrest darstellt,
**$R_6$** und **$R_7$** unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,
**$R_{7a}$** für $C_1$-$C_{12}$-Alkyl steht;
**$R_8$**, **$R_9$**, **$R_{10}$**, **$R_{11}$**, **$R_{12}$**, **$R_{13}$**, **$R_{14}$** und **$R_{15}$** unabhängig voneinander eine der Bedeutungen von $R_6$ haben oder $C_3$-$C_{12}$-Cycloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;
**X** $C_1$-$C_{20}$-Alkylen, welches unsubstituiert oder mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, Halogen oder $P(O)_qR_{16}R_{17}$ substituiert ist bedeutet,
oder X $C_1$-$C_{20}$-Alkylen, welches durch eine oder mehrere Gruppen -O-, $-S(O)_p-$ oder $-NR_{18}-$ unterbrochen ist,

bedeutet,
oder X $C_3$-$C_{12}$-Cycloalkylen oder $C_2$-$C_8$-Alkenylen ist, wobei diese Reste unsubstituiert oder mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind, oder wobei diese Reste durch eine oder mehrere Gruppen -O-, $-S(O)_p-$ oder $-NR_{18}-$ unterbrochen sind,
oder X für einen zweiwertigen aromatischen Kohlenwasserstoffrest steht, wobei dieser Rest unsubstituiert oder mit $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert ist;
oder X für einen Rest der Formeln II oder III

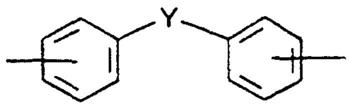

(II)

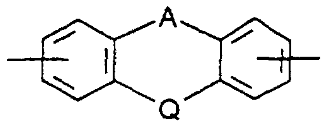

(III)

steht;
**$R_{16}$** und **$R_{17}$** unabhängig voneinander eine der Bedeutungen von $R_6$ haben oder $C_3$-$C_{12}$-Cycloalkyl sind;
**$R_{18}$** eine der Bedeutungen von $R_6$ hat oder Wasserstoff ist,
**Y** $-(CH_2)_r-$, -C(O)-, $-NR_{18}-$, -O-, $-S(O)_p-$, $-CR_{19}R_{20}-$,

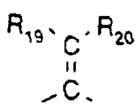

oder

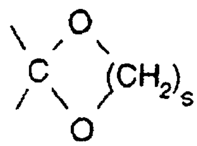

ist;
**r** für 1, 2 oder 3 steht;
**s** für 2 oder 3 steht;
**$R_{19}$** und **$R_{20}$** $C_1$-$C_6$-Alkyl oder Phenyl sind oder $R_{19}$ und $R_{20}$ zusammen mit dem C-Atom, an welches sie gebunden sind, einen 5- oder 6-gliedrigen Ring bilden;
**A** und **Q** unabhängig voneinander eine Einfachbindung, $-(CH_2)_r-$, -CH=CH-, -C(O)-, $-NR_{18}-$, $S(O)_p-$,

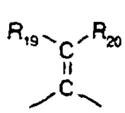

oder

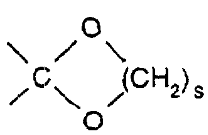

bedeuten; oder die Reste $R_1$, $R_2$, $R_3$, $R_4$ oder X Brücken bilden, wobei Reste der Formeln (IV) oder (V)

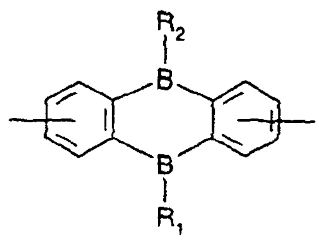

(IV)

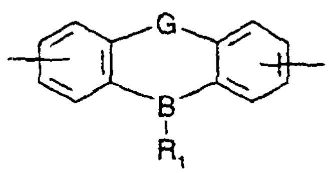

(V)

entstehen, worin

G für $-(CH_2)_t-$, -CHCH-, -C(O)-, $-NR_{18}-$, -O- oder $-S(O)_p-$ steht und

**t** 0,1 oder 2 ist,

wobei die Reste der Formeln (II), (III), (IV) und (V) unsubstituiert sind oder an den aromatischen Ringen mit $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ oder Halogen substituiert sind und wobei an die Phenylringe der Formeln (II), (III), (IV) und (V) weitere Phenylringe anneliert sein können;

mit der Massgabe, dass $R_1$, $R_{2a}$, $R_3$ und $R_4$ nicht alle gleichzeitig 1-Naphthyl bedeuten, wenn X für Phenylen oder 4,4'-Biphenylen steht; und

**Z** für einen Rest steht, welcher positive Ionen bilden kann.

**2.** Verbindungen nach Anspruch 1, worin n und o gleich 0 sind, m für die Zahl 1 steht, $R_1$, $R_2$, $R_{2a}$, $R_3$ und $R_4$ mit $C_1$-$C_6$-Alkyl und/oder Halogen, insbesondere Chlor, substituiertes Phenyl bedeuten, $R_5$ $C_1$-$C_{12}$-Alkyl, $(C_1\text{-}C_4\text{-Alkyl})_3Si\text{-}CH_2$- oder Phenyl ist, X unsubstituiertes Phenylen, mit Halogen, insbesondere Fluor, substituiertes Phenylen. Biphenylen, o- oder p-Terphenylen, Naphthylen, Phenanthrylen, Ferrocenylen oder einen Rest der Formel II darstellt, worin Y -C(O)- oder

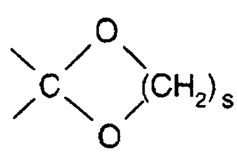

bedeutet,
s gleich 2 ist und
Z für Tetraalkylammonium steht.

**3.** Zusammensetzung enthaltend

(a) mindestens eine ethylenisch ungesättigte photopolymerisierbare Verbindung und
(b) mindestens eine Verbindung der Formel I wie in Anspruch 1 definiert.

**4.** Zusammensetzung nach Anspruch 3 enthaltend zusätzlich zu den Komponenten (a) und (b) mindestens einen Elektronenakzeptor (c).

**5.** Zusammensetzung nach Anspruch 3, enthaltend zusätzlich zu den Komponenten (a) und (b) mindestens eine Verbindung der Formel XI

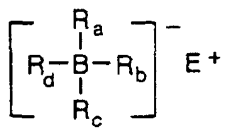

(XI)

worin $R_a$, $R_b$, $R_c$ und $R_d$ unabhängig voneinander für $C_1$-$C_{12}$-Alkyl, Trimethylsilylmethyl, Phenyl, einen anderen aromatischen Kohlenwasserstoff, $C_1$-$C_6$-Alkylphenyl, Allyl, Phenyl-$C_1$-$C_6$-alkyl, $C_2$-$C_8$-Alkenyl, $C_2$-$C_8$-Alkinyl, $C_3$-$C_{12}$-Cycloalkyl oder gesättigte oder ungesättigte heterozyclische Reste stehen, wobei die Reste Phenyl, anderer aromatischer Kohlenwasserstoff, Phenyl-$C_1$-$C_6$-alkyl, gesättigter oder ungesättigter heterozyclischer Rest unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,

p 0, 1 oder 2 ist;

q 0 oder 1 ist;

$R_6$ und $R_7$ unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,

$R_{7a}$ für $C_1$-$C_{12}$-Alkyl steht;

$R_8$, $R_9$, $R_{10}$, $R_{11}$, $R_{12}$, $R_{13}$, $R_{14}$ und $R_{15}$ unabhängig voneinander eine der Bedeutungen von $R_6$ haben oder $C_3$-$C_{12}$-Cycloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;

$R_{16}$ und $R_{17}$ unabhängig voneinander eine der Bedeutungen von $R_6$ haben oder $C_3$-$C_{12}$-Cycloalkyl sind; und

E für einen Rest steht, welcher positive Ionen bilden kann.

**6.** Zusammensetzung nach Anspruch 3, enthaltend neben der Komponente (b) noch einen weiteren Photoinitator (d) und/oder weitere Additive.

**7.** Zusammensetzung nach Anspruch 3, enthaltend zusätzlich zu den Komponenten (a) und
(b) mindestens einen neutralen, anionischen oder kationischen Farbstoff oder eine Thioxanthonverbindung und eine Oniumverbindung.

**8.** Zusammensetzung nach Anspruch 7, enthaltend zusätzlich einen radikalischen Photoinitiator, insbesondere eine $\alpha$-Aminoketonverbindung.

**9.** Zusammensetzung enthaltend

(a) mindestens eine ethylenisch ungesättigte photopolymerisierbare Verbindung und
(b) mindestens ein Polyborat-Anion der Formel Ia

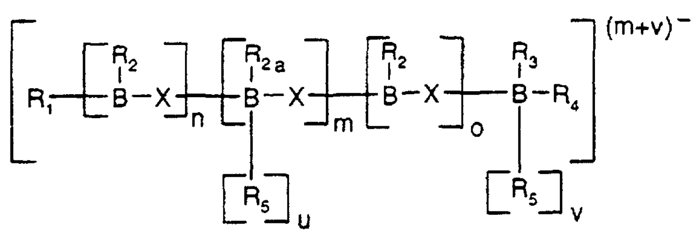

(Ia)

worin die Reste $R_1$, $R_2$, $R_{2a}$, $R_3$, $R_4$, $R_5$ und X, sowie n, m, o, u und v wie in Anspruch 1 definiert sind, und
(c) ein Farbstoff-, Sulfonium- oder Iodonium-Kation.

**10.** Zusammensetzung nach Anspruch 9, enthaltend zusätzlich mindestens eine weitere Boratverbindung der Formel XI

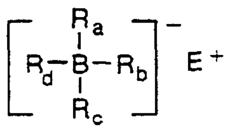

(XI)

worin $R_a$, $R_b$, $R_c$ und $R_d$ unabhängig voneinander für $C_1$-$C_{12}$-Alkyl, Trimethylsilylmethyl, Phenyl, einen anderen aromatischen Kohlenwasserstoff, $C_1$-$C_6$-Alkylphenyl, Allyl, Phenyl-$C_1$-$C_6$-alkyl, $C_2$-$C_8$-Alkenyl, $C_2$-$C_8$-Alkinyl, $C_3$-$C_{12}$-Cycloalkyl oder gesättigte oder ungesättigte heterozyclische Reste stehen, wobei die Reste Phenyl, anderer aromatischer Kohlenwasserstoff, Phenyl-$C_1$-$C_6$-alkyl, gesättigter oder ungesättigter heterozyclischer Rest unsubstituiert oder mit unsubstituiertem oder mit Halogen, $OR_6$ oder/und $NR_8R_9$ substituiertem $C_1$-$C_6$-Alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ oder Halogen substituiert sind,

p 0, 1 oder 2 ist;

q 0 oder 1 ist;

$R_6$ und $R_7$ unsubstituiertes oder mit $COOR_{7a}$, OH, $C_1$-$C_{12}$-Alkoxy oder Halogen substituiertes $C_1$-$C_{12}$-Alkyl, unsubstituiertes oder 1- bis 5-fach mit $C_1$-$C_6$-Alkyl, $C_1$-$C_{12}$-Alkoxy oder Halogen substituiertes Phenyl oder unsubstituiertes oder 1- bis 5-fach mit $C_1$-$C_6$-Alkyl, $C_1$-$C_{12}$-Alkoxy oder Halogen substituiertes Phenyl-$C_1$-$C_6$-Alkyl sind,

$R_{7a}$ für $C_1$-$C_{12}$-Alkyl steht;

$R_8$, $R_9$, $R_{10}$, $R_{11}$, $R_{12}$, $R_{13}$, $R_{14}$ und $R_{15}$ unabhängig voneinander eine der Bedeutungen von $R_6$ haben oder $C_3$-$C_{12}$-Cycloalkyl sind, oder $R_8$ und $R_9$ zusammen mit dem N-Atom, an welches sie gebunden sind, einen 5- oder 6-gliedrigen Ring, der zusätzlich noch O- oder S-Atome enthalten kann, bilden oder $R_{14}$ und $R_{15}$ zusammen mit dem B-Atom, an welches sie gebunden sind, einen 5- oder 6-gliedrigen Ring bilden;

$R_{16}$ und $R_{17}$ unabhängig voneinander eine der Bedeutungen von $R_6$ haben oder $C_3$-$C_{12}$-Cycloalkyl sind; und

E für einen Rest steht, welcher positive Ionen bilden kann.

**11.** Zusammensetzung nach Anspruch 3, enthaltend mindestens ein Borat der Formel I und mindestens einen Cyanin- oder Pyriliumfarbstoff, wobei dieser Farbstoff auch als Kation Bestandteil der Verbindung der Formel I sein kann.

**12.** Verwendung von in Anspruch 1 definierten Verbindungen als Photoinitiatoren für die Photopolymerisation ethylenisch ungesättigter Verbindungen.

**13.** Zusammensetzung nach einem der Ansprüche 3-11, enthaltend 0,05 bis 15, insbesondere 0,1 bis 5 Gew.-%, der Komponente (b), bezogen auf die Zusammensetzung.

**14.** Verwendung einer Zusammensetzung nach einem der Ansprüche 3-11 zur Herstellung von pigmentierten und nichtpigmentierten Lacken, Pulverlacken, Druckfarben, Druckplatten, Klebern, Dentalmassen, Lichtwellenleitern, optischen Schaltern, Farbprüfusystemen, Glasfaserkabelbeschichtungen, Siebdruckschablonen, Resistmaterialien, Verbundmassen, zur Verkapselung elektrischer und elektronischer Bauteile, zur Herstellung von magnetischen Aufzeichnungsmaterialien, zur Herstellung von dreidimesnionalen Objekten mittels Stereolithographie, für photographische Reproduktionen, sowie als Bildaufzeichnungsmaterial, insbesondere für holographische Aufzeichnungen.

**15.** Beschichtetes Substrat, das auf mindestens einer Oberfläche mit einer Zusammensetzung nach einem der Ansprüche 3-11 beschichtet ist.

**16.** Verfahren zur photographischen Herstellung von Reliefabbildungen, **dadurch gekennzeichnet, dass** ein beschichtetes Substrat nach Anspruch 15 bildmässig belichtet wird oder mittels eines beweglichen Laserstrahls (ohne Maske) belichtet wird und die unbelichteten Anteile danach mit einem Lösemittel entfernt werden.

**17.** Verwendung der Verbindungen der Formel I gemäß Anspruch 1 als Initiator für die thermische Polymerisation von Verbindungen mit ethylenisch ungesättigten Doppelbindungen.

## Claims

**1.** A compound of the formula I

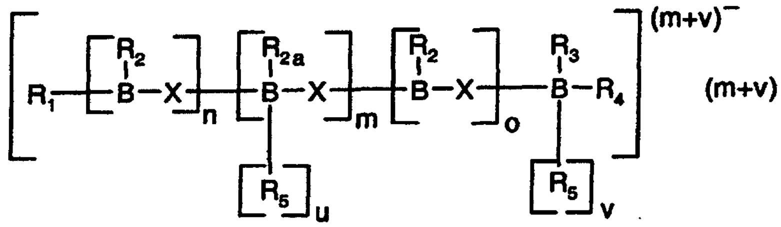 (m+v) [Z]$^+$ (I)

in which n and o are each a number from 0 to 50,

m is a number from 1 to 50,

u and v are 0 or 1, and at least one of the indices u and v is 1,

$R_1$, $R_2$, $R_{2a}$, $R_3$ and $R_4$ independently of one another are phenyl or another aromatic hydrocarbon, which radicals are unsubstituted or are substituted by unsubstituted or halo-, $OR_6$- and/or $NR_8R_9$-substituted $C_1$-$C_6$alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ or halogen,

p is 0, 1 or 2,

q is 0 or 1;

$R_5$ is $C_1$-$C_{12}$alkyl, $C_3$-$C_{12}$cycloalkyl, $C_2$-$C_8$alkenyl, phenyl-$C_1$-$C_6$alkyl or naphthyl-$C_1$-$C_3$alkyl, the radicals $C_1$-$C_{12}$alkyl, $C_3$-$C_{12}$cycloalkyl, $C_2$-$C_8$alkenyl, phenyl-$C_1$-$C_6$alkyl or naphthyl-$C_1$-$C_3$alkyl being unsubstituted or substituted by $OR_6$, $S(O)_pR_7$, $OS(O)_2R_7$, $NR_8R_9$, $C(O)OR_6$, $C(O)NR_8R_9$, $C(O)R_{10}$,

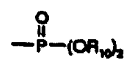 ,

$SiR_{11}R_{12}R_{13}$, $BR_{14}R_{15}$ or halogen, or $R_5$ is phenyl or another aromatic hydrocarbon radical, which radicals are unsubstituted or substituted by $C_1$-$C_6$alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ or halogen, at least one of the radicals $R_1$, $R_2$, $R_{2a}$, $R_3$, $R_4$ and $R_5$ being a phenyl radical which is substituted ortho to the bond to the boron atom, or being another aromatic hydrocarbon radical which is sterically hindered ortho to the boron atom,

$R_6$ and $R_7$ are unsubstituted or $COOR_{7a}$, OH, $C_1$-$C_{12}$alkoxy-or halo-substituted $C_1$-$C_{12}$alkyl, unsubstituted or mono-to penta-$C_1$-$C_6$alkyl-, -$C_1$-$C_{12}$alkoxy- or -halo-substituted phenyl, or unsubstituted or mono- to penta-$C_1$-$C_6$alkyl-, -$C_1$-$C_{12}$alkoxy- or -halo-substituted phenyl-$C_1$-$C_6$alkyl,

$R_{7a}$ is $C_1$-$C_{12}$alkyl,

$R_8$, $R_9$, $R_{10}$, $R_{11}$, $R_{12}$, $R_{13}$, $R_{14}$ and $R_{15}$ independently of one another are as defined for $R_6$ or are $C_3$-$C_{12}$cycloalkyl, or $R_8$ and $R_9$, together with the N atom to which they are attached, form a 5- or 6-membered ring which may additionally contain O or S atoms, or $R_{14}$ and $R_{15}$, together with the B atom to which they are attached, form a 5- or 6-membered ring;

X is $C_1$-$C_{20}$alkylene which is unsubstituted or substituted by

$OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, halogen or $P(O)_qR_{16}R_{17}$,

or X is $C_1$-$C_{20}$ alkylene is interrupted by one or more groups -O-, -$S(O)_p$-, or -$NR_{18}$-,

or X is $C_3$-$C_{12}$cycloalkylene or $C_2$-$C_8$alkenylene, each of which is unsubstituted or substituted by

$OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ or halogen, or where these radicals are interrupted by one or more groups -O-, -$S(O)_p$- or -$NR_{18}$-,

or X is a divalent aromatic hydrocarbon radical which is unsubstituted or substituted by $C_1$-$C_6$alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ or halogen,

or X is a radical of the formula II or III

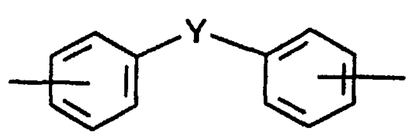 (II)

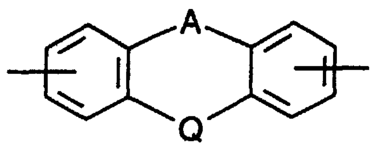 (III)

$R_{16}$ and $R_{17}$ independently of one another are as defined for $R_6$ or are $C_3$-$C_{12}$cycloalkyl;
$R_{18}$ is as defined for $R_6$ or is hydrogen,
Y is $-(CH_2)_r-$, -C(O)-, $-NR_{18}-$, -O-, $-S(O)_p-$, $-CR_{19}R_{20}-$,

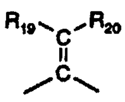 or 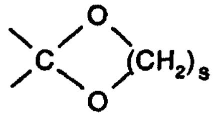 ,

r is 1, 2 or 3,
s is 2 or 3,
$R_{19}$ and $R_{20}$ are $C_1$-$C_6$alkyl or phenyl, or $R_{19}$ and $R_{20}$, together with the C atom to which they are attached, form a 5- or 6-membered ring,
A and Q independently of one another are a single bond $-(CH_2)_r-$, -CH=CH-, -C(O)-, $-NR_{18}-$, $-S(O)_p-$,

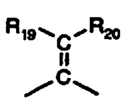 or 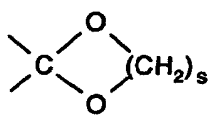

or the radicals $R_1$, $R_2$, $R_3$, $R_4$ and X form bridges to produce radicals of the formula (IV) or (V)

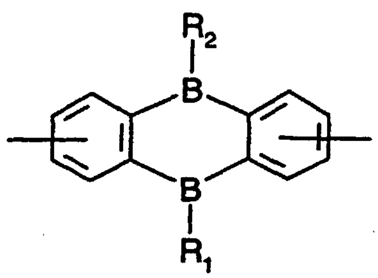 (IV)

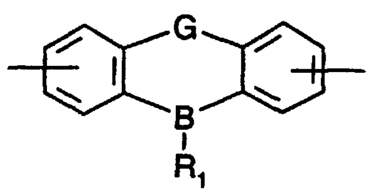 (V)

in which
G is $-(CH_2)_t-$, -CHCH-, -C(O)-, $-NR_{18}-$, -O- or $-S(O)_p-$ and
t is 0, 1 or 2,
the radicals of the formulae (II), (III), (IV) and (V) being unsubstituted or being substituted on the aromatic rings by $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ or halogen and where additional phenyl rings may be fused to the phenyl rings of the formulae (II), (III), (IV) and (V), with the proviso that $R_1$, $R_{2a}$, $R_3$ and $R_4$ are not all simultaneously 1-naphthyl if X is phenylene or 4,4'-biphenylene; and
Z is a radical which is able to form positive ions.

**2.** A compound according to claim 1, in which n and o are both 0, m is the number 1, $R_1$, $R_2$, $R_{2a}$, $R_3$ and $R_4$ are phenyl substituted by $C_1$-$C_6$alkyl and/or halogen, especially chlorine, $R_5$ is $C_1$-$C_{12}$alkyl, $(C_1$-$C_4$alkyl$)_3$Si-$CH_2$- or phenyl, X is unsubstituted phenylene, halo-substituted, especially fluoro-substituted, phenylene, biphenylene, o- or p-terphenylene, naphthylene, phenanthrylene, ferrocenvlene or a radical of the formula II in which Y is -C(O)- or

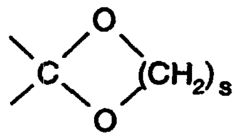 ,

s is 2, and
Z is tetraalkylammonium.

**3.** A composition comprising

(a) at least one ethylenically unsaturated photopolymerizable compound and
(b) at least one compound of the formula I as defined in claim 1.

**4.** A composition according to claim 3 comprising in addition to components (a) and (b) at least one electron acceptor (c).

**5.** A composition according to claim 3, comprising in addition to components (a) and (b) at least one compound of the formula XI

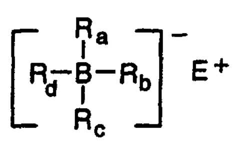 (XI)

in which $R_a$, $R_b$, $R_c$ and $R_d$ independently of one another are $C_1$-$C_{12}$alkyl, trimethylsilylmethyl, phenyl, another aromatic hydrocarbon, $C_1$-$C_6$alkylphenyl, allyl, phenyl-$C_1$-$C_6$alkyl, $C_2$-$C_8$alkenyl, $C_2$-$C_8$alkynyl, $C_3$-$C_{12}$cycloalkyl or saturated or unsaturated heterocyclic radicals, where the radicals phenyl, other aromatic hydrocarbon, phenyl-$C_1$-$C_6$alkyl, saturated or unsaturated heterocyclic radical are unsubstituted or substituted by unsubstituted or halogen-, $OR_6$- and/or $NR_8R_9$-substituted phenyl-$C_1$-$C_6$alkyl, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ or halogen,
p is 0, 1 or 2;
q is 0 or 1;
$R_6$ and $R_7$ are $C_1$-$C_{12}$alkyl which is unsubstituted or substituted by $COOR_{7a}$, OH, $C_1$-$C_{12}$alkoxy or halogen, or are phenyl which is unsubstituted or substituted from 1 to 5 times by $C_1$-$C_6$alkyl, $C_1$-$C_{12}$alkoxy or halogen, or are phenyl-$C_1$-$C_6$alkyl which is unsubstituted or substituted from 1 to 5 times by $C_1$-$C_6$alkyl, $C_1$-$C_{12}$alkoxy or halogen,
$R_{7a}$ is $C_1$-$C_{12}$alkyl;
$R_8$, $R_9$, $R_{10}$, $R_{11}$, $R_{12}$, $R_{13}$, $R_{14}$ and $R_{15}$ independently of one another have one of the definitions of $R_6$ or are $C_3$-$C_{12}$cycloalkyl, or $R_8$ and $R_9$, together with the nitrogen atom to which they are attached, form a 5- or 6-membered ring which may additionally contain oxygen or sulphur atoms, or $R_{14}$ and $R_{15}$, together with the boron atom to which they are attached, form a 5- or 6-membered ring;
$R_{16}$ and $R_{17}$ independently of one another have one of the definitions of $R_6$ or are $C_3$-$C_{12}$cycloalkyl; and
E is a radical which is able to form positive ions.

**6.** A composition according to claim 3, comprising in addition to component (b) a further photoinitiator (d) and/or other additives.

**7.** A composition according to claim 3, comprising in addition to components (a) and (b) at least one neutral, anionic or cationic dye or a thioxanthone compound and an onium compound.

**8.** A composition according to claim 7, additionally comprising a free-radical photoinitiator, especially an $\alpha$-amino ketone compound.

**9.** A composition comprising

(a) at least one ethylenically unsaturated photopolymerizable compound and
(b) at least one polyborate anion of the formula Ia

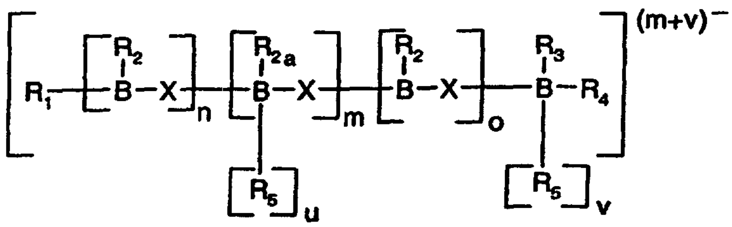

(Ia)

in which the radicals $R_1$, $R_2$, $R_{2a}$, $R_3$, $R_4$, $R_5$ and X, and also n, m, o, u and v, are as defined in claim 1, and
(c) a dye cation, sulfonium cation or iodonium cation.

**10.** A composition according to claim 9, additionally comprising at least one further borate compound of the formula XI

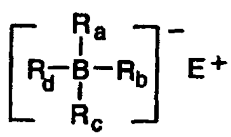

(XI)

in which $R_a$, $R_b$, $R_c$ and $R_d$ independently of one another are $C_1$-$C_{12}$alkyl, trimethylsilylmethyl, phenyl, another aromatic hydrocarbon, $C_1$-$C_6$alkylphenyl, allyl, phenyl-$C_1$-$C_6$alkyl, $C_2$-$C_8$alkenyl, $C_2$-$C_8$alkynyl, $C_3$-$C_{12}$cycloalkyl or saturated or unsaturated heterocyclic radicals, and where the radicals phenyl, other aromatic hydrocarbon, phenyl-$C_1$-$C_6$alkyl, saturated or unsaturated heterocyclic radical are unsubstituted or substituted by unsubstituted or halogen-, $OR_6$- and/or $NR_8R_9$-substituted phenyl-$C_1$-$C_6$alkyl, $OR_6$, $S(O)_pR_7$, $OS(O)_2R_7$, $NR_8R_9$, $C(O)OR_6$, C (O)$NR_8R_9$, $C(O)R_{10}$, $SiR_{11}R_{12}R_{13}$, $BR_{14}R_{15}$, $P(O)_qR_{16}R_{17}$ or halogen,
p is 0, 1 or 2;
q is 0 or 1;
$R_6$ and $R_7$ are $C_1$-$C_{12}$alkyl which is unsubstituted or substituted by $COOR_{7a}$, OH, $C_1$-$C_{12}$alkoxy or halogen, or are phenyl which is unsubstituted or substituted from 1 to 5 times by $C_1$-$C_6$alkyl, $C_1$-$C_{12}$alkoxy or halogen, or are phenyl-$C_1$-$C_6$alkyl which is unsubstituted or substituted from 1 to 5 times by $C_1$-$C_6$alkyl, $C_1$-$C_{12}$alkoxy or halogen,
$R_{7a}$ is $C_1$-$C_{12}$alkyl;
$R_8$, $R_9$, $R_{10}$, $R_{11}$, $R_{12}$, $R_{13}$, $R_{14}$ and $R_{15}$ independently of one another have one of the definitions of $R_6$ or are $C_3$-$C_{12}$cycloalkyl, or $R_8$ and $R_9$, together with the nitrogen atom to which they are attached, form a 5- or 6-membered ring which may additionally contain oxygen or sulphur atoms, or $R_{14}$ and $R_{15}$, together with the boron atom to which they are attached, form a 5- or 6-membered ring;
$R_{16}$ and $R_{17}$ independently of one another have one of the definitions of $R_6$ or are $C_3$-$C_{12}$cycloalkyl; and
E is a radical which is able to form positive ions.

**11.** A composition according to claim 3, comprising at least one borate of the formula I and at least one cyanine or pyrilium dye which may also, as a cation, be part of the compound of the formula I.

**12.** The use of a compound defined in claim 1 as a photoinitiator for the photopolymerization of ethylenically unsaturated compounds.

**13.** A composition according to any one of claims 3-11, containing from 0.05 to 15% by weight, in particular from 0.1 to 5% by weight, of component (b), based on the composition.

**14.** The use of a composition according to any one of claims 3-11 for producing pigmented and nonpigmented paints and varnishes, powder coatings, printing inks, printing plates, adhesives, dental compositions, optical waveguides, optical switches, colour testing systems, glass fibre cable coatings, screen printing stencils, resist materials, composite compositions, for encapsulating electrical and electronic components, for producing magnetic recording materials, for producing three-dimensional objects by means of stereolithography, for photographic reproductions, and as image recording material, especially for holographic recordings.

**15.** A coated substrate which is coated on at least one surface with a composition according to any one of claims 3-11.

**16.** A process for the photographic production of relief images, which comprises subjecting a coated substrate according to claim 15 to imagewise exposure or exposing it by means of a movable laser beam (without a mask) and then removing the unexposed areas with a solvent.

**17.** The use of a compound of the formula I according to claim 1 as an initiator for the thermal polymerization of compounds containing ethylenically unsaturated double bonds.

**Revendications**

**1.** Composé de formule I

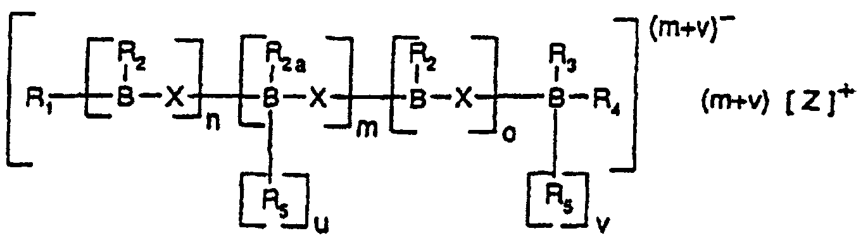 (I)

dans laquelle n et o représentent un nombre de 0 à 50,

| | |
|---|---|
| m | représente un nombre de 1 à 50, |
| u et v | sont 0 ou 1, dans lesquels au moins un des indices u ou v représente 1, |
| $R_1$, $R_2$, $R_{2a}$, $R_3$ et $R_4$ | représentent indépendamment les uns des autres le phényle ou un autre hydrocarbure aromatique, dans lequel ces groupes sont non substitués ou sont substitués par un alkyle en $C_1$ à $C_6$, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ non substitué ou substitué par halogène, $OR_6$ ou/et $NR_8R_9$ ou un halogène, |
| p | est 0, 1 ou 2 ; |
| q | est 0 ou 1 ; |
| $R_5$ | est un alkyle en $C_1$ à $C_{12}$, cycloalkyle en $C_3$ à $C_{12}$, alcényle en $C_2$ à $C_8$, phényl-alkyle en $C_1$ à $C_6$ ou naphtyl-alkyle en $C_1$ à $C_3$; dans lesquels les groupes alkyle en $C_1$ à $C_{12}$, cycloalkyle en $C_3$ à $C_{12}$, alcényle en $C_2$ à $C_8$, phényl-alkyle en $C_1$ à $C_6$ ou naphtyl-alkyle en $C_1$ à $C_3$ sont non substitués ou substitués avec $OR_6$, $S(O)_pR_7$, $OS(O)_2R_7$, $NR_8R_9$, $C(O)OR_6$, $C(O)NR_8R_9$, $C(O)R_{10}$, 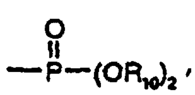 $SiR_{11}R_{12}R_{13}$, $BR_{14}R_{15}$, ou halogène, ou $R_5$ représente un phényle ou un autre hydrocarbure aromatique, dans lequel ces groupes sont non substitués ou substitués avec alkyle en $C_1$ à $C_6$, $OR_6$, $S(O)_pR_7$, OS |

$(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, ou halogène,
dans lesquels au moins un des groupes $R_1$, $R_2$, $R_{2a}$, $R_3$, $R_4$ ou $R_5$ représente un groupe phényle substitué en position ortho par rapport à la liaison avec l'atome de bore ou autrement à un groupe hydrocarboné aromatique à empêchement stérique en position ortho par rapport à l'atome de bore,

$R_6$ et $R_7$ représentent un alkyle en $C_1$ à $C_{12}$ non substitué ou substitué avec $COOR_{7a}$, OH, alcoxy en $C_1$ à $C_{12}$ ou halogène, phényle non substitué ou substitué 1 à 5 fois avec alkyle en $C_1$ à $C_6$, alcoxy en $C_1$ à $C_{12}$ ou halogène ou phényl-alkyle en $C_1$ à $C_6$ non substitué ou substitué 1 à 5 fois avec alkyle en $C_1$ à $C_6$, alcoxy en $C_1$ à $C_{12}$ ou halogène,

$R_{7a}$ représente un alkyle en $C_1$ à $C_{12}$ ;

$R_8$, $R_9$, $R_{10}$, $R_{11}$, $R_{12}$, $R_{13}$, $R_{14}$ et $R_{15}$, indépendamment les uns des autres, ont une des significations de $R_6$ ou sont un cycloalkyle en $C_3$ à $C_{12}$, ou $R_8$ et $R_9$ forment ensemble avec l'atome d'azote auquel ils sont liés, un cycle à 5 ou 6 chaînons, qui peut contenir encore des atomes O- ou S- ou $R_{14}$ et $R_{15}$ forment ensemble avec l'atome de bore auquel ils sont liés un cycle à 5 ou 6 chaînons ;

X représente un alkylène en $C_1$ à $C_{20}$, qui est non substitué ou substitué par $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, halogène ou $P(O)_qR_{16}R_{17}$,
ou X représente un alkylène en $C_1$ à $C_{20}$, qui est interrompu par un ou plusieurs groupes -O-, $-S(O)_p-$ ou $-NR_{18}-$,
ou X représente un cycloalkylène en $C_3$ à $C_{12}$ ou alcénylène en $C_2$ à $C_8$, dans lequel ces groupes sont non substitués ou substitués par $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ ou halogène, ou dans lesquels ces groupes sont interrompus par un ou plusieurs groupes -O-, $-S(O)_p-$ ou $-NR_{18}-$,
ou X représente un groupe hydrocarbure aromatique divalent, dans lequel ce groupe est non substitué ou substitué par alkyle en $C_1$ à $C_6$, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ ou halogène ;
ou X représente un groupe de formule II ou III

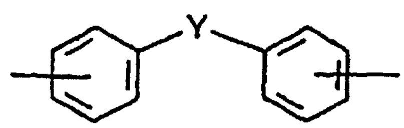
(II)

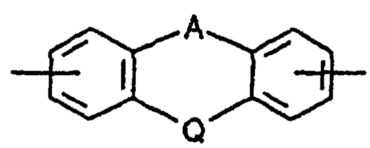
(III)

$R_{16}$ et $R_{17}$ ont indépendamment l'un de l'autre une des significations de $R_6$ ou sont un cycloalkyle en $C_3$ à $C_{12}$ ;

$R_{18}$ a une des significations de $R_6$ ou est un hydrogène ;

Y est $-(CH_2)_r-$, -C(O)-, $-NR_{18}-$, -O-, $-S(O)_p-$, $-CR_{19}R_{20}-$,

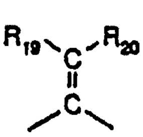
ou
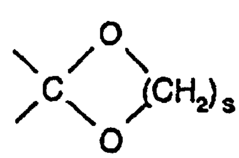
;

r — représente 1, 2 ou 3 ;

s — représente 2 ou 3 ;

$R_{19}$ et $R_{20}$ — sont un alkyle en $C_1$ à $C_6$ ou phényle ou $R_{19}$ et $R_{20}$ forment ensemble avec l'atome de carbone auquel ils sont liés un cycle à 5 ou 6 chaînons ;

A et Q — représentent indépendamment l'un de l'autre une liaison simple, $-(CH_2)_r-$, -CH=CH-, -C(O)-, $-NR_{18}-$, $-S(O)_p-$,

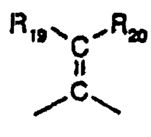 ou 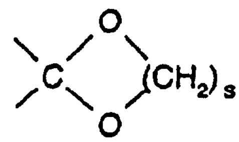 ;

ou les groupes $R_1$, $R_2$, $R_3$, $R_4$ ou X forment des ponts, dans lesquels les groupes des formules (IV) ou (V)

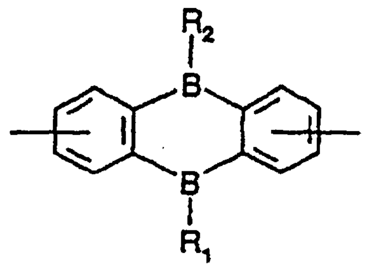

(IV)

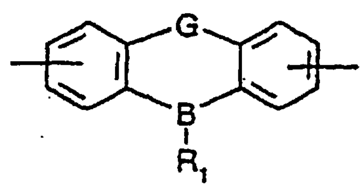

(V)

apparaissent, dans lesquels

G — représente $-(CH_2)_t-$, -CHCH-, -C(O)-, $-NR_{18}-$, -O- ou $-S(O)_p-$, et

t — est 0, 1 ou 2,

dans lesquels les groupes des formules (II), (III), (IV) et (V) sont non substitués ou sont substitués sur les cycles aromatiques avec $OR_6$, S $(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$ ou halogène et dans lesquels sur les cycles- phényle des formules (II), (III), (IV) et (V) d'autres cycles phényle peuvent être accolés ;

à la condition que $R_1$, $R_{2a}$, $R_3$ et $R_4$ ne représentent pas tous en même temps un 1-naphtyle, lorsque X représente un phénylène ou un 4,4'-biphénylène ; et

Z — représente un groupe, qui peut former des ions positifs.

**2.** Composé selon la revendication 1, dans laquelle

n et o — sont égaux à 0,

m — représente le nombre 1,

$R_1$, $R_2$, $R_{2a}$, $R_3$ et $R_4$ — représentent un phényle substitué par alkyle en $C_1$ à $C_6$ et/ou halogène, en particulier chlore,

$R_5$ — est un alkyle en $C_1$ à $C_{12}$, (alkyle en $C_1$ à $C_4)_3Si-CH_2-$ ou phényle,

X — représente un phénylène non substitué par halogène, en particulier fluor, bi-phénylène,

o- ou p-terphénylène, naphtylène, phénanthrylène, ferrocénylène ou un groupe de formule (II), dans laquelle

Y représente -C(O)- ou

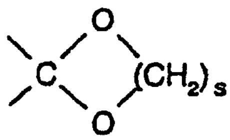 ;

s est égal à 2 et

Z représente un tétraalkylammonium.

**3.** Composition contenant

(a) au moins un composé photopolymérisable éthyléniquement insaturé et
(b) au moins un composé de formule I comme défini à la revendication 1.

**4.** Composition selon la revendication 3 contenant en plus des composants (a) et (b) au moins un accepteur d'électrons (c).

**5.** Composition selon la revendication 3, contenant en plus des composants (a) et (b) au moins un composé de formule XI

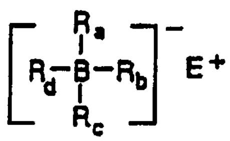 (XI)

dans laquelle $R_a$, $R_b$, $R_c$ et $R_d$ représentent indépendamment les uns des autres un alkyle en $C_1$ à $C_{12}$, triméthylsilylméthyle, phényle, un autre hydrocarbure aromatique, alkyl-phényle en $C_1$ à $C_6$, allyle, phényl-alkyle en $C_1$ à $C_6$, alcényle en $C_2$ à $C_8$, alcynyle en $C_2$ à $C_8$, cycloalkyle en $C_3$ à $C_{12}$ ou des groupes hétérocycliques saturés ou insaturés, dans lesquels les groupes phényle, un autre hydrocarbure aromatique, phényl-alkyle en $C_1$ à $C_6$, un groupe hétérocyclique saturé ou insaturé sont non substitués ou substitués avec alkyle en $C_1$ à $C_6$, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ ou halogène substitué avec halogène, $OR_6$ ou/et $NR_8R_9$ ou un halogène,

p est 0, 1 ou 2 ;

q est 0 ou 1 ;

$R_6$ et $R_7$ sont un alkyle en $C_1$ à $C_{12}$ non substitué ou substitué par $COOR_{7a}$, OH, alcoxy en $C_1$ à $C_{12}$ ou halogène, un phényle non substitué ou substitué 1 à 5 fois par alkyle en $C_1$ à $C_6$, alcoxy en $C_1$ à $C_{12}$ ou halogène ou phényl-alkyle en $C_1$ à $C_6$ non substitué ou substitué 1 à 5 fois par alkyle en $C_1$ à $C_6$, alcoxy en $C_1$ à $C_{12}$ ou halogène ;

$R_{7a}$ représente un alkyle en $C_1$ à $C_{12}$ ;

$R_8$, $R_9$, $R_{10}$, $R_{11}$, $R_{12}$, $R_{13}$, $R_{14}$ et $R_{15}$ ont indépendamment les uns des autres une des significations de $R_6$ ou sont un cycloalkyle en $C_3$ à $C_{12}$, ou $R_8$ et $R_9$ forment ensemble avec l'atome d'azote auquel ils sont liés un cycle à 5 ou 6 chaînons, qui peut contenir en plus encore des atomes O ou S, ou $R_{14}$ et $R_{15}$ forment ensemble avec l'atome de bore auquel ils sont liés un cycle à 5 ou 6 chaînons ;

$R_{16}$ et $R_{17}$ ont indépendamment l'un de l'autre une des significations de $R_6$ ou sont un cycloalkyle en $C_3$ à $C_{12}$ ; et

E représente un groupe, qui peut former des ions positifs.

**6.** Composition selon la revendication 3, contenant en plus du composant (b) encore un autre photo-initiateur (d) et/ou d'autres additifs.

**7.** Composition selon la revendication 3, contenant en plus des composants (a) et (b) au moins un colorant neutre, anionique ou cationique ou un composé thioxanthone et un composé onium.

**8.** Composition selon la revendication 7, contenant en plus un photo-initiateur radicalaire, en particulier un composé α-aminocétone.

**9.** Composition contenant

(a) au moins un composé photopolymérisable éthyléniquement insaturé et
(b) au moins un anion polyborate de formule Ia

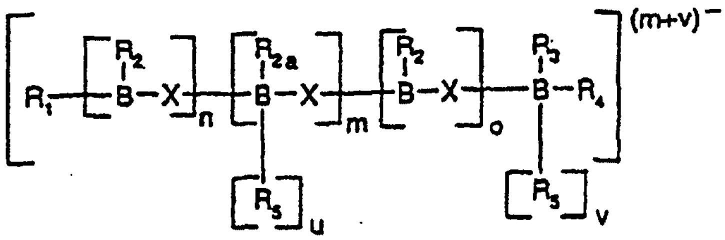

(Ia)

dans laquelle les groupes $R_1$, $R_2$, $R_{2a}$, $R_3$, $R_4$, $R_5$ et X, ainsi que n, m, o, u et v sont définis comme à la revendication 1, et
(c) un cation de colorant, de sulfonium ou d'iodonium.

**10.** Composition selon la revendication 9, contenant en plus au moins un autre composé borate de formule XI

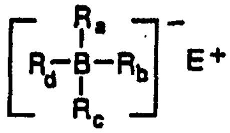

(XI)

dans laquelle $R_a$, $R_b$, $R_c$ et $R_d$ représentent indépendamment les uns des autres un alkyle en $C_1$ à $C_{12}$, triméthylsilylméthyle, phényle, un autre hydrocarbure aromatique, alkyl-phényle en $C_1$ à $C_6$, allyle, phényl-alkyle en $C_1$ à $C_6$, alcényle en $C_2$ à $C_8$, alcynyle en $C_2$ à $C_8$, cycloalkyle en $C_3$ à $C_{12}$ ou des groupes hétérocycliques saturés ou insaturés, dans lesquels les groupes phényle, un autre hydrocarbure aromatique, phényl-alkyle en $C_1$ à $C_6$, un groupe hétérocyclique saturé ou insaturé sont non substitués ou substitués avec un alkyle en $C_1$ à $C_6$, $OR_6$, $S(O)_pR_7$, $OS(O)_2R_7$, $NR_8R_9$, $C(O)OR_6$, $C(O)NR_8R_9$, $C(O)R_{10}$, $SiR_{11}R_{12}R_{13}$, $BR_{14}R_{15}$, $P(O)_qR_{16}R_{17}$ non substitué ou substitué par halogène, $OR_6$ ou/et $NR_8R_9$ ou un halogène,

| | |
|---|---|
| p | est 0, 1 ou 2 ; |
| q | est 0 ou 1 ; |
| $R_6$ et $R_7$ | sont un alkyle en $C_1$ à $C_{12}$ non substitué ou substitué par $COOR_{7a}$, OH, alcoxy en $C_1$ à $C_{12}$ ou halogène, un phényle non substitué ou substitué 1 à 5 fois par alkyle en $C_1$ à $C_6$, alcoxy en $C_1$ à $C_{12}$ ou halogène ou phényl-alkyle en $C_1$ à $C_6$ non substitué ou substitué 1 à 5 fois par alkyle en $C_1$ à $C_6$, alcoxy en $C_1$ à $C_{12}$ ou halogène ; |
| $R_{7a}$ | représente un alkyle en $C_1$ à $C_{12}$ ; |
| $R_8$,$R_9$, $R_{10}$, $R_{11}$, $R_{12}$, $R_{13}$, $R_{14}$ et $R_{15}$ | ont indépendamment les uns des autres une des significations de $R_6$ ou sont un cycloalkyle en $C_3$ à $C_{12}$, ou $R_8$ et $R_9$ forment ensemble avec l'atome d'azote auquel ils sont liés un cycle à 5 ou 6 chaînons, qui peut con- |

tenir en plus encore des atomes O ou S, ou $R_{14}$ et $R_{15}$ forment ensemble avec l'atome de bore auquel ils sont liés un cycle à 5 ou 6 chaînons ;

$R_{16}$ et $R_{17}$ ont indépendamment l'un de l'autre une des significations de $R_6$ ou sont un cycloalkyle en $C_3$ à $C_{12}$ ; et

E représente un groupe, qui peut former des ions positifs.

**11.** Composition selon la revendication 3, contenant au moins un borate de formule I et au moins un colorant cyanine ou pyrilium, dans lequel ce colorant peut être également comme cation un constituant du composé de formule I.

**12.** Utilisation de composés définis à la revendication 1 comme photo-initiateurs pour la photopolymérisation de composés éthyléniquement insaturés.

**13.** Composition selon une des revendications 3 à 11, contenant 0,05 à 15, en particulier 0,1 à 5 % en poids, du composant (b), par rapport à la composition.

**14.** Utilisation d'une composition selon une des revendications 3 à 11 pour la fabrication de laques pigmentées et non pigmentées, de laques en poudre, d'encres d'impression, de plaques d'impression, de guides d'ondes lumineuses, de commutateurs optiques, de systèmes d'essai de couleurs, de revêtements de câbles en fibre de verre, d'écrans de sérigraphie, de matériaux resists, de matières composites pour l'encapsulation de composants électriques et électroniques, pour la fabrication de matériaux de reproduction magnétiques, pour la fabrication d'objets tridimensionnels au moyen de stéréolithographie, pour les reproductions photographiques, ainsi que comme matériaux de reproduction d'images, en particulier pour les imageries holographiques.

**15.** Substrat revêtu, qui est revêtu sur au moins une surface avec une composition selon une des revendications 3 à 11.

**16.** Procédé pour la fabrication photographique d'illustrations en relief, **caractérisé en ce qu'**un substrat revêtu selon la revendication 15 est éclairé selon une image ou insolé au moyen d'un rayon laser en mouvement (sans masque) et où les parties non insolées sont ensuite éliminées avec un solvant.

**17.** Utilisation des composés de formule I selon la revendication 1 comme initiateurs pour la polymérisation thermique de composés avec des doubles liaisons éthyléniquement insaturées.